# EUROPEAN PATENT SPECIFICATION

(11) **EP 2 692 525 B1**
(45) Date of publication and mention of the grant of the patent: **28.10.2015**
(21) Application number: 12765039.8
(22) Date of filing: 27.03.2012
(51) Int. Cl.: C08J 7/04, G06F 3/045, B32B 27/16, G06F 3/041, H01B 5/14, B32B 27/30, B32B 27/36, B32B 27/12, B32B 7/12, B32B 27/08

(54) **CONDUCTIVE LAMINATED BODY AND TOUCH PANEL**
LEITFÄHIGES BESCHICHTETES ELEMENT UND BERÜHRUNGSBILDSCHIRM
CORPS STRATIFIÉ CONDUCTEUR ET ÉCRAN TACTILE

(30) Priority: 28.03.2011 JP 2011069504
(43) Date of publication of application: 05.02.2014
(73) Proprietor: Toray Industries, Inc., Tokyo, 103-8666 (JP); Toray Advanced Film Co., Ltd., Chuo-ku Tokyo 103-0021 (JP)
(72) Inventor: SATO, Yoshikazu, Otsu-shi, Shiga 520-8558 (JP); WATANABE, Osamu, Otsu-shi, Shiga 520-8558 (JP); ASAI, Nobuki, Mishima-shi, Shizuoka 411-0824 (JP); UEOKA, Takenori, Mishima-shi, Shizuoka 411-0824 (JP)
(74) Representative: Hoefer & Partner Patentanwälte mbB
(86) International application number: PCT/JP2012/057860
(87) International publication number: WO 2012/133367

(56) References cited:
- WO-A1-2009/054464
- WO-A1-2009/054464
- JP-A- 2007 328 092
- JP-A- 2010 103 212
- JP-A- 2010 205 532
- JP-A- 2010 507 199
- JP-A- 2011 029 099

## Description

### [Technical Field]

The present invention relates to a conductive laminate. More particularly, the present invention relates to a conductive laminate which is used in electrode members used for display-related articles such as touch panels, liquid crystal displays, organic electroluminescences and electronic papers, and solar cell modules. The present invention also relates to a touch panel using the conductive laminate.

### [Background Art]

In recent years, cell phones, gaming machines, personal computers and the like respectively mounted with touch panels have popularly used. A touch panel uses electrode members, and the touch panel that allows complicated operations uses multiple electrode members. Since processing of these electrode members into a touch panel requires multiple steps (for example, step of forming a desired pattern on a surface of a conductive layer of an electrode member, step of laminating electrode members with each other by pressurizing and heating, etc.), various types of energy stress is applied to the electrode member to be used.

There have been proposed, as the electrode member used in the touch panel, conductive laminates in which a layer formed of a polymer compound having specific functional groups or a skeleton structure is laminated on each thin conductive film layer, for example, a conductive laminate in which a layer formed of a polymer compound having functional groups such as amino groups is laminated on a thin conductive film layer provided on a polymer substrate (Patent Literature 1) ; a conductive laminate in which a layer formed of a polymer compound having cyano groups and the like is laminated on a thin conductive film layer formed of a metal thin film or a conductive polymer thin film provided on a plastic substrate (Patent Literature 2) ; a conductive laminate in which a layer formed of a polymer compound having a cationic quaternary ammonium base as a hydrophilic functional group, or sulfone groups is laminated on a conductive layer containing a needle-like conductive metal oxide provided on a polymer substrate (Patent Literature 3) ; and a transparent conductive film in which various layers formed of a polyester resin, an epoxy resin, hydrolyzate of a metal alkoxide of silicone, a silicone compound and the like are laminated on a conductive layer containing spherical fine metal particles (Patent Literature 4).

There have also been proposed a conductive laminate in which a thin silicon coating layer i.e., a silica layer is laminated on a conductive layer containing carbon nanotubes (hereinafter (hereinafter sometimes abbreviated to CNTs) as linear structures provided on a polymer substrate (Patent Literature 5) ; a conductive laminate in which a thin film layer formed of a polyester resin and CNTs is laminated on one or both surfaces of a polyester film substrate (Patent Literature 6) ; and conductive laminates in which a thin film layer formed of a resin having various vinyl and vinylidene groups as a carbon-carbon double bond and CNTs is laminated on one or both surfaces of a substrate (Patent Literatures 7, 8, 9). There has also been proposed a conductive laminate in which a metal nanowire such as a silver nanowire is used as linear structures of a conductive component, in addition to CNTs (Patent Literature 10), and there has also been proposed touch panels formed by using conductive laminates in which conductive linear structures are used (Patent Literatures 10, 11).

### [Citation List]

### [Patent Literature]

[Patent Literature 1]
   Japanese Unexamined Patent Publication (Kokai) No. 2003-115221
[Patent Literature 2]
   Japanese Unexamined Patent Publication (Kokai) No. 2007-276322
[Patent Literature 3]
   Japanese Unexamined Patent Publication (Kokai) No. 11-198275
[Patent Literature 4]
   Japanese Patent No. 3442082
[Patent Literature 5]
   Japanese Patent No. 3665969
[Patent Literature 6]
   Japanese Unexamined Patent Publication (Kokai) No. 2009-96181
[Patent Literature 7]
   Japanese Patent No. 4349793
[Patent Literature 8]
   Japanese Unexamined Patent Publication (Kokai) No. 2009-155374
[Patent Literature 9]
   Japanese Unexamined Patent Publication (Kokai) No. 2006-328311
[Patent Literature 10]
   Japanese Translation of PCT International Application Publication No. 2009-505358
[Patent Literature 11]
   Japanese Unexamined Patent Publication (Kokai) No. 2009-283376

### [Summary of Invention]

### [Technical Problem]

However, like the laminates disclosed in Patent Literatures 1 to 3, in case where the layer laminated on the conductive layer is formed of a polymer compound having functional groups such as an amino group, a cyano group, a cationic quaternary ammoniumbase, ands a sulfone group as a constituent, poor durability against heat or humidity leads to damage of the substrate and thus causes a problems such as yellowing of the substrate. Particularly, when the substrate is a resin substrate, a constituent having comparatively low molecular weight, called an oligomer, existing in the substrate is generated on a surface of the substrate due to heat by passing through multiple steps when an electrode member is processed and formed into a product, which leads to surface whitening or foreign substances as defects of the electrode member, and thus exerting an adverse influence on optical properties or electrical properties of the electrode member. As a result, quality level of products using the electrode members (for example, touch panels, display-related articles such as liquid crystal displays, organic electroluminescences and electronic papers, and solar cell modules) may decrease.

Similar to Patent Literatures 1 to 3, it is impossible to suppress oligomer generation even by technologies of Patent Literatures 4 to 10. Therefore, the touch panels formed by using the conductive laminates (Patent Literatures 10, 11) are inferior in quality level.

In view of these problems of the prior art, the present invention intends to provide a conductive laminate having satisfactory durability against heat.

### [Solution to Problem]

In order to achieve such object, the present invention employs the following configurations:
a conductive laminate including a substrate, a crosslinked layer laminated on one surface of the substrate, and a conductive layer and a protective layer laminated on the other surface of the substrate, the conductive laminate satisfying the following conditions (i) to (iv):
   (i) the crosslinked layer is composed of a crosslinked polymer including a structure in which compounds, each having two or more carbon-carbon double bond groups contributing to a polymerization reaction, are subjected to the polymerization reaction, and also the mass content of a unit structure (>C=C<: formula weight of 24) portion of the carbon-carbon double bond group in the structure derived from the carbon-carbon double bond group is from 9 to 26% by mass relative to the total mass of the crosslinked layer;
   (ii) the crosslinked layer has a thickness of 50 nm to 1 µm;
   (iii) the conductive layer contains a conductive component having a network structure composed of linear structures; and
   (iv) the protective layer has an average thickness (t) of 70 nm to 1 µm.

The present invention also includes a touch panel obtained by using the above conductive laminate.

### [Advantageous Effects of Invention]

According to the present invention, it is possible to provide a conductive laminate having satisfactory durability against heat. The conductive laminate of the present invention can be suitably used for touch panels. Furthermore, the conductive laminate of the present invention can also be suitably used in the electrode members which are used for displays such as liquid crystal displays, organic electroluminescence displays and electronic papers and also for solar cell modules.

### [Brief Description of the Drawings]

Fig. 1 is an example of a schematic cross-sectional view of a conductive laminate of the present invention.
Fig. 2 is an example of a schematic view of linear structures observed from the conductive layer side of the conductive laminate of the present invention
Fig. 3 is a schematic view showing an example of a touch panel as an aspect of the present invention.
Fig. 4 is an example of a schematic cross-sectional view near the linear structures of the present invention.
Fig. 5 is a schematic view of a vertical fluidized bed reactor.

### [Description of Embodiments]

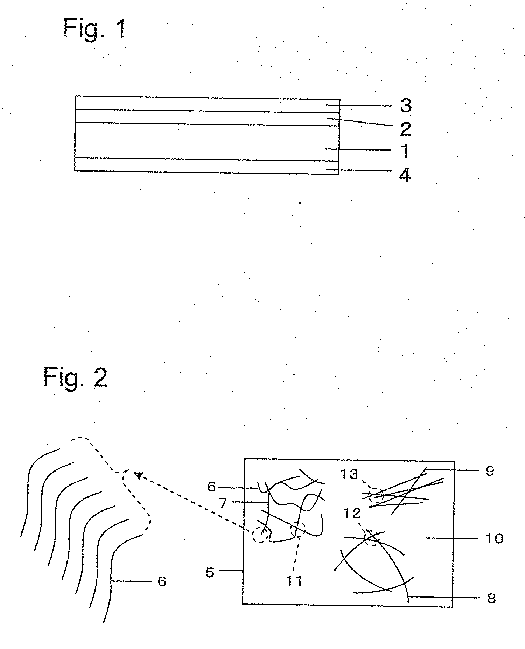

Referring to an example shown in Fig. 1, the conductive laminate of the present invention has such a configuration that a crosslinked layer 4 is laminated on one surface of a substrate 1, and a conductive layer 2 and a protective layer 3 are laminated on the other surface of the substrate. Each layer satisfies the following conditions (i) to (iv).
(i) The crosslinked layer is composed of a crosslinked polymer including a structure in which compounds, each having two or more carbon-carbon double bond groups contributing to a polymerization reaction, are subjected to the polymerization reaction, and also the mass content of a unit structure (>C=C<: formula weight of 24) portion of the carbon-carbon double bond group in the structure derived from the carbon-carbon double bond group is from 9 to 26% by mass relative to the total mass of the crosslinked layer.
(ii) The crosslinked layer has a thickness of 50 nm to 1 µm.
(iii) The conductive layer contains a conductive component having a network structure composed of linear structures.
(iv) The protective layer has an average thickness (t) of 70 nm to 1 µm.

Detailed description will be made hereinafter. The conductive layer in the present invention is a layer containing a conductive component including a network structure composed of linear structures. Since the conductive component has a network structure in which a conductive component is composed of linear structures, in case where the amount of the linear structures is less than a certain amount, some areas free from existing linear structures in the plane may be scattered. However, even though such areas may exist, if the linear structures continuously and uniformly exist to form a network in the plane so that conductivity can be established between given two points, it is defined that a conductive layer is formed. That is, in such a case, the layer-like region formed by the linear structures (including the areas where the scattered linear structures do not exist) is defined as the conductive layer. In this case, in the areas where the linear structures do not exist, the surface of the protective layer may exist more on the substrate side than the surface of the linear structures (in the case of viewing from the protective layer side, the linear structures are partially buried in the protective layer), but including such a case, the range from the surface of the substrate to the outermost surface of the linear structures is defined as the conductive layer. The range from the outermost surface of the linear structures to the outermost surface of the laminate is defined as the protective layer in the areas where the linear structures exist, while the range from the surface of the substrate to the outermost surface of the laminate is defined as the protective layer in the areas where the linear structures do not exist.

The reason why a conductive laminate having satisfactory durability against heat is obtained by satisfying the above-mentioned conditions (i) to (iv) is estimated as follows.

It is considered that the micro-Brownian motion of molecular chains is activated by application of thermal energy to each layer constituting the conductive laminate through heating, and thus the space between molecular chains in which a layer is formed, that is, free volume increases, and an oligomer moves in the layer and gradually generated on a surface. However, in the conductive laminate of the present invention, the crosslinked layer is obtained by polymerizing a compound including two or more carbon-carbon double bond groups contributing to a polymerization reaction in the structure in the above-mentioned specific range, and it is estimated that formation of a dense crosslinked structure decreases the free volume of the crosslinked layer, leading to suppression of the movement of the oligomer. An indicator of denseness of the crosslinked structure of the crosslinked layer, used herein, is mass content (hereinafter sometimes referred to as mass content of a crosslinked unit structure) of a unit structure (that is, >C=C< (formula weight of 24)) moiety of a carbon-carbon double bond group of a structure in which a compound having a carbon-carbon double bond group contributing to a polymerization reaction undergoes a polymerization reaction (hereinafter also referred to as structure derived from a carbon-carbon double bond group) based on the total mass of a crosslinked layer. When the mass content of the crosslinked unit structure is less than 9% by mass, crosslinking points including the structure derived from a carbon-carbon double bond group as a starting point decreases and thus density of the crosslinked structure of the crosslinked layer decreases. Therefore, it is estimated that sufficient effect of decreasing the free volume is not exerted, and thus fails to obtain the effect of suppressing the movement of the oligomer. On the other hand, when the mass content of the crosslinked unit structure is more than 26% by mass, excess crosslinking points make it impossible to perform stress relaxation in the crosslinked layer involved in crosslinking, leading to, for example, curling and deterioration of planarity of the conductive laminate. In case where curling and deterioration of planarity of the conductive laminate occur, generation of defects in the network structure of linear structures in the conductive layer (for example, poor conductive contact between linear structures, damage due to breakage of linear structures per se, etc.) causes deterioration of conductivity, and thus it becomes difficult to achieve a desired surface resistance value. Accordingly, when the mass content of the crosslinked unit structure is from 9% by mass to 26% by mass, the crosslinked structure is densely formed and the free volume of the crosslinked layer decreases, and thus making it possible to obtain a conductive laminate which simultaneously satisfies the generation of an oligomer and surface conductivity. The mass content of a crosslinked unit structure is preferably in a range from 19% by mass to 24% by mass, and more preferably from 21% by mass to 24% by mass, since it becomes easy to obtain the oligomer generation suppression effect and to reduce the thickness of the crosslinked layer.

Even if the crosslinked layer has small free volume, total moving distance of the oligomer in the thickness direction decreases when the thickness of the crosslinked layer is less than 50 nm, resulting in the generation of an oligomer. On the other hand, when the thickness of the crosslinked layer is more than 1 µm, poor network structure of linear structures occurs due to curling and deterioration of planarity of the above-mentioned conductive laminate. Therefore, it is also important that the thickness of the crosslinked layer is from 50 nm to 1 µm.

As mentioned above, when the crosslinked layer satisfies the conditions (i) and (ii), it is possible to simultaneously satisfy suppression of the generation of an oligomer and surface conductivity of the conductive laminate.

In the conductive laminate of the present invention, a conductive layer is formed on the surface opposite to a crosslinked layer of the substrate via a substrate. As mentioned above, the conductive layer is a layer containing a conductive component which includes a network structure composed of linear structures. When the conductive component in the conductive layer is the linear structure, the linear structure forms the network structure to the conductive layer, thereby, electricity flows through the portions where the linear structure exists even if existing the loose portions where no linear structure exists. Therefore, it is well suited for practical use as the entire conductive laminate since the surface has sufficiently low resistance value.

In order to use the conductive laminate for a touch panel that is one of important applications, it is important that the conductive layer contains a conductive component including a network structure composed of a linear structure. For example, when the conductive laminate is used as an electrode member of the touch panel, there is required the step of forming a desired pattern as the electrode member on the conductive layer. Namely, in the conductive layer, the conductive component remains by patterning to form the region having conductivity (hereinafter referred to as conductive region) and the region electrically insulated by removing the conductive component (hereinafter referred to as insulating region). When the insulating region is not electrically insulated, sufficiently, defects such as short-circuit are generated when used as the electrode member, and thus fails to be used as the electrode member.

For example, in case where the conductive layer is formed of metal or a conductive metal oxide such as ITO, there is no problem in conductivity of the conductive region. However, with regard to the insulating region, it is impossible to obtain sufficient insulating properties unless the entre conductive layer is removed. Therefore, with regard to the insulating region, the substrate had to be exposed. In that case, with regard to the conductive region, the conductive layer prevents the generation of an oligomer to some extent. However, with regard to the insulating region, it is impossible to suppress the generation of an oligomer. On the other hand, when the conductive component is a linear structure, it is estimated that it is easy to simultaneously satisfy the oligomer generation suppression effect and electric insulation by the below-mentioned effect.

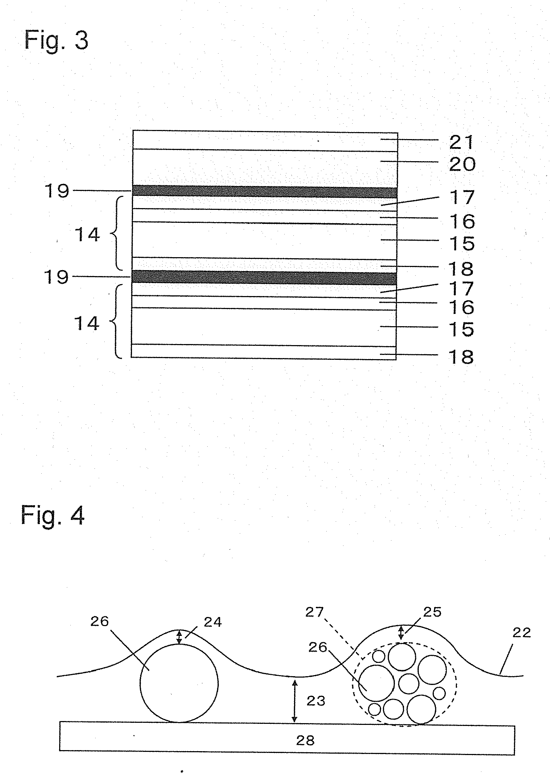

When the conductive component is a linear structure, as shown in Fig. 4, the thickness 23 of the protective layer of the portions where no linear structure exists increases as compared with the thickness 24 or 25 of the portions where the linear structure exists. When patterning is performed by removing the linear structure of the portions which would be the insulating region, using a removing agent, the rate of the protective layer eroded by the removing component (for example, an acid component or a base component) in the removing agent does not vary with the place of the protective layer. Therefore, when the protective lay of the portions where the thin linear structure exists is removed, the protective layer still remains in other portions. In the portions where the linear structure exists, the removing component penetrated into the protective layer reaches the linear structure in a short time and erosion selectively proceeds in the major axis direction of the linear structure, thereby, the rate of removing the linear structure increases as compared with the rate of removing the protective layer in the vicinity. Therefore, it is possible to remove only the linear structure except for the protective layer in the case of patterning. Namely, in the insulating region where the linear structure as the conductive component was removed, since a surface of the substrate is covered with the protective layer without being exposed, it is estimated that the generation of the oligomer can be suppressed. When patterning is performed by the above-mentioned mechanism, a step between the formed conductive region and the insulating region is too small to be visually recognized, and it is estimated that local peeling or dissolution of the protective layer is much less likely to occur.

When the average thickness (t) of the protective layer is less than 70 nm, the time taken for the removing component to complete the permeation through the protective layer and the linear structures becomes short, and consequently the difference in the period for the removing component to complete permeation becomes small. As a result, only the linear structures cannot be selectively removed, and the protective layer is also removed together. Accordingly the substrate is likely to be exposed, and thus fails to exert the effect of suppressing the generation of an oligomer. When the average thickness (t) of the protective layer is 70 nm or more, the protective layer can be made to remain even after patterning, and thus the generation of the oligomer can be suppressed. When the average thickness (t) of the protective layer is more than 1 µm, the following problems arise: the amount of the linear structures in the surface layer on the conductive side (on the side laminated with the conductive layer and the protective layer in the present invention) is so small as to lower the conductivity, making it difficult to achieve a desired surface resistance value; and the removing component cannot reach the linear structures, and due to insufficient removal, the electric insulation is insufficient, to cause defects such as short-circuit. When the average thickness (t) of the protective layer is 1 µm or less, it is possible to obtain a conductive laminate which does not prevent conductivity of the conductive component and is free from abnormal rise of resistance value or defective continuity. The average thickness (t) of the protective layer is preferably from 100 nm to 500 nm, more preferably from 100 nm to 400 nm, and most preferably from 150 nm to 350 nm. When the average thickness (t) of the protective layer is from 100 nm to 500 nm, the protective layer sufficiently remains after patterning, and thus exerting high effect of preventing the generation of an oligomer. When the average thickness (t) of the protective layer is from 100 nm to 400 nm, it becomes easier to obtain a low surface resistance value while maintaining the effect of preventing the generation of an oligomer. Furthermore, when the average thickness (t) of the protective layer is from 150 nmto 350 nm, the conductive laminate is likely to have a low surface resistance value stably even if the conductivity of the conductive component is somewhat high.

The average thickness (t) of the protective layer is determined as mentioned below. The portion to be observed of a sample is encapsulated with ice and frozen and secured, or encapsulated with a material stronger in securing force than ice such as an epoxy resin and is then cut in the direction perpendicular to the film surface using a rotary microtome manufactured by Nihon Microtome Kenkyusho K.K. having a diamond knife set at a knife inclination angle of 3°. Subsequently, the obtained cross section of the film is observed by using a field emission scanning electron microscope (JSM-6700-F manufactured by JEOL Ltd.) at an accelerating voltage of 3.0 kV at respective observation magnifications of 10,000 to 100,000 times by appropriately adjusting the image contrast. From each obtained photograph of the cross section, given five places each of the 23 (the thickness of the protective layer in a portion where the linear structures do not exist: the above-mentioned thick portion of the protective layer) and 24 (the thickness of the protective layer laminated on the top of a single linear structure) or 25 (the top of an aggregate consisting of linear structures: the above-mentioned thin portion of the protective layer) respectively shown in Fig. 4 are measured at an observation magnification of 10,000 to 100,000 times (calculated from the magnifications), and the values are averaged to obtain the average thickness (t) of the protective layer. Upon the measurement, magnification capable of ensuring three significant digits was selected and the value was determined by rounding the 4th digit upon calculation.

As mentioned above, in the conductive laminate of the present invention, the crosslinked layer suppresses an oligomer from generating on a surface in one surface of the substrate, whereas, the protective layer suppresses an oligomer from generating on a surface in the other surface of the substrate. Even if patterning of the conductive layer is carried out, the protective layer remains and the substrate surface is not exposed, enabling effective suppression of the generation of an oligomer upon heating and thus the conductive laminate has satisfactory durability against heat.

As mentioned above, the crosslinked layer in the present invention includes a structure derived from a carbon-carbon double bond group. Examples of the functional group including a carbon-carbon double bond group contributing to a polymerization reaction include an allyl group, an acryloyl group, a methacryloyl group, an acryloyloxy group, a methacryloyloxy group, a methacryl group, an acrylamide group, a methacrylamide group, an allylidene group, an allylidyne group, a vinylether group and the like. The functional group also includes functional groups in which a halogen element (for example fluorine, chlorine, etc.) or a substituent having an aromatic ring (for example, phenyl group, naphthyl group, etc.) is bound to carbon of a carbon-carbon double bond group, for example, functional groups having a conjugated polyene structure, such as a vinyl fluoride group, a vinyl fluorideidene group, a vinyl chloride group, a vinylidene chloride group, a styryl group having a phenyl group (benzene ring) as an aromatic ring, an isopropenyl group, an isopentenyl group, a butadienyl group (for example CH₂=C(R)-C(R²)=CH-, CH₂=C(R))-C(=CH₂)- (R¹ and R² represent H or CH₃)), wherein the functional group has a vinyl group when R¹ = H, or a vinylidene group when R¹ = CH₃. In response to required properties or productivity, these functional groups are used alone, or two or more functional groups are used in combination. Of these functional groups, it is possible to preferably use a group selected from an acryloyl group, a methacryloyl group, an acryloyloxy group and a methacryloyloxy group, which easily form a crosslinking point because of high reactivity of the carbon-carbon double bond group moiety, from the viewpoint of enhancing durability against heat and suppressing the generation of an oligomer. It is possible to more preferably use an acryloyl group and an acryloyloxy group which contain hydrogen (-H) with small steric hindrance, as compared with a methacryloyl group and a methacryloyloxy group which have a methyl group (-CH₃) with large steric hindrance near the carbon-carbon double bond, since the obtained crosslinked layer easily form a more dense crosslinked structure due to structural reasons, and also exhibits higher durability against heat and easily exerts the effect of suppressing the generation of an oligomer. Of these functional groups, an acryloyl group having only a carbonyl group (-CO-), which is more stable to an acryloyloxy group having an ester group (-COO-) that may be capable of serving as a starting point of hydrolysis by moisture in air with thermal energy obtained upon heating, is most preferred since it exhibits higher durability against heat and easily exerts the effect of suppressing the generation of an oligomer.

Examples of the compound having two or more double bond groups contributing to a polymerization reaction in the structure include pentaerythritol triacrylate, pentaerythritol trimethacrylate, pentaerythritol tetraacrylate, pentaerythritol tetramethacrylate, pentaerythritol ethoxytriacrylate, pentaerythritol ethoxy trimethacrylate, pentaerythritol ethoxy tetraacrylate, pentaerythritol ethoxy tetramethacrylate, dipentaerythritol triacrylate, dipentaerythritol trimethacrylate, dipentaerythritol tetraacrylate, dipentaerythritol tetramethacrylate, dipentaerythritol pentaacrylate, dipentaerythritol pentamethacrylate, dipentaerythritol hexaacrylate, dipentaerythritol hexamethacrylate, trimethylolpropane triacrylate, trimethylolpropane trimethacrylate, trimethylolpropane ethoxytriacrylate, trimethylolpropane ethoxy trimethacrylate, ditrimethylolpropane triacrylate, ditrimethylolpropane trimethacrylate, ditrimethylolpropane tetraacrylate, ditrimethylolpropane tetramethacrylate, glycerol propoxy triacrylate, glycerol propoxy trimethacrylate and the like. The compound also includes triacrylate, trimethacrylate, tetraacrylate, tetramethacrylate, pentaacrylate, pentamethacrylate, hexaacrylate, hexamethacrylate and the like, each partially having a cyclic skeleton such as a cyclopropane ring, a cyclobutane ring, a cyclopentane ring or a cyclohexane ring in the molecular structure. The compound also includes compounds whose structure is partially modified, for example, 2-hydroxypropanoic acid-modified pentaerythritol triacrylate, 2-hydroxypropanoic acid-modified pentaerythritol trimethacrylate, 2-hydroxypropanoic acid-modified pentaerythritol tetraacrylate and 2-hydroxypropanoic acid-modified pentaerythritol tetramethacrylate, each being modified with 2-hydroxypropanoic acid; silicone triacrylate, silicone trimethacrylate, silicone tetraacrylate, silicone tetramethacrylate, silicone pentaacrylate, silicone pentamethacrylate, silicone hexaacrylate and silicone hexamethacrylate, each including a silicone skeleton introdued thereinto. The compound further includes those including other skeletons, together with a vinyl group and/or a vinylidene group included in the skeleton, for example, urethane triacrylate, urethane trimethacrylate, urethane tetraacrylate, urethane tetramethacrylate, urethane pentaacrylate, urethane pentamethacrylate, urethane hexaacrylate and urethane hexamethacrylate, each including a urethane skeleton; polyether triacrylate, polyether trimethacrylate, polyether tetraacrylate, polyether tetramethacrylate, polyether pentaacrylate, polyether pentamethacrylate, polyether hexaacrylate and polyether hexamethacrylate, each including an ether skeleton; epoxy triacrylate, epoxy trimethacrylate, epoxy tetraacrylate, epoxy tetramethacrylate,epoxy pentaacrylate,epoxypentamethacrylate, epoxy hexaacrylate and epoxy hexamethacrylate, each including an epoxy-derived skeleton; polyester triacrylate, polyester trimethacrylate, polyester tetraacrylate, polyester tetramethacrylate, polyester pentaacrylate, polyester pentamethacrylate, polyester hexaacrylate and polyester hexamethacrylate, each including an ester skeleton; and the like. In response to applications and required properties and productivity, examples of usable one include, but are not limited to, these compounds alone or a composition obtained by mixing two or more of them, or an oligomer obtained by mixing two or more of them. Examples of commercially available compound include Light Acrylate series, Light Ester series, Epoxy Ester series, Urethane Acrylate AH series, Urethane Acrylate AT series and Urethane Acrylate UA series, manufactured by Kyoeisha Chemical Co., Ltd; EBECRYL (registered trademark) series, PETIA, TMPTA, TMPEOTA, OTA 480, DPHA and PETA-K, manufactured by DAICEL-CYTEC Company LTD.; Fulcure (registered trademark) series manufactured by Soken Chemical Engineering Co., Ltd.; "LIODURAS (registered trademark)" series manufactured by TOYO INK MFG. CO., LTD.; PHOLUCID (registered trademark) series manufactured by Chugoku Marine Paints, Ltd.; EXP series manufactured by Matsuichemical Inc.; and the like.

Mass content of a crosslinked unit structure of a crosslinked layer is determined in the following manner. First, the crosslinked layer is peeled from a sample, and the crosslinked layer is dissolved in a soluble solvent. If necessary, the dissolved measurement samples were separated and refined into individual substances using a method capable of isolation selected from among general chromatography typified by silica gel column chromatography, gel permeation chromatography, liquid high-performance chromatography and the like, and then subjected to the following qualitative analysis and quantitative analysis.

Then, if necessary, the substances were concentrated and diluted to prepare samples. First, the components contained in the sample were specified by performing qualitative analysis. First, analysis was performed by using analytical methods of the group (i) in combination and then the components, which could not been detected by the analysis, were analyzed by using analytical methods of the group (ii) in combination. The measuring method of each group was applied in the order of description, and the subsequent measuring method was used in case where detection could not be performed by the previous method. Even in the case of using methods in combination, the measuring method described previously was preferentially used and the method capable of measuring by using lesser combinations was applied:
(1) nuclear magnetic resonance spectroscopy (¹H-NMR, ¹³C-NMR, ²⁹Si-NMR, ¹⁹F-NMR), two-dimensional nuclear magnetic resonance spectrometry (2D-NMR), infrared spectrometry (IR), Raman spectrometry, various mass spectrometries (gas chromatography-mass spectrometry (GC-MS), pyrolysis gas chromatography-mass spectrometry (Py-GC-MS), matrix assisted laser desorption/ionization-mass spectrometry (MALDI-MS), time-of-flight mass spectrometry (TOF-MS), matrix-assisted laser desorption-ionization time-of-flight mass spectrometry (MALDI-TOF-MS), dynamic secondary ion mass spectrometry (Dynamic-SIMS), time-of-flight secondary ion mass spectrometer (TOF-SIMS), and other static secondary-ion mass spectrometry (Static SIMS)); and
(2) X-ray diffractometry (XRD), neutron diffractometry (ND), low energy electron diffraction (LEED), reflection high energy electron diffraction (RHEED), atomic absorption spectrometry (AAS), ultraviolet photoelectron spectrometry (UPS), auger electron spectrometry (AES), X-ray photoelectron spectrometry (XPS), X-ray fluorescence (XRF) spectrometry, inductively coupled plasma atomic emission spectrometry (ICP-AES), electron probe micro-analyzer (EPMA), particle induced X-ray emission (PIXE), low-energy ion scattering spectroscopy (RBS or LEIS), medium energy ion scattering (MEIS), high energy ion scattering (ISS or HEIS), gel permeation chromatography (GPC), transmission electron microscope-energy dispersive x-ray spectrometry (TEM-EDX), scanning electron microscope-energy dispersive X-ray spectrometry (SEM-EDX), and other elemental analyses.

Then, the isolated samples are subjected to qualitative analysis. Subsequently, 1,1,2,2-tetrabromoethane (hereinafter abbreviated to TBE) with the mass measured in advance is appropriately diluted with deuterated chloroform to prepare an internal standard solution. To the isolated sample, the TBE internal standard solution is added and the obtained test solution was measured using ¹H-NMR. The amount of the carbon-carbon double bond group in the sample is calculated from an area ratio between a peak area of a peak corresponding to hydrogen bound to carbon which was the carbon-carbon double bond group at the time of a precursor (it does not matter whether or not it exists as the carbon-carbon double bond group at the time of the measurement), and a peak area corresponding to hydrogen (proton, H) of TBE added as an internal standard substance in the obtained ¹H-NMR spectrum, the mass of the sample measured in advance, and the concentration of the TBE internal standard solution. By a comparison between the obtained amount of the carbon-carbon double bond group, and the other structure in the measurement sample calculated in the same manner, the mass content of the unit structure portion of the carbon-carbon double bond group to the total mass of the measurement sample is calculated.

The thickness of the crosslinked layer in the conductive laminate of the present invention is from 50 nm to 1 µm. When the thickness of the crosslinked layer is from 50 nm to 1 µm, it is possible to obtain a laminate which is free from defects of the network structure of linear structures involved in curing of the laminate and deterioration of planarity (for example, poor conductive contact between linear structures, damage due to breakage of linear structures per se, etc.), and to simultaneously satisfy suppression of the generation of an oligomer and surface conductivity upon heating. When the thickness of the crosslinked layer is less than 50 nm, the total moving distance of the oligomer to the thickness direction decreases and thus the oligomer is generated. On the other hand, the thickness of the crosslinked layer of more than 1 µm may cause poor network structure of linear structures due to curling and deterioration of planarity of the laminate. The thickness of the crosslinked layer in the present invention means the average thickness measured by the below-mentioned method. In the present invention, the thickness of the crosslinked layer is preferably from 50 nm to 800 nm, more preferably from 80 nm to 500 nm, and still more preferably from 100 nm to 350 nm, from the above-mentioned viewpoint.

The thickness of the crosslinked layer is determined in the following manner. The portion to be observed of a sample is encapsulated with ice and frozen and secured, or encapsulated with a material stronger in securing force than ice such as an epoxy resin and then cut in the direction perpendicular to the film surface using a rotary microtome (manufactured by NihonMicrotome Kenkyusho K.K.) having a diamond knife set at a knife inclination angle of 3°. Subsequently, the obtained cross section of the film is observed using a field emission scanning electron microscope (JSM-6700-F manufactured by JEOL Ltd.) at an accelerating voltage of 3.0 kV at an observation magnification of 10,000 to 100,000 times by appropriately adjusting the image contrast. At fifteen positions of a boundary divided into sixteen equal parts in a direction perpendicular to the thickness, the thickness of the crosslinked layer is measured from the obtained cross-sectional photograph (calculated from the magnifications), and the values were averaged to obtain the thickness of the crosslinked layer. Upon the measurement, magnification capable of ensuring three significant digits was selected and the value was determined by rounding the 4th digit upon calculation.

The conductive laminate of the present invention include a conductive layer containing a conductive component formed of linear structures. In the present invention, a linear structure is a structure in which the ratio of the major axis length to the minor axis length, i.e., the aspect ratio = major axis length/minor axis length is larger than 10. On the other hand, for example, the aspect ratio of a sphere is 1. The minor axis and major axis lengths are different depending on the types of linear structures. However, it is preferred that the minor axis length is smaller than a formed pattern and is in a range from 1 nm to 1, 000 nm (1 µm). The major axis length is only required to be larger than the minor axis length such that the above-mentioned aspect ratio = major axis length/minor axis length is larger than 10 and is preferably in a range from 1 µm to 100 µm (0.1 mm). Examples of the linear structures include fibrous conductors, needle-like conductors and the like.

Examples of the fibrous conductors include carbon-based fibrous conductors, metal-based fibrous conductors, metal oxide-based fibrous conductors and the like. These fibrous conductors can be subjected to a surface treatment.

Examples of the carbon-based fibrous conductors include polyacrylonitrile-based carbon fibers, pitch-based carbon fibers, rayon-based carbon fibers, vitreous carbon, carbon nanotubes (CNTs), carbon nanocoils, carbon nanowires, carbon nanofibers, graphite fibrils and the like.

Examples of the metal-based fibrous conductors include a fibrous conductor formed of single metal selected from gold, platinum, silver, nickel, silicon, stainless steel, copper, brass, aluminum, zirconium, hafnium, vanadium, niobium, tantalum, chromium, molybdenum, manganese, technetium, rhenium, iron, osmium, cobalt, zinc, scandium, boron, gallium, indium, silicon, germanium, tin and magnesium, or an alloy of two or more of these metals.

Examples of the metal oxide-based fibrous conductor include a fibrous conductor formed of metal oxide or metal oxide composite selected from InO₂, InO₂Sn, SnO₂, ZnO, SnO₂-Sb₂O₄, SnO₂-V₂O₅, TiO₂(Sn/Sb)O₂, SiO₂(Sn/Sb)O₂, K₂O-nTiO₂-(Sn/Sb)O₂, K₂O-nTiO₂C and the like.

Non-metal materials such as plant fibers, synthetic fibers and inorganic fibers coated or vapor-deposited on the surfaces with the above-mentioned metals, above-mentioned metal oxides or CNTs are also included in the fibrous conductors.

Examples of the above-mentioned needle-like conductors include needle-like conductors such as whiskers formed of metal, carbon-based compound, metal oxide or the like. Examples of the metal include elements belonging to group 2, group 3, group 4, group 5, group 6, group 7, group 8, group 11, group 12, group 13, group 14 or group 15 in the Periodic Table of elements. Specific examples thereof include gold, platinum, silver, nickel, stainless steel, copper, brass, aluminum, gallium, zirconium, hafnium, vanadium, niobium, tantalum, chromium, molybdenum, manganese, antimony, palladium, bismuth, technetium, rhenium, iron, osmium, cobalt, zinc, scandium, boron, gallium, indium, silicon, germanium, tellurium, tin, magnesium, or alloys containing these elements. The carbon-based compound includes carbon nanohorns, fullerenes, graphene and the like. The metal oxide include InO₂, InO₂Sn, SnO₂, ZnO, ZnO₂-Sb₂O₄, SnO₂-V₂O₅, TiO₂(Sn/Sb)O₂, SiO₂(Sn/Sb)O₂, K₂O-nTiO₂-(Sn/Sb)O₂, K₂O-nTiO₂-C and the like.

These linear structures can be used alone, or multiple linear structures can be used in combination. If necessary, other micro-nanosize conductive materials can be added.

Of these linear structures, silver nanowires or CNTs can be preferably used in view of optical properties such as transparency and conductivity.

As an example of the above-mentioned linear structure, CNTs will be described. The CNTs used as a component of the conductive layer may be single-layered CNTs, double-layered CNTs, triple-layered or higher multiple-layered CNTs. CNTs with a diameter of about 0.3 to 100 nm and a length of about 0.1 to 20 µm can be preferably used. In order to enhance transparency of the conductive laminate and to reduce the surface resistance value, single-layered CNTs or double-layered CNTs with a diameter of 10 nm or less and a length of 1 to 10 µm are more preferred. Further, it is preferred that the CNT aggregates do not contain such impurities as amorphous carbon and catalyst metal as far as possible. In case where the CNT aggregates contain these impurities, they can be appropriately refined by an acid treatment, a heat treatment or the like. The CNTs can be produced by an arc discharge method, a laser ablation method, a catalytic chemical vapor phase method (method of using a catalyst having a transition metal supported in a carrier among chemical vapor phase methods) or the like. Of these methods, a catalytic chemical vapor phase method with satisfactory productivity, capable of reducing formation of impurities such as amorphous carbon, is preferred.

A conductive layer can be formed by coating a substrate with a CNT dispersion. In order to obtain the CNT dispersion, CNTs and a solvent are commonly subjected to a dispersion treatment using a mixing/dispersion device or an ultrasonic irradiation device. A dispersing agent is preferably added when a dispersion treatment is performed.

There is no particular limitation on the dispersing agent as long as CNTs can be dispersed. In view of adhesion between the obtained conductive layer and the substrate, hardness and rub fastness of the conductive layer, it is preferred to select a polymer such as a synthetic polymer or a natural polymer. Further, a crosslinking agent can also be added to such an extent that dispersibility is not impaired.

Examples of the synthetic polymer used as the dispersing agent include polyether diol, polyester diol, polycarbonate diol, polyvinyl alcohol, partially saponified polyvinyl alcohol, acetacetyl group-modified polyvinyl alcohol, acetal group-modified polyvinyl alcohol, butyral group-modified polyvinyl alcohol, silanol group-modified polyvinyl alcohol, ethylene-vinyl alcohol copolymer, ethylene-vinyl alcohol-vinyl acetate copolymer resin, dimethylaminoethyl acrylate, dimethylaminoethyl methacrylate, acrylic resin, epoxy resin, modified epoxy resin, phenoxy resin, modified phenoxy resin, phenoxy ether resin, phenoxy ester resin, fluorine-based resin, melamine resin, alkyd resin, phenol resin, polyacrylamide, polyacrylic acid, polystyrenesulfonic acid, polyethylene glycol and polyvinylpyrrolidone. Examples of the natural polymer used as the dispersing agent include polysaccharides such as starch, pullulan, dextran, dextrin, guar gum, xanthan gum, amylose, amylopectin, alginic acid, gum arabic, carrageenan, chondroitin sulfate, hyaluronic acid, curdlan, chitin, chitosan, cellulose and cellulose derivatives. Derivatives mean compounds in which some of functonal groups undergo a reaction, for example, carboxylic acid groups are esterified in the case of a compound having carboxylic acid groups. These compounds can be used alone, or two or more of them can be used in combination. Of these compounds, polysaccharides and polysaccharide derivatives are preferred, since they are excellent in CNT dispersibility. Further, celluloses and cellulose derivatives are preferred since film formability is high. Above all, ester and ether derivatives are preferred. Specifically carboxymethyl cellulose, salts thereof and the like are preferable.

The mixing ratio between CNTs and the above-mentioned dispersing agent can also be adjusted. It is preferred that the mixing ratio between CNTs and the dispersing agent is such a ratio that does not cause any problem in adhesion to the substrate, hardness and rub fastness. Specifically, it is preferred that the amount of CNTs is in a range from 5% by mass to 90% by mass based on the total mass of the conductive layer. The amount is more preferably in a range from 35% by mass to 70% by mass. When the amount of CNTs is 5% by mass or more, conductivity required for the touch panel is easily obtained. Further, when the substrate is coated on the surface with the CNT dispersion, it becomes easy to uniformly coat with the dispersion without being repelled, and thus a conductive laminate with satisfactory appearance quality can be supplied at satisfactory productivity. It is preferred that the amount is 90% by mass or less since the dispersibility of CNTs in the solvent becomes better and cohesion is less likely to occur, and also a satisfactory CNT coating layer can be easily obtained and satisfactory productivity is achieved. Further, it is also preferred since the obtained coating film is also strong and abrasion is less likely to occur during the production process, and also uniformity of the surface resistance value can be maintained.

Examples of the nanowires of the metals and metal oxides are disclosed in Japanese Translation of PCT International Application Publication No. 2009-505358, Japanese Unexamined Patent Publication (Kokai) No. 2009-146747 and Japanese Unexamined Patent Publication (Kokai) No. 2009-70660. As needle-like conductors such as whiskers, for example, Dentol WK series (manufactured by Otsuka Chemical Co., Ltd.) such as WK200B, WK300R and WK500 comprising potassium titanate fibers and tin-antimony oxide as composite compounds, and Dentol TM series (manufactured by Otsuka Chemical Co., Ltd.) such as TM100 comprising silicon dioxide fibers and tin-antimony oxide as composite compounds are commercially available.

As shown in Fig. 2, the linear structure forms a network structure in the conductive layer. When the linear structure is a fibrous conductor, a single fibrous conductor 6 or an aggregate 7 of fibrous conductors overly each other to form contact points, and thus a network structure is formed. As shown in Fig. 2, the fibrous conductors often include straight line portions and bending portions in the network structure. Of the fibrous conductors, a structure called nanowire often has an arc shape, as indicated by symbol 8 in Fig. 2. A needle-like conductor 9 like whisker has a straight line shape. As shown in Fig. 2, the linear structure forms a network structure including contact points composed of overlying as indicated by symbols 11, 12 and 13 in the conductive layer.

The linear structure forms a network structure in the conductive layer, thereby, the network structure increases the conductive paths in the plane direction on the protective layer side of the conductive laminate, and the surface resistance value of the conductive layer on the protective layer side can be easily adjusted to a low level. Further, in the case of patterning the conductive layer, the acid component in the removing agent migrates along the network structure, to erode. Accordingly since the linear structures are more selectively eroded, the protective layer is more likely to remain, and the conductive laminate can have more satisfactory durability against heat. The network structure in the present invention means a structure in which linear structures contact each other at least at one contact point, and the smallest network structure is a structure in which two linear structures have a contact point. A contact point may be formed between given portions of linear structures. Ends of linear structures may contact each other, or an end of a linear structure may contact given portion other than the ends of another linear structure. Any portions other than the ends of linear structures may also contact each other. Further, at a contact point, the linear structures concerned may be bonded to each other or may also merely contact each other. The network structure can be observed by the below-mentioned method.

As the constituents of the protective layer in the present invention, inorganic polymer compounds or organic polymer compounds are preferably used.

The inorganic polymer compounds include inorganic oxides and the like. For example, it is possible to use sol-gel coating films formed by hydrolysis/polymerization reaction or vapor deposition films formed by sputtering of silicon oxides including tetraalkoxysilanes such as tetramethoxysilane, tetraethoxysilane, tetra-n-propoxysilane, tetra-i-propoxysilane and tetra-n-butoxysilane; trialkoxysilanes such as methyltrimethoxysilane, methyltriethoxysilane, ethyltrimethoxysilane, ethyltriethoxysilane, n-propyltrimethoxysilane, n-propyltriethoxysilane, i-propyltrimethoxysilane, i-propyltriethoxysilane, n-butyltrimethoxysilane, n-butyltriethoxysilane, n-pentyltrimethoxysilane, n-pentyltriethoxysilane, n-hexyltrimethoxysilane, n-heptyltrimethoxysilane, n-octyltrimethoxysilane, vinyltrimethoxysilane, vinyltriethoxysilane, cyclohexyltrimethoxysilane, cyclohexyltriethoxysilane, phenyltrimethoxysilane, phenyltriethoxysilane, N-(2-aminoethyl)-3-aminopropyltrimethoxysilane, N-(2-aminoethyl)-3-aminopropyltriethoxysilane, 3-chloropropyltrimethoxysilane, 3-chloropropyltriethoxysilane, 3,3,3-trifluoropropyltrimethoxysilane, 3,3,3-trifluoropropyltriethoxysilane, 3-aminopropyltrimethoxysilane, 3-aminopropyltriethoxysilane, 2-hydroxyethyltrimethoxysilane, 2-hydroxyethyltriethoxysilane, 2-hydroxypropyltrimethoxysilane, 2-hydroxypropyltriethoxysilane, 3-hydroxypropyltrimethoxysilane, 3-hydroxypropyltriethoxysilane, 3-mercaptopropyltrimethoxysilane, 3-mercaptopropyltriethoxysilane, 3-isocyanatopropyltrimethoxysilane, 3-isocyanatopropyltriethoxysilane, 3-glycidoxypropyltrimethoxysilane, 3-glycidoxypropyltriethoxysilane, 2-(3,4-epoxycyclohexyl)ethyltrimethoxysilane, 2-(3,4-epoxycyclohexyl)ethyltriethoxysilane, 3-(meth)acryloxypropyltrimethoxysilane, 3-(meth)acryloxypropyltriethoxysilane, 3-ureidopropyltrimethoxysilane, 3-ureidopropyltriethoxysilane, allyltrimethoxysilane and vinyltriacetoxysilane; and organoalkoxysilane such as methyltriacetyloxysilane and methyltriphenoxysilane.

The organic polymer compounds include thermoplastic resins, thermosetting resins, photocurable resins and the like, and can be appropriately selected in view of visible light transmittance, heat resistance of the substrate, glass transition point, film hardness and the like. Examples of these resins include organic polymer compounds, for example, polyester-based resins such as polyethylene terephthalate and polyethylene naphthalate, polycarbonate resins, acrylic resins, methacrylic resins, urethane acrylate-based resins, urethane methacrylate-based resins, epoxy-based resins, polyamide-based resins such as nylon and benzoguanamine, ABS resins, polyimide-based resins, olefin-based resins such as polyethylene and polypropylene, polystyrene resins, polyvinyl acetate resins, melamine-based resins, phenol-based resins, resins containing chlorine atoms such as polyvinyl chloride and polyvinylidene chloride, resins containing fluorine atoms (for example, resins in which fluorine atoms are contained in the structure of resins such as polyester-based resin, acrylic resin, methacrylic resin, epoxy-based resin, and olefin-based resin such as polyethylene or polypropylene), silicone-based resins (straight chain silicone-based resin, general silicone-based resin, a copolymer comprising a straight chain silicone-based resin or general silicone-based resin and another resin, a copolymer with graft structure, a modified silicone-based resin having various functional groups introduced into such structures as silicone molecular chain ends, molecular chains or branched chains of the copolymer comprising the above-mentioned straight chain silicone-based resin/the above-mentioned general silicone-based resin/the above-mentioned other resin and the copolymer with graft structure). The resin can be a resin obtained from a compound having two or more carbon-carbon double bond groups contributing to a polymerization reaction in the structure, which is used in the above-mentioned crosslinked layer. In response to applications and required properties and productivity, examples of usable one include, but are not limited to, these compounds alone or a composition obtained by mixing two or more of them, or an oligomer obtained by mixing two or more of them. It is more preferred to use a polymer compound which does not contain any of S element, P element, metal element, metal ion, and N element constituting a functional group. S element, P element and N element may have an electron pair (lone electron pair) in capable of being bound to another element in view of the electron orbit situation thereof or may form a functional group having an ionic bond with a metal ion (for example, -ONa, -COONa, -SO₃Na, etc.), and a metal element may form a coordination bond. The lone electron pair, ionic bond and coordination bond may be unstable to hear or easily act on the acid component in the removing agent, and the bond with the element to which N element, S element, P element, metal element or metal ion is bound may be easily cut and cleaved, and thus durability against heat of the protective layer may deteriorate or durability to the above-mentioned removing agent of the protective layer may deteriorate. Therefore, it is preferred to use a polymer compound which does not contain any of S element, P element, metal element, metal ion and N element constituting a functional group, since acid resistance is likely to be given and the thickness of the protective layer can be thinned, and also the acid component of the removing agent can be easily changed. Examples of the polymer compound which does not contain any of S element, P element, metal element, metal ion, and N element constituting a functional group include the acrylic resins, methacrylic resins, urethane acrylate resins, urethane methacrylate resins, resins containing fluorine element (F element), silicone resins and the like. In response to required properties, productivity and the like, these polymer compounds can be used alone, or two or more of them can be used in combination. In view of excellent optical properties such as transparency, satisfactory resistance to the acid component in the removing agent and the likes, it is possible to preferably use a polymer compound selected from a polyfunctional acrylic polymer compound, a polyfunctional methacrylic polymer compound, a polyfunctional urethane acrylate-based polymer compound and a polyfunctional urethane methacrylate-based polymer compound.

It is possible to preferably use, as a polyfunctional monomer or a polyfunctional oligomer which forms a polyfunctional acrylic polymer compound, a polyfunctional methacrylic polymer compound, a polyfunctional urethane acrylate-based polymer compound and a polyfunctional urethane methacrylate-based polymer compound, compounds exemplified as the above-mentioned compound having two or more carbon-carbon double bond groups contributing to a polymerization reaction in the structure, which is used in the above-mentioned crosslinked layer.

Furthermore, it is preferred that the polymer compound constituting the protective layer has a crosslinked structure, since durability against heat and resistance to the removing component of the removing agent can be further improved. The crosslinked structure refers to a state where the bonds of the constituents forming the protective layer are three-dimensionally connected. If the polymer compound has a crosslinked structure, it is estimated that the bonds of the constituents forming the protective layer become dense to reduce the free volume of the protective layer, and thus the effect of suppressing the migration of the oligomer from the substrate and the effect of suppressing permeation of the removing component into the protective layer are enhanced, whereby, durability to heat may be improved. The effect owing to the crosslinked structure can be similarly obtained, irrespective of whether the polymer compound is organic or inorganic. However, if an inorganic polymer compound has a crosslinked structure, flexibility or bendability deteriorates to make the protective layer fragile, as compared with the organic polymer compound, and brittle fracture is likely to occur at the time of production. Therefore, the crosslinked structure of an organic polymer compound is preferred.

The method for making an organic polymer compound have a crosslinked structure will be described below. The following method can be preferably applied even in the case of laminating the above-mentioned crosslinked layer. The method includes a method in which a polyfunctional monomer or polyfunctional oligomer is used as a raw material and then cured by heating, or photocured by irradiation with radiations such as ultraviolet light, visible light and electron beam. In the case of thermosetting, heat energy is a driving force of curing reaction and, when a monomer or oligomer is made more polyfunctional, the reaction takes time and any measure such as elongation of the curing time may be sometimes required. On the other hand, in the case of photocuring, the below-mentioned photo-initiator is contained and is irradiated with the above-mentioned active electron beam to generate an initiation species that easily causes a reaction to progress like a chain reaction, and therefore a short curing time can be adopted. Because of such reason, photocuring is more preferred.

As used herein, a photo-initiator is a substance which absorbs radiations such as ultraviolet light, visible light and electron beam to produce active species such as radical species, cationic species and anionic species as the reaction initiation species, to initiate a chemical reaction. These photo-initiators can be used alone, and it is preferred to use two or more photo-initiators having maximum absorption wavelengths which are different from each other by 20 nm or more.

The reason is explained below. For example, in case where the initiation species are radical species, radical species have very highly reactivity. Because of high reactivity, radicals may be inactivated before the reaction. In this case, the curing reaction does not progress as expected, and thus the crosslinked structure is not sufficiently formed. However, an emitter such as a lamp capable of emitting the above-mentioned active electron beam actually does not emit a single wavelength only, but emits various wavelengths. When two or more photo-initiators having maximum absorption wavelength values different from each other by 20 nm or more are mixed, a wider region of wavelengths can be employed, and thus enabling the curing reaction to progress sufficiently. It is more effective contain three or more photo-initiators.

The maximum absorption wavelength as used herein means a wavelength at the maximum value of the absorption spectrum obtained by ultraviolet-visible spectrophotometry (UV-Vis) when a photo-initiator is dissolved in a soluble solvent. In case where there are multiple maximum values, the maximum value having the largest absorbance among multiple maximum values is employed. In casewhere the difference between the maximum absorption wavelength values is less than 20 nm, there is a region where the absorption bands of the mixed photo-initiators superimpose each other, and in this case, it is estimated that the effect obtained is equivalent to the effect obtained when only one photo-initiator is used.

The initiation species of the above-mentioned reaction are likely to be deactivated as a result of a reaction with oxygen in air with ease. In order to suppress deactivation of the initiation species by oxygen, it is effective to form the crosslinked structure of the protective layer under the atmosphere replaced by an inert gas such as nitrogen or argon, or atmosphere obtained by reducing the oxygen concentration such as environment obtained by removing oxygen. If such a special atmosphere is employed, enormous equipment is required disadvantageously in view of productivity and cost. It is particularly preferred to form the crosslinked structure by mixing two or more photo-initiators having maximum absorption wavelength values which are different from each other by 20 nm or more under the atmosphere obtained by reducing the oxygen concentration.

Examples of usable photo-initiators include benzophenone-based photo-initiators such as benzophenone, hydroxybenzophenone and 4-phenylbenzophenone; benzoin-based photo-initiators such as benzyl dimethyl ketal; α-hydroxyketone-based photo-initiators and α-aminoketone-based photo-initiators, such as 1-hydroxy-cyclohexyl-phenyl-ketone, 2-hydroxy-2-methyl-1-phenylpropan-1-one, 2-methyl-1-[4-(methylthio)phenyl]-2-morpholinopropan-1-one and 2-benzyl-2-dimethylamino-1-(4-morpholinophenyl)-butanone-1; thioxanthone-based photo-initiators such as isopropylthioxanthone and 2-4-diethylthioxanthone; methylphenyl glyoxylate and the like. Examples of commercially available products of photo-initiators include Ciba (registered trademark) IRGACURE (registered trademark) 184 (manufactured by Ciba Japan K.K.) as 1-hydroxy-cyclohexyl-phenyl-ketone, Ciba (registered trademark) IRGACURE (registered trademark) 907 (manufactured by Ciba Japan K.K.) as 2-methyl-1-[4-(methylthio)phenyl]-2-morpholinopropan-1-one, Ciba (registered trademark) IRGACURE (registered trademark) 369 (manufactured by Ciba Japan K.K.) as 2-benzyl-2-dimethylamino-1-(4-morpholinophenyl)-butanone-1 and the like.

In the conductive laminate of the present invention, a static friction coefficient between the crosslinked layer side and the protective layer side in accordance with JIS C2151 (2006) (hereinafter sometimes simply referred to as static friction coefficient) is 0.75 or less, and a dynamic friction coefficient in accordance with JIS C2151 (2006) (hereinafter sometimes simply referred simply to as dynamic friction coefficient) is 0.65 or less. Commonly, the conductive laminate of the present invention is often produced by so-called roll-to-roll process in which a substrate wound-up into a roll shape is unwound by a processing device in the case of laminating on a substrate, to form a certain layer on the substrate, and then the substrate is wound-up again into a roll shape. Also in the case of processing into an electrode member after the production of the conductive laminate of the present invention, roll-to-roll processing is often employed similarly. In the roll-to-roll process, a roll is formed in a case where the crosslinked layer side of the conductive laminate is in contact with the protective layer side. In the case of unwinding and winding-up the roll, either or both of the crosslinked layer and the protective layer may be scratched by friction therebetween. The thus formed scratched portions constitute defects such as cracks due to gouging or cracking of each layer. Therefore, the crosslinked layer and the protective layer have significantly small thickness or the substrate is exposed in the portions, and thus the portions may serve as a starting point of the generation of an oligomer by heat. In the scratched portions, the network structure of linear structures is broken to cause suppression of the flow of electrical current, leading to an increase in surface resistance value. Alternatively, the scratched portions may become visually recognizable defects, leading to a decrease in quality level when products such as touch panels and electronic papers are produced. When the static friction coefficient between the crosslinked layer side and the protective layer side is 0. 75 or less and also the dynamic friction coefficient is 0. 65 or less, moderate slip of the crosslinked layer and the protective layer occurs and the layers are not scratched by friction in the production of multiple roll-to-roll processing. As a result, it is possible to provide a conductive laminate and a product using the same with durability against heat, satisfactory conductivity and high quality level. When the static friction coefficient is more than 0.75, the position where the crosslinked layer is in contact with the protective layer may be likely to be scratched at the time of initiation of an operation in the case of processing. When the dynamic friction coefficient is more than 0.65, scratches may be continuously formed during an operation in the case of processing. The static friction coefficient is preferably 0.60 or less, and more preferably 0.55 or less. The dynamic friction coefficient is preferably 0.50 or less, and more preferably 0.45 or less. There is no particular limitation on the lower limit of each friction coefficient, in view of the formation of the above-mentioned scratches. Excess slip may occur depending on a method of winding or winding hardness in the case of winding up the conductive laminate on a roll, and thus it may become difficult to wind up or the roll shape may be likely to be collapsed when the roll inclines at the time of transfer. Therefore, it is preferred that the static friction coefficient is 0.08 or more and the dynamic friction coefficient is 0.05 or more.

The method of adjusting the static friction coefficient and dynamic friction coefficient in the above-mentioned specific range includes a method in which an additive for improving slipperiness is mixed in the crosslinked layer or the protective layer. However, since the additive may bleed out, it is preferred that the additive is reacted with a compound used to form each layer to fix to the compound by heating or irradiating with radiations such as ultraviolet light, visible light and electron beam, or a method of selecting a compound per se used to form each layer, which is capable of forming a layer satisfying each friction coefficient, is employed. It is also possible to apply a method for adjusting the static friction coefficient and the dynamic friction coefficient in the specific range to both the crosslinked layer and the protective layer. However, the method can be applied only to one layer as long as the effect is exerted. Taking the effect or influence on the linear structure as a conductive material into consideration, it is preferred to apply to the crosslinked layer side. Examples of the additive for decreasing the static friction coefficient and the dynamic friction coefficient include a low-molecular compound/monomer/oligomer or the like containing fluorine atoms, a silicone-based low-molecular compound/monomer/oligomer resin and the like. Using monomers or oligomers, such as silicone triacrylate, silicone trimethacrylate, silicone tetraacrylate, silicone tetramethacrylate, silicone pentaacrylate, siliconepentamethacrylate, siliconehexaacrylate and silicone hexamethacrylate, each including a silicone skeleton introduced thereinto, as the additive, and these additives can be fixed by reacting with a compound used to form each layer. Examples of the commercially available additive include EBECRYL1360 manufactured by DAICEL-CYTEC Company LTD., X-12-2456 series manufactured by Shin-Etsu Chemical Co., Ltd. and the like.

In the conductive laminate of the present invention, the number of scratches generated in a direction parallel to a friction direction is preferably 10 or less in 2 cm square when a surface of either the crosslinked layer or the protective layer is subj ected to reciprocating friction for 50 times by a method in accordance with JIS L0849 (2004), using an attached white cotton cloth (Kanakin No. 3) for test. As mentioned above, since scratches formed on the crosslinked layer and the protective layer can cause deterioration of durability against heat, conductivity and quality level, the crosslinked layer or protective layer per se is preferably a layer having scratching resistance which means difficulty in scratch formation, that is, high surface rub fastness. The number of scratches generated in a direction parallel to a friction direction is preferably 5 or less, more preferably 3 or less, and most preferably 0 in 2 cm square. The method of adjusting the number of scratches to 10 or less in 2 cm square includes a method using a compound having four or more functional groups contributing to a polymerization reaction in the molecule, that is, a tetrafunctional or higher polyfunctional compound of compounds for forming the crosslinked layer or the protective layer. It is estimated that introduction of the tetrafunctional or higher polyfunctional compound enables immobilization of molecular chains at that position, and that surface rub fastness is enhanced when molecular chains are less likely to be cut by a physical force (reciprocating friction for 50 times by an attached white cotton cloth (Kanakin No. 3) for test in this case). Examples of the above-mentioned compound used in the crosslinked layer or the protective layer, which is likely to improve surface rub fastness, include pentaerythritol tetraacrylate, pentaerythritol tetramethacrylate, pentaerythritol ethoxy tetraacrylate, pentaerythritol ethoxy tetramethacrylate, dipentaerythritol tetraacrylate, dipentaerythritol tetramethacrylate, dipentaerythritol pentaacrylate, dipentaerythritol pentamethacrylate, dipentaerythritol hexaacrylate, dipentaerythritol hexamethacrylate, ditrimethylolpropane tetraacrylate, ditrimethylolpropane tetramethacrylate and the like. The compound also includes any one of tetraacrylate, tetramethacrylate, pentaacrylate, pentamethacrylate, hexaacrylate and hexamethacrylate, each partially having a cyclic skeleton such as a cyclopropane ring, a cyclobutane ring, a cyclopentane ring or a cyclohexane ring in the molecular structure. The compound also includes compounds in which the structure of the above-mentioned compound is partially modified, for example, 2-hydroxypropanoic acid-modified pentaerythritol tetraacrylate and 2-hydroxypropanoic acid-modified pentaerythritol tetramethacrylate, each being modified with 2-hydroxypropanoic acid. The compound also includes silicone tetraacrylate, silicone tetramethacrylate, silicone pentaacrylate, silicone pentamethacrylate, silicone hexaacrylate and silicone hexamethacrylate, each including a silicone skeleton introduced thereinto. The compound further includes those including other skeletons, together with a carbon-carbon double bond group included in the skeleton, for example, urethane tetraacrylate, urethane tetramethacrylate, urethane pentaacrylate, urethane pentamethacrylate, urethane hexaacrylate and urethane hexamethacrylate, each including a urethane skeleton; polyether tetraacrylate, polyether tetramethacrylate, polyether pentaacrylate, polyether pentamethacrylate, polyether hexaacrylate and polyether hexamethacrylate, each including an ether skeleton; epoxy tetraacrylate, epoxy tetramethacrylate, epoxy pentaacrylate, epoxy pentamethacrylate, epoxy hexaacrylate and epoxy hexamethacrylate, each including an epoxy-derived skeleton; and polyester tetraacrylate, polyester tetramethacrylate, polyester pentaacrylate, polyester pentamethacrylate, polyester hexaacrylate and polyester hexamethacrylate, each including an ester skeleton. These compounds can be selected and used in response to applications and required properties and productivity. It is also possible to use these compounds alone or a composition obtained by mixing two or more of them, or an oligomer obtained by mixing two or more of them.

In the conductive laminate of the present invention, the crosslinked layer side preferably has a surface resistance value of 1 × 10¹³ Ω/□ or less. In case where static electricity is generated in the crosslinked layer side, dust and dirt may adhere to cause scratches and defects, thus leading to deterioration of durability against heat and decrease in quality level of the obtained touch panel and electronic paper. When the surface resistance value of the crosslinked layer side has antistatic properties of 1 × 10¹³ Ω/□ or less, dust and dirt are less likely to adhere in the transportation and processing steps even if the environment is not dust-proof environment, and thus being free from scratches and defects due to adhesion of dust and dirt. Therefore, it is preferred since products such as touch panels and electronic papers in high quality level can be obtained without causing deterioration of durability against heat. The surface resistance value of the crosslinked layer side is preferably 1 × 10¹² Ω/□ or less, and more preferably 1 × 10¹⁰ Ω/□ or less. The surface resistance value of the crosslinked layer side is preferably 1 × 10⁸ Ω/□ or more. Examples of antistatic mechanism, which can be applied to the present invention, include (1) ionic conduction and (2) electronic conduction.

In order to apply antistatic mechanism by ionic conduction (1), it is possible to adjust the surface resistance value of the crosslinked layer by mixing cationic, anionic and nonionic components in the constituents of the crosslinked layer, or directly bonding to the constituents in the layer. The method of directly bonding to the constituents in the layer is preferred since the component capable of imparting antistatic properties is less likely to cause bleed out or degradation and thus it is easy to maintain the initial surface resistance value over the long period. Specifically, it is preferred to introduce a component having a quaternary ammonium salt-based functional group capable of imparting antistatic properties into a part of the constituents contained in the crosslinked layer. Examples of commercially available components usable in the mixing method include Electrostripper (registered trademark) QN, Electrostripper (registered trademark) AC, RHEODOL (registered trademark) TW-L120 and EMASOL (registered trademark) L-10V manufactured by Kao Corporation; Hostastat (registered trademark) FA 14, Hostastat (registered trademark) FA 18, Hostastat (registered trademark) FA 38, Hostastat (registered trademark) FE 2 and Hostastat (registered trademark) FE 20 manufactured by Clariant (Japan) K.K.; and "SAFTOMER" (registered trademark) ST-1000 series, "SAFTOMER" (registered trademark) ST-2000 series and "SAFTOMER" (registered trademark) ST-3000 series manufactured by Mitsubishi Chemical Corporation. Examples of commercially available components usable in the method of directly bonding to a part of the constituents contained in the crosslinked layer include Fulcure (registered trademark) HCE-022 and Fulcure (registered trademark) HCE-032 manufactured by Soken Chemical & Engineering Co., Ltd.; and "LIODURAS (LIODURAS)" (registered trademark) LAS1211 manufactured by TOYO INK MFG. CO., LTD.

Antistatic mechanism by electronic conduction (2) is that the constituents per se which conduct electricity, for example, metal microparticles, fine metal oxide particles, or linear structures used in the present invention are allowed to contain in the layer to be imparted with antistatic properties, thereby, the surface resistance value is adjusted by the conductivity possessed by the constituents per se. The linear structures as the conductive component of the above-mentioned conductive layer can be applied as the constituents per se which conduct electricity, or antimony pentoxide, tin oxide, antimony-doped tin oxide (ATO), indium oxide, tin-doped indium oxide (ITO), or zinc oxide, titanium oxide, zirconium hydroxide, barium sulfide and tin oxide doped or surface-coated with the constituent selected from Al, Ga, Sn, P, F and ATO can be used. Examples of commercially available fine-particle powder include Pasutoran (registered trademark) TYPE-IV 4000 series and Pasutoran (registered trademark) TYPE-IV 6000 series manufactured by Mitsui Mining & Smelting Co., Ltd.; and Pazet CK, Pazet GK, Pazet AK, Pazet AB and 23-K manufactured by Hakusuitech Co., Ltd. Examples of the coating solution prepared by dispersion or compatibilization processing of a commercially available fine-particle powder to a solvent or a binder component include TR-AS-1 (lot.2, trial product number) manufactured by Sumitomo Osaka Cement Co., Ltd.; and ELCOM (registered trademark) P-3501 and ELCOM (registered trademark) TO-1002ATC manufactured by Catalysts & Chemicals Industries Co., Ltd. Examples of commercially available products prepared by mixing with a conductive component, together with the compound usable in the above-mentioned crosslinked layer include Fulcure (registered trademark) LHT-11 manufactured by Soken Chemical & Engineering Co., Ltd.; and "LIODURAS" (registered trademark) LASTYP series, "LIODURAS" (registered trademark) LASTYZA series, "LIODURAS" (registered trademark) LASTYST series, "LIODURAS" (registered trademark) LASTYPT series and "LIODURAS" (registered trademark) LASTYA series manufactured by TOYO INK MFG. CO., LTD.

In the conductive laminate of the present invention, a color tone b* of transmitted light in an L*a*b* color system in accordance with JIS Z8729 (2004) is preferably 1.5 or less when light emitted from a light source C is made incident from the crosslinked layer side. Touch panel or electronic paper sometimes uses multiple electrode members depending on the configuration or operation system. Display principle of touch panel or electronic paper utilizes transmitted light emitted from a light source disposed at a back surface of a display section calledbacklight, or reflected light of light incident from outside. Therefore, when multiple electrode members are used, it looks yellowish due to light absorption by each layer of the conductive laminate or reflection of light at the interface between air and each layer, and thus deterioration of color reproductivity or image quality of displayed image may occur. When the color tone b* of transmitted light (light source C) in accordance with JIS Z8729 (2004) is 1.5 or less when light emitted from a light source C is made incident from the crosslinked layer side of the conductive laminate using a color tone b* value of transmitted light (light source C) as an indicator of yellowness is 1.5 or less, it is also possible to prevent deterioration of color reproductivity or image quality of displayed image in the product including multiple conductive laminates of the present invention. The color tone b* value of transmitted light (lightsourceC) is preferably 1. 0 or less, andmorepreferably 0.5 or less. The b* value (light source C) is preferably -5.0 or more, more preferably -4.0 or more, and still more preferably -3.0 or more.

As the method of adjusting b* value (light source C) of transmitted light to 1. 5 or less, a method of coloring the conductive laminate blue as a complementary color of yellow is effective, and it is possible to decrease the b* value by the addition of an additive such as a blue-based coloring matter, a dye or a pigment, or a blue-colored resin component, followed by dispersion, compatibilization or binding. Examples of the additive such as the blue-based coloring matter, dye or pigment include a compound including an anthraquinone skeleton, a compound including a porphyrin skeleton, a compound including a tetraazaporphyrin skeleton, a compound including a phthalocyanine skeleton, Pigment Blue 15, 15:3, 15:4, 15:6, 22, 60, 64; and compounds disclosed in Japanese Patent No. 3879402 and Japanese Patent No. 4440720. Examples of commercially available products include Kayaset (registered trademark) series, such as Kayaset (registered trademark) Blue FR, Kayaset (registered trademark) Blue N, Kayaset (registered trademark) Blue A-2R, Kayaset (registered trademark) Blue A-D and Kayaset (registered trademark) Blue A-CR manufactured by Nippon Kayaku Co., Ltd. The layer to be colored using these blue-based additives can be any of a substrate, a crosslinked layer, a conductive layer and a protective layer. Taking the influence on linear structures as a conductive material, productivity and the like into consideration, it is preferred to color the crosslinked layer. Preferred content of the blue-based additive varies depending on type of the additive and thickness of the layer, and product (T) × (A) (where T denotes the thickness (µm) of the layer to which the additive is added, and A denotes mass content (% by mass) of a blue-based additive based on the total solid content to the layer to which the additive is added) is preferably 0.10 or more and 0.50 or less, and more preferably 0.15 or more and 0.30 or less.

It is preferred that the conductive laminate of the present invention is a conductive laminate with a total light transmittance of 80% or more in accordance with JIS K 7361-1 (1997) in case where light falls on the above-mentioned conductive layer side. The touch panel in which the conductive laminate with a total light transmittance of 80% or more is assembled shows excellent transparency, and the image presented by the display provided as an underlying layer of the touch panel using the conductive laminate can be vividly recognized. The total light transmittance is preferably 85% or more, and more preferably 90% or more. Examples of the method for enhancing the total light transmittance include a method of enhancing the total light transmittance of the substrate used, a method of reducing the thickness of the above-mentioned conductive layer, a method of laminating the protective layer in such a manner that the protective layer may become an optical interference film, a method of reducing the amount of the above-mentioned blue additive as far as possible and the like.

The method for enhancing the total light transmittance of the substrate includes a method of reducing the thickness of the substrate or a method of selecting a material with a high total light transmittance for the substrate. The material with a high total light transmittance includes, for example, a resin or glass having high transparency. Even a windable film with a thickness of 250 µm or less or a substrate with a thickness of more than 250 µm can be preferably used if the total light transmittance is in the abovementioned range. In view of cost, productivity, handling properties and the like, the resin film is preferably a resin film with a thickness of 250 µm or less, more preferably 190 µm or less, still more preferably 150 µm or less, and most preferably 100 µm or less. Use of the substrate having a thickness of 100 µm or less enables weight saving or thinning, improvement in optical properties, and reduction in thermal processing temperature or decrease in thermal processing times because of thin substrate in touch panels and electronic papers using multiple conductive laminates as an electrode member. Therefore, the generation of the oligomer during processing may be suppressed, leading to significant cost and property-related advantage in the case of producing products such as touch panels and electronic papers. Examples of the resin having high transparency include polyester such as polyethylene terephthalate (PET) or polyethylene naphthalate (PEN), polyimide, polyphenylene sulfide, aramid, polypropylene, polyethylene, polylactic acid, polyvinyl chloride, polycarbonate, polymethylmethacrylate, alicyclicacrylic resin, cycloolefin resin, triacetyl cellulose, and a mixture and/or copolymer of these resins. It is possible to use, as the substrate, a non-stretched, monoaxially stretched or biaxially stretched film formed of these resins. Of these substrates, in view of moldability, optical properties such as transparency, productivity and the like, a polyester film of polyethylene terephthalate (PET) or polyethylene naphthalate (PEN), a PET film mixed and/or copolymerized with PEN, a polypropylene film and an aramid film can be preferably used. As the material of the glass substrate, ordinary soda glass can be used.

These multiple substrates can also be used in combination. For example, a composite substrate such as a substrate obtained by combining a resin and glass or a substrate obtained by laminating two or more resins can also be used. Furthermore, a substrate treated on the surface, if necessary, can also be used. The surface treatment can be physical treatment such as glow discharge, corona discharge, plasma treatment or flame treatment, or can also be the provision of a resin layer. It is also possible to preferably use, as the substrate, a film with an easy-adhesion layer on a surface can also be used. The type of the substrate is not limited to those mentioned above, and an optimum substrate can be selected in response to applications in view of transparency, durability, flexibility, cost and the like.

The method for laminating a protective layer in such a manner that the protective layer may be an optical interference film will be described below. A conductive layer reflects or absorbs light owing to the physical properties of the conductive component. Therefore, in order to raise the total light transmittance of the conductive laminate, it is effective that the protective layer is formed to be an optical interference film, and the average reflectance on the protective layer side in a wavelength range from 380 to 780 nm is lowered to 4% or less. The average reflectance on the protective layer side in a wavelength range from 380 to 780 nm is preferably 3% or less, and more preferably 2% or less. The average reflectance is preferably 4% or less, since the performance of 80% or more total light transmittance in case where the conductive laminate is used for touch panel application or the like can be obtained at satisfactory productivity.

It is preferred that the conductive laminate of the present invention has a surface resistance value of 1 × 10° Ω/□ or more and 1 × 10⁴ Ω/□ or less on the conductive layer side thereof. The surface resistance value is more preferably 1 × 10¹ Ω/□ or more and 1.5 × 10³ Ω/□ or less. When the surface resistance value is in this range, the conductive laminate can be preferably used for a touch panel. That is, when the surface resistance value is 1 × 10° Ω/□ or more, the power consumption can be kept small. When the surface resistance value is 1 × 10⁴ Ω/□ or less, the influence on the error in a touch panel digitizer can be lessened.

To the substrate and the respective layers, various additives can be added to such an extent that the effects of the present invention are not impaired. Examples of the additives include organic and/or inorganic fine particles, crosslinking agents, flame retarders, flame retardant aids, heat-resistant stabilizers, oxidation-resistant stabilizers, leveling agents, slip activators, conductive agents, antistatic agents, ultraviolet absorbers, photostabilizers, nucleating agents, dyes, fillers, dispersing agents, coupling agents and the like.

The method for producing the conductive laminate of the present invention will be described by way of examples. In the case of producing the conductive laminate of the present invention, it is preferred that a crosslinked layer is formed on one surface of a substrate and a conductive layer is formed on the other surface of the substrate, and then a protective layer is formed on the conductive layer.

As the method for forming the crosslinked layer, the conductive layer and the protective layer, it is only required to select an optimum method in response to the material to be formed, and examples thereof include drymethods such as vacuum deposition, EB deposition and sputtering methods; wet coating methods such as casting, spin coating, dip coating, bar coating, spraying, blade coating, slit die coating, gravure coating, reverse coating, screen printing, mold coating, print transfer and ink jet methods; and other general methods. Of these method, a slit die coating capable of laminating the protective layer uniformly and unlikely to flaw the conductive layer or a wet coating method using micro gravure capable of forming the protective layer uniformly with satisfactory productivity are preferred.

The method for forming a pattern in the conductive laminate of the present invention by chemical etching using a removing agent will be described below in reference to an example. The protective layer side of the conductive laminate of the present invention is coated with the removing agent at the portions to be removed. Since the removing agent used in the present invention has non-Newtonian flowability, a publicly known method can be used for coating irrespective of the type, size and form of the conductive laminate. Examples of the coating method include, but are not limited to, screen printing method, dispenser method, stencil printing method, pad printing method, spray coating, ink jet method, micro gravure printing method, knife coating method, spin coating method, slit coating method, roll coating method, curtain coating method, flow coating method and the like. Further, in order to decrease the etching irregularity of the conductive layer, it is preferred to uniformly coat the protective layer of the conductive laminate with the removing agent.

The coating thickness of the removing film is appropriately decided by the material and thickness of the conductive layer to be removed, heating temperature and heating time. It is preferred to coat to ensure that the thickness after drying may be from 0.1 to 200 µm, and more preferably from 2 to 200 µm. When the thickness of the removing agent after drying is kept in the above-mentioned range, the coating film contains a required amount of the conductive layer removing component, and the conductive layer can be removed more uniformly in the plane. Further, since the sags in the horizontal direction can be suppressed at the time of heating, a designed pattern free from the shift of coating film border lines can be obtained.

Then, the conductive laminate coated with the removing agent is heat-treated at 80°C or higher. It is preferred that the heat treatment temperature is lower than the boiling points of the other constituents than the solvent of the removing agent, and 200°C or lower. When heat treatment is performed in the above-mentioned temperature range, the conductive layer is decomposed, dissolved or solubilized in the portions coated with the removing agent. The heat treatment method can be selected in response to purposes and applications. Examples thereof include, but are not limited to, hot plate, hot air oven, infrared oven, microwave irradiation with a frequency of 300 megahertz to 3 terahertz and the like.

After completion of heat treatment, the removing agent and the dissolved or decomposed matter of the conductive layer and protective layer are removed by washing with a liquid to obtain a desired conductive pattern. The liquid used in the washing step is a preferably liquid capable of dissolving the resin contained in the removing agent. Examples of the liquid include, but are not limited to, ketones such as acetone, alcohols such as methanol, organic solvents such as tetrahydrofuran, an aqueous solution containing any of the above-mentioned organic solvents, a basic aqueous solution containing sodium hydroxide, ethanolamine, triethylamine or the like, pure water and the like. In order to wash without leaving residues in the washing step, the above-mentioned liquid may be heated to 25 to 100°C when used.

The removing agent will be described below. The removing agent is a solution containing an acid component or a base component. When the removing agent contains an acid component or a base component, linear structures of the conductive layer can be selectively removed by coating the protective layer with the removing agent. The acid component or base component is preferably one component selected from the group consisting of an acid with a boiling point of 80°C or higher, a base with a boiling point of 80°C or higher, and a compound capable of generating an acid or a base by external energy. The removing agent preferably contains an acid component or a base component, a solvent, a resin, and a leveling agent. When the leveling agent is contained, it gives a high permeation power and the fibrous conductive component can be easily removed though the removal has been difficult hitherto. When the protective layer on the conductive layer side is partially coated with the removing agent, heat-treated at 80°C or higher and washed using a liquid, to remove the conductive layer, and thus the conductive layer can be selectively removed in the portions coated with the removing agent. When the removing agent is applied to desired places, a complicated and highly precise pattern including sharp angles and curves can be formed as desired. It is preferred that the heat treatment temperature is lower than the boiling points of the constituents other than the solvent of the removing agent and lower than 200°C.

As used herein, the boiling point refers to the value at atmospheric pressure and is measured in accordance with JIS K 5601-2-3 (1999). The boiling point of the removing agent is preferably 100°C or higher, and more preferably 200°C or higher. In the present invention, an acid which does not have a clear boiling point and begins to be thermally decomposed at 80°C or higher without being gasified when heated is also included in the acid with a boiling point of 80°C or higher. An acid with a vapor pressure density of 30 kPa or less at the heat treatment temperature for removing the conductive layer is more preferred. Examples of the acid with a boiling point of 80 °C or higher include monocarboxylic acids such as formic acid, acetic acid and propionic acid; dicarboxylic acids such as oxalic acid, succinic acid, tartaric acid and malonic acid; tricarboxylic acids such as citric acid and tricarballylic acid; alkylsulfonic acids such as methanesulfonic acid; phenylsulfonic acids such as benzenesulfonic acid; alkylbenzenesulfonic acids such as toluenesulfonic acid and dodecylbenzenesulfonic acid; phenolsulfonic acids; nitrobenzenesulfonic acids; styrenesulfonic acids; sulfonic acid compounds such as phenolsulfonic acid; derivatives obtained by partially fluorinating organic acids such as trifluoroacetic acid; inorganic acids such as sulfuric acid, hydrochloric acid, nitric acid and phosphoric acid; and the like. Two or more acids can also be used in combination.

Of these acids, an acid with high oxidizing power is preferred, and sulfuric acid or sulfonic acid compound is more preferred. The boiling point of sulfuric acid at atmospheric pressure is 290 °C, and the vapor pressure density at 150 °C of sulfuric acid is 1.3 kPa or less. Therefore, even if sulfuric acid is heated at this temperature, it remains liquid and permeates deep into the linear structures in the conductive layer. Since sulfuric acid has high oxidizing power, sulfuric acid easily reacts with the conductive layer even at a low temperature of about 80 to about 200°C, and can remove the conductive layer without affecting the substrate by a heat treatment for a shorter period of time than that required by nitric acid or acetic acid. Since a sulfonic acid compound is a solid acid at atmospheric pressure, it does not evaporate, and the vapor pressure density is 150°C is 1.3 kPa or less. Therefore, even if it is heated at this temperature, it neither evaporates nor sublimes, and at the time of heating, the reaction is efficiently accelerated. Therefore, it can remove the conductive layer by a heat treatment for a short period of time. Further, a removing agent containing a solid acid allows easy control of non-Newtonian flowability, and thus a sulfonic acid compound is particularly preferred since highly precise patterning can be performed. A straight line pattern with a line width of about 30 µm can be formed with less variation of line width (line bending), particularly preferably.

The boiling point of a base used in the removing agent is preferably 100°C or higher, and more preferably 150°C or higher. A base, which does not have a clear boiling point under atmospheric pressure and begins to be thermally decomposed before vaporization when heated, is included in the base with the boiling point of 80°C or higher when the thermal decomposition beginning temperature is 80°C or higher. The base is more preferably a base in which vapor pressure at the heat treating temperature upon removal of the conductive film is 30 kPa or less. Examples of the base with the boiling point of 80°C or higher include sodium hydroxide, potassium hydroxide, cesium hydroxide, tetramethylammonium hydroxide, barium hydroxide, guanidine, trimethylsulfonium hydroxide, sodium ethoxide, diazabicycloundecene, hydazine, phosphazene, proazaphosphatrane, ethanolamine, ethylenediamine, triethylamine, trioctylamine, alkoxysilane having amino groups and the like. Two or more bases can be used in combination.

The compound capable of generating an acid by external energy can be a compound capable of generating an acid by irradiation with radiation such as ultraviolet light and/or heat. Examples of the compound include sulfonium compounds such as 4-hydroxyphenyldimethylsulfonium, hexafluoroantimonate, and trifluoromethanesulfonate; benzophenone compounds such as 4,4-bis(dimethylamine)benzophenone and 4,4-dichlorobenzophenone; benzoin compounds such as benzoin methyl ether; phenyl ketone compounds such as 4-benzoyl-4-methyl diphenyl ketone and dibenzyl ketone; acetophenone compounds such as 2,2-diethoxyacetophenone and 2-hydroxy-2-methylpropionephenone; thioxanthene compounds such as 2,4-diethylthioxanthen-9-one and 2-chlorothioxanthene; anthraquinone compounds such as 2-aminoanthraquinone and 2-ethylanthraquinone; anthrone compounds such as benzanthrone and methyleneanthrone; imidazole compounds such as 2,2-bis(2-chlorophenyl)-4,4,5,5-tetraphenyl-1,2-biimidazole; triazine compounds such as 2-(3,4-dimethoxystyryl)-4,6-bis(trichloromethy)-1,3,5-triazin e and 2-[2-(5-methylfuran-2-yl)vinyl]-4,6-bis(trichloromethyl)-1,3, 5-triazine; benzoyl compounds such as 2-benzoylbenzoic acid and benzoyl peroxide; sulfone compounds such as 2-pyridyl tribromomethyl sulfone and tribromomethyl phenyl sulfone; iodonium compounds such as 4-isopropyl-4-methyldiphenyliodonium tetrakis(pentafluorophenyl)borate and diphenyliodonium trifluoromethane sulfonic acid; tetramethylthiuram disulfide, 9-fluorenone, dibenzosuberone, N-methylacridone, nifedipine, camphorquinone, carbon tetrabromide and the like. Two or more of these compounds can also be used in combination as a mixture.

The compound capable of generating an acid by external energy can be a compound capable of generating a base by irradiation with radiation such as ultraviolet light and/or heat. Examples of the compound include amine compounds such as bis[(α-methyl)-2,4,6-trinitrobenzyloxycarbonyl]methanedipheny lenediamine and N-[(2-nitrophenyl)-1-methylmethoxy]carbonyl-2-propylamine; benzyl carbamate, benzylsulfonamide, benzyl quaternary ammonium salt, imine, iminium salt, cobalt amine complex, oxime compound and the like. Two or more of these compounds can also be used in combination as a mixture.

In the removing agent used in the present invention, the content of the acid or base component preferably from 1 to 80% by mass in the constituents other than the solvent. Above all, the content as mass percentage of the acid with a boiling point of 80 °C or higher in the constituents other than the solvent is preferably from 10 to 70% by mass, and more preferably from 20 to 70% by mass. The content of the base with a boiling point of 80°C or higher in the constituents other than the solvent is preferably from 0.01 to 70% by mass. The content of the compound capable of generating an acid by external energy is preferably from 0.1 to 70% by mass in the constituents other than the solvent. The content of the compound capable of generating a base by external energy is preferably from 1 to 80% by mass in the constituents other than the solvent. However, the amount of the compound is not limited in this range and can be appropriately selected depending on the molecular weight of the compound, the amount of the generated acid or base, the material and thickness of the conductive layer to be removed, heating temperature and heating time.

Specific examples of the solvent used in the removing agent include acetic acid esters such as ethyl acetate and butyl acetate; ketones such as acetone, acetophenone, ethyl methyl ketone, and methyl isobutyl ketone; aromatic hydrocarbons such as toluene, xylene, and benzyl alcohol; alcohols such as methanol, ethanol, 1,2-propanediol, terpineol, acetyl terpineol, butyl carbitol, ethyl cellosolve, ethylene glycol, triethylene glycol, tetraethylene glycol, and glycerol; ethylene glycol monoalkyl ethers such as triethylene glycol monobutyl ether; ethylene glycol dialkyl ethers; diethylene glycol monoalkyl ether acetates; ethylene glycol monoaryl ethers; polyethylene glycol monoaryl ethers; propylene glycol monoalkyl ethers; dipropylene glycol dialkyl ethers; propylene glycol monoalkyl ether acetates; ethylene carbonate, propylene carbonate, γ-butyrolactone, solvent naphtha, water, N-methylpyrrolidone, dimethyl sulfoxide, hexamethylphosphoric triamide, dimethylethyleneurea, N,N'-dimethylpropyleneurea, tetramethylurea, etc. Two or more of these solvents can also be used in combination as a mixture.

The content of the solvent is preferably 1% by mass or more in the removing agent, more preferably 30% by mass or more, and still more preferably 50% by mass or more. The content of the solvent of 1% by mass or more enables an improvement in the flowability of the removing agent, leading to enhanced coating properties. The content of the solvent is preferably 99.9% by mass or less, and more preferably 95% by mass or less. The content of the solvent of 99.9% by mass or less enables the flowability at the time of heating to keep in an adequate range, and thus maintaining a desired pattern precisely.

The removing agent preferably contains a resin. Inclusion of the resin can impart non-Newtonian flowability to the removing agent, leading to easy coating on the conductive laminate by a publicly known method. Further, the flowability of the removing agent at the time of heat treatment can be suppressed to enhance the accuracy of coating position. Examples of the resin, which can be used for this purpose, include a polystyrene resin, a polyacrylic resin, a polyamide resin, a polyimide resin, a polymethacrylic resin, a melamine resin, a urethane resin, a benzoguanamine resin, a phenol resin, a silicone resin, a fluorine resin and the like. Two or more of these resins can also be contained. Inclusion of a nonionic, anionic, amphoteric, cationic or other hydrophilic resin enables easy washing with water, or an aqueous basic solution, or an aqueous organic solvent solution, leading to reduction of the residue on the removed surface. Examples of the hydrophilic resin include polyvinyl pyrrolidone, hydrophilic polyurethane, polyvinyl alcohol, polyethyl oxazoline, polyacrylic acid, gelatin, hydroxyalkyl guar, guar gum, locust bean gum, carrageenan, alginic acid, gum arabic, pectin, xanthan gum, cellulose, ethyl cellulose, hydroxypropyl cellulose, carboxymethyl cellulose, carboxymethyl-hydroxyethyl cellulose sodium, acrylamide copolymer, polyethyleneimine, polyamine sulfonium, polyvinylpyridine, polydialkylaminoethyl methacrylate, polydialkylaminoethyl acrylate, polydialkylaminoethyl methacrylamide, polydialkylaminoethyl acrylamide, polyepoxyamine, polyamidoamine, dicyanediamide-formalin condensation product, polydimethyldiallylammonium chloride, polyaminepolyamide epichlorohydrin, polyvinylamine and polyacrylamine, and modification products thereof and the like. Of these resins, a cationic resin is not easily modified even in the presence of an acid or even under a high temperature condition, and exhibits high solubility in a polar solvent. Because of having high solubility, the cationic resin enables the removal of the conductive layer within a short time in the step of removing by washing with a liquid after a heat treatment. Examples of the cationic resin include polydialkylaminoethyl methacrylate, polydialkylaminoethyl acrylate, polydialkylaminoethyl methacrylamide, polydialkylaminoethyl acrylamide, polyepoxyamine, polyamideamine, dicyanediamide-formalin condensation product, polydimethyldiallylammonium chloride, guar hydroxypropyl trimonium chloride, polyaminepolyamide epichlorohydrin, polyvinylamine, polyallylamine, polyacrylamide, polyquaternium-4, polyquaternium-6, polyquaternium-7, polyquaternium-9, polyquaternium-10, polyquaternium-11, polyquaternium-16, polyquaternium-28, polyquaternium-32, polyquaternium-37, polyquaternium-39, polyquaternium-51, polyquaternium-52, pblyquaternium-44, polyquaternium-46, polyquaternium-55 and polyquaternium-68, modification products thereof and the like. For example, polyquaternium-10 has trimethylammonium groups at the ends of side chains. Under an acidic condition, the trimethylammonium groups are cationized, and due to the action of electrostatic repellence, high solubility is shown. The dehydration polycondensation by heating is less likely to occur, and even after heating, high solvent solubility is maintained. For this reason, in the step of removing the conductive layer by washing with a liquid, the conductive layer can be removed within a short time, preferably.

In case where a resin is used in the removing agent, the content of the resin is preferably from 0.01 to 80% by mass in the constituents other than the solvent. In order to keep low the heating temperature required for removing the conductive layer and to shorten the heating time, the resin content in the removing agent is more preferably as small as possible within the range for maintaining non-Newtonian flowability.

The viscosity of the removing agent is preferably from about 2 to 500 Pa·S at 25°C and control of the viscosity within the above range enables easy formation of a uniform coating film by a screen printing method. The viscosity of the removing agent can be adjusted, for example, by the contents of the solvent and the resin.

The leveling agent used in the removing agent is preferably a compound with a nature of lowering the surface tension of the removing agent to less than 50 mN/m. In the present invention, even a polymer compound is classified as the leveling agent even if it is a compound with a nature of lowering the surface tension to less than 50 mN/m. Examples of the leveling agent include acrylic compounds and acrylic resins, such as modified polyacrylates; vinyl-based compounds and vinyl-based resins having double bonds in the molecular skeleton; silicone-based compounds and silicone-based resins having alkyloxysilyl groups and/or polysiloxane skeleton; fluorine-based compounds and fluorine-based resins having fluorinated alkyl groups and/or fluorinated phenyl groups and the like. Any of these leveling agents can be selectively used, as appropriate, depending on the material and polar state of the protective layer surface. It is possible to use fluorine-based compounds and fluorine-based resins having fluorinated alkyl groups and/or fluorinated phenyl groups, particularly preferably, because of having strong capability of reducing a surface tension.

In the removing agent, the content of the leveling agent is preferably from 0.001 to 10% by mass, more preferably from 0.01 to 5% by mass, and still more preferably from 0.05 to 3% by mass, in the constituents other than the solvent in view of surface activities such as wettability to the conductive laminate and leveling property, and the balance with the acid content of the obtained coating film.

In case where an acid with a boiling point of 80°C or higher or a compound capable of generating an acid by external energy is contained, it is preferred that a nitrate or nitrite is further contained. In the reaction between the acid and the conductive component, the reaction rate may sometime vary depending on the acid and the conductive component used. If a nitrate or nitride is contained, the acid and the nitrate or nitrite react with each other at the time of a heat treatment to produce nitric acid in the system. Therefore, the dissolution of the conductive component can be further accelerated. For this reason, the conductive layer can be removed by the heat treatment within a short time. Examples of the nitrate include lithium nitrate, sodium nitrate, potassium nitrate, calcium nitrate, ammonium nitrate, magnesium nitrate, barium nitrate, and hydrates of those nitrates. Examples of the nitrite include sodium nitrite, potassium nitrite, calcium nitrite, silver nitrite, barium nitrite and the like. Two or more of these nitrates can also be contained. Of these nitrates, considering the reaction rate for formation of nitric acid, the nitrate is preferably a nitrate, and more preferably sodium nitrate or potassium nitrate film.

According to the purposes, the removing agent may contain additives, for example, inorganic fine particles of titanium oxide, alumina, silica and the like; thixotropic agents capable of imparting thixotropy; antistatic agents; defoaming agents; viscosity adjusting agents; light-resistant stabilizers; anti-weathering agent; heat-resistant agents; anti-oxidants; rust preventives; slipping agents; waxes; releasing agents; compatibilizing agents; dispersing agents; dispersion stabilizers; rheology control agents and the like.

The method for producing the removing agent will be described below with reference to an example. At first, a resin is added to a solvent and dissolved by well stirring. Then, a compound selected from an acid with a boiling point of 80 °C or higher, a base with a boiling point of 80°C or higher and a compound capable of generating an acid by external energy, a leveling followed by stirring. There is no particular limitation on the addition method and addition order. Stirring in each stage can be performed with heating, and is preferably performed at 50 to 80°C for the purpose of raising the dissolution rates.

The touch panel of the present invention will be described below. The touch panel of the present invention is mounted with a single or multiple conductive laminate(s) of the present invention, and may also be mounted with a combination of other members. Examples of the touch panel of the present invention include a resistance film touch panel, capacitance touch panel and the like. In the touch panel of the present invention, as shown in Fig. 3, multiple conductive laminates 14, each conductive layer of which is patterned, are bonded via bonding layers 19 of an adhesive, a tackifier or the like, followed by lamination. Furthermore, on one surface of the laminate, a substrate on the screen side of a touch panel 20, and a hard coating layer 21 laminated on a surface of the substrate 20 are laminated. The touch panel having lead wires and a drive unit attached thereto is assembled at the front surface of a liquid crystal display, when used.

### [Examples]

The present invention will be specifically described below by way of examples, but the present invention is not limited thereto. First, the evaluation methods used in the examples and comparative examples will be described nitrate film.

### (1) Surface Resistance Value R₀.

The surface resistance value was measured at the central portion of a sample measuring 100 mm × 50 mm by an eddy current method using a non-contact resistivity meter (NC-10 manufactured by NAPSON Corporation). In case where the surface resistance value could not be obtained due to excess of detection limit, the following method was used for measurement.

A high resistivity meter (Hiresta-UPMCP-HT450 manufactured by Mitsubishi Chemical Corporation) was used to measure at the central portion of a sample measuring 100 mm × 100 mm according to a double ring method by connecting a ring probe (URS probe, MCP-HTP14 manufactured by Mitsubishi Chemical Corporation).

In any method, the average value of five samples was calculated and employed as the surface resistance value R₀ [Ω/□].

### (2) Observation of Configuration of Laminate

The nearby region including the portion to be observed of a sample was encapsulated with ice and frozen and secured, or encapsulated with a material stronger in securing force than ice such as an epoxy resin and then cut in the direction perpendicular to the film surface using a rotary microtome (manufactured by Nihon Microtome Kenkyusho K.K.) having a diamond knife set at a knife inclination angle of 3°. Subsequently, the obtained cross section of the film was observed using a field emission scanning electron microscope (JSM-6700-F manufactured by JEOL Ltd.) at an accelerating voltage of 3.0 kV. The observation magnification was selected from a range from 2,500 to 200,000 times such that the thickness of the laminate accounts for 50 to 90% of the length in a longitudinal direction of a display, and then observation was performed by appropriately adjusting contrast of the image.

### (3) Identification of Types of Functional Groups and Structures contained in Crosslinked Layer

First, it was specified by the method (1) or (2) which side is the crosslinked layer side of the conductive laminate. Then, the crosslinked layer was peeled from a sample and the crosslinked layer was dissolved in a solvent capable of dissolving the crosslinked layer. If necessary, the components contained in the crosslinked layer were separated and refined into individual substances using any general chromatography typified by silica gel column chromatography, gel permeation chromatography, liquid high-performance chromatography and the like, and then subjected to the following qualitative analysis and quantitative analysis. It is also possible to identify the contained elements, structure and binding mode of the compound of the protective layer by the similar method.

Then, if necessary, the substances were concentrated and diluted to prepare samples. First, the components contained in the samples were specified by performing qualitative analysis. First, analysis was performed by using analytical methods of the group (i) in combination and then the components, which could not been detected by the analysis, were analyzed by using analytical methods of the group (ii) in combination. The measuring method of each group was applied in the order of description, and the subsequent measuring method was used in case where detection could not be performed by the previous method. Even in the case of using methods in combination, the measuring method described previously was preferentially used and the method capable of measuring by using lesser combinations was applied:
(i) nuclear magnetic resonance spectroscopy (¹H-NMR, ¹³C-NMR, ²⁹Si-NMR, ¹⁹F-NMR), two-dimensional nuclear magnetic resonance spectrometry (2D-NMR), infrared spectrometry (IR), Raman spectrometry, various mass spectrometries (gas chromatography-mass spectrometry (GC-MS), pyrolysis gas chromatography-mass spectrometry (Py-GC-MS), matrix assisted laser desorption/ionization-mass spectrometry (MALDI-MS), time-of-flight mass spectrometry (TOF-MS), matrix-assisted laser desorption-ionization time-of-flight mass spectrometry (MALDI-TOF-MS), dynamic secondary ion mass spectrometry (Dynamic-SIMS), time-of-flight secondary ion mass spectrometer (TOF-SIMS), and other static secondary-ion mass spectrometry (Static SIMS)); and
(ii) X-ray diffractometry (XRD), neutron diffractometry (ND), low energy electron diffraction (LEED), reflection high energy electron diffraction (RHEED), atomic absorption spectrometry (AAS), ultraviolet photoelectron spectrometry (UPS), auger electron spectrometry (AES), X-ray photoelectron spectrometry (XPS), X-ray fluorescence (XRF) spectrometry, inductively coupled plasma atomic emission spectrometry (ICP-AES), electron probe micro-analyzer (EPMA), particle induced X-ray emission (PIXE), low-energy ion scattering spectroscopy (RBS or LEIS), medium energy ion scattering (MEIS), high energy ion scattering (ISS or HEIS), gel permeation chromatography (GPC), transmission electron microscope-energy dispersive x-ray spectrometry (TEM-EDX), scanning electron microscope-energy dispersive X-ray spectrometry (SEM-EDX), gas chromatography (GC), and other elemental analyses.

### (4) Measurement of Mass Content of Crosslinked Unit Structure

After carrying out the method (3), given portion of a peeled or separated substance of the obtained crosslinked layer was isolated and the mass was measured to give a measurement sample. Then, 1,1,2,2-tetrabromoethane (hereinafter abbreviated to TBE) with the mass measured in advance was appropriately diluted with deuterated chloroform to prepare an internal standard solution having a known concentration. To the isolated sample, the TBE internal standard solution was added and the obtained test solution was measured using ¹H-NMR. The amount of the carbon-carbon double bond group was calculated from an area ratio between a peak area of a peak derived from hydrogen (proton, H) of the carbon-carbon double bond group moiety of functional groups including the carbon-carbon double bond group, and a peak area corresponding to hydrogen (proton, H) of TBE added as an internal standard substance in the obtained ¹H-NMR spectrum, the mass of the sample measured in advance, and the concentration of the TBE internal standard solution. By a comparison between the obtained amount of the carbon-carbon double bond group, and the other structure in the measurement sample calculated in the same manner, the mass content of the unit structure portion of the carbon-carbon double bond group to the total mass of the measurement sample was calculated. As used herein, the carbon-carbon double bond group also includes a group derived from the carbon-carbon double bond group having a structure changed into the other structure as a result of a reaction.

### (5) Thickness of Crosslinked Layer

First, it was specified by the method (1) or (2) which side is the crosslinked layer side of the conductive laminate. In the same manner as in (2), the conductive laminate was cut in a direction perpendicular to the film plane. Using a field emission scanning electron microscope (JSM-6700-F manufactured by JEOL Ltd.), the portion of the crosslinked layer of the obtained cross section was observed at an accelerating voltage of 3.0 kV at respective observation magnifications of 10,000 to 100,000 times by appropriately adjusting the image contrast. At fifteen positions of a boundary divided into sixteen equal parts in the direction perpendicular to the thickness, the thickness of the crosslinked layer was measured from the obtained cross-sectional photograph to determine the average value. Upon the measurement, magnification capable of ensuring three significant digits was selected and the value was determined by rounding the 4th digit upon calculation.

### (6) Discrimination of Linear Structures (Structure of Conductive Component), Network State of Linear Structures

First, it was specified by the method (1) or (2) which side is the crosslinked layer side of the conductive laminate. Using a scanning electron microscope (Hitachi Scanning Transmission Electron Microscope HD-2700 manufactured by Hitachi High-Technologies Corporation), a surface of the conductive layer side of the sample was observed.

In case where observation was difficult by the above-mentioned method, observation was performed by using a field emission scanning electron microscope (JSM-6700-F manufactured by JEOL Ltd.) at an accelerating voltage of 3.0 kV at respective observation magnifications of 10,000 to 200,000 times by appropriately adjusting the image contrast.

In case where observation was still difficult by the above-mentioned method, the surface was observed at the same positions of the protective layer side using a color 3D laser microscope (VK-9710 manufactured by Keyence Corporation) by changing the magnification using accessory standard objective lenses 10X (CF IC EPI Plan 10X manufactured by Nikon Corporation), 20X (CF IC EPI Plan 20X manufactured by Nikon Corporation), 50X (CF IC EPI Plan Apo 50X manufactured by Nikon Corporation), and 150X (CF IC EPI Plan Apo 150XA manufactured by Nikon Corporation). Then, the image data were image-analyzed using an observation application (VK-HV1 manufactured by Keyence Corporation), followed by confirmation.

In case where observation was still difficult, an atomic force microscope (Nanoscope III manufactured by Digital Instruments) was used for observation using silicon monocrystal as the cantilever in the tapping mode as the scanning mode at a temperature of 25°C and at a relative humidity of 65% RH.

### (7) Average Thickness t of Protective Layer

First, it was specified by the method (1) or (2) which side is the crosslinked layer side of the conductive laminate. In the same manner as in (2), the conductive laminate was cut in a direction perpendicular to the film plane. Using a field emission scanning electron microscope (JSM-6700-F manufactured by JEOL Ltd.), the portion of the protective layer of the obtained cross section was observed at an accelerating voltage of 3.0 kV at an observation magnification of 10, 000 to 100, 000 times by appropriately adjusting the image contrast. From each obtained photograph of the cross section, given five places each of 23 (the thickness of the protective layer in a portion where the linear structures do not exist: the above-mentioned thick portion of the protective layer) and 24 (the thickness of the protective layer laminated on the top of a single linear structure) or 25 (the thickness of the top of an aggregate consisting of linear structures: the above-mentioned thin portion of the protective layer) respectively shown in Fig. 4 are measured (calculated from the magnifications), and the values were averaged to obtain the average thickness. Upon the measurement, magnification capable of ensuring three significant digits was selected and the value was determined by rounding the 4th digit upon calculation.

### (8) Observation of Diameter (r) of Linear Structures and Average Thickness (t) of Protective Layer

Using a field emission scanning electron microscope (JSM-6700-F manufactured by JEOL Ltd.), a cross section or surface of the protective layer side as in (7) was observed by appropriately adjusting the image contrast between the portions of linear structures and the portions where the linear structures were not laminated. With regard to the relative magnitude between (r) and (t), in the case of cross section observation, the diameter (r) of the linear structure (s) was decided and compared with the (t) obtained in (7).

### (9) Evaluation of Durability against Heat (before Patterning)

Using a turbidity meter (cloudiness meter) NDH2000 (manufactured by Nippon Denshoku Industries Co., Ltd.), the haze value in the thickness direction of a conductive laminate according to JIS K 7361-1 (1997) was measured by allowing light to fall on the conductive layer side (protective layer side). The average value was calculated from the measured values of five samples and employed as the initial haze Hz₀. All five samples were heated at 130°C for 30 minutes in a thermostatic safety oven with a safety door (SPHH-201 manufactured by ESPEC Corp.). After heating, the haze value of five samples was measured likewise as in the case before heating by allowing light to fall on the conductive layer side (protective layer side). The average value was calculated from the measured values of five samples and employed as the haze Hz after heating. The case where a ratio Hz/Hz₀ of the initial haze Hzo to the haze Hz after heating, as a change in haze before and after heating, is 1.20 or less, the sample was accepted, whereas, in case where the ratio Hz/Hz₀ is more than 1.20, the sample was rejected. Lower ratio Hz/Hz₀ means less generation of an oligomer and higher durability against heat. The sample having most satisfactory durability exhibits no change in haze before and after heating, namely, Hz/Hz₀ is 1.0. To the contrary, higher ratio Hz/Hz₀ means lower durability against heat.

### (10) Evaluation of Durability against Heat (after Patterning)

(i) A conductive laminate including a patterned conductive layer was obtained in the following manner. The below-mentioned removing agent was prepared and screen-printed on a conductive laminate using a SUS#500-mesh screen in such a manner that the film thickness of the removing agent after drying might be 2.4 µm. The printed pattern was a straight line with a line length of 5 cm and line width of 500 µm. After coating with the removing agent, the printed conductive laminate was placed in an infrared oven and heat-treated at 130°C for 3 minutes. It was taken out of the oven and allowed to cool to room temperature, and then the deposited removing agent and decomposition product were removed by washing with pure water of 25°C for 1 minute. The above-mentioned substrate was drained by compressed air and dried in an infrared oven at 80°C for 1 minute to obtain a conductive laminate including the patterned conductive layer.
(ii) The conductive laminate including the patterned conductive layer was heated at 130°C for 30 minutes in a thermostatic safety oven (SPHH-201 manufactured by ESPEC Corp.), and the surface of the patterned portions was observed by an optical microscope (ECLIPSE-L200 manufactured by Nikon Corporation) before and after heating, followed by observation whether or not the oligomer was generated on the surface of the patterned portions. The generation of the oligomer was determined in reference to whether or not the speckles or a speckle pattern which had not existed before heating existed after heating. In case where the oligomer could not be observed using the above-mentioned optical microscope, the surface was observed likewise using a scanning electron microscope ABT-32 manufactured by TOPCON Corporation to confirm whether or not the oligomer was generated. In case where the generation of the oligomer was not observed at ten given points, the conductive laminate was also accepted.

### (11) Evaluation of Electrical Insulation Properties of Patterned Portions

The 1 cm portions from both the ends of each straight line length were cut off from the conductive laminate having the conductive layer patterned in (10), and a conductive laminate measuring 3 cm × 10 cmpartitionedby straight line patterns (etching lines) at the center was obtained. The probes of an insulation resistance tester (EA709DA-1 manufactured by Sanwa Denki Keiki K.K.) were applied to the right side and left side of an etching line. In case where a resistance of 10 MΩ or more was indicated with DC 25 V applied, the conductive laminate was accepted, whereas, in case where a resistance of less than 10 MΩ was indicated, the conductive laminate was rejected.

### (12) Whether or not Conductive Component remained in Patterned Portions

The patterned portions of the conductive laminate including the patterned conductive layer in (10) were observed by the same method as in (7) or (8) or by a scanning transmission electron microscope (Hitachi Scanning Transmission Electron Microscope HD-2700 manufactured by Hitachi High-Technologies Corporation). In case where the conductive component determined in (6) could not be confirmed, the conductive laminate (the conductive component did not remain) was accepted, whereas, in case where the same could be confirmed (the conductive component remained), the conductive laminate was rejected.

### (13) Difference between Maximum Absorption Wavelengths of Photo-Initiators

The individual constituents of the protective layer were separated and refined by any of the methods in (3), and among the respective constituents, only the compounds corresponding to photo-initiators were extracted. In case where whether or not the constituents corresponded to photo-initiators was unknown, they were irradiated with an active electron beam, and the constituents that generated any one species of radical species, cationic species and anionic species were identified as photo-initiators. Then, each of the photo-initiators was dissolved into any of various soluble solvents. Subsequently, the solution was placed in a quartz cell, and the absorption spectrum in a wavelength range from 200 to 900 nm was measured at an optical path length of 1 cm using a ultraviolet-visible spectrometer (UV-Bis Spectrophotometer V-660 manufactured by JASCO Corporation) to obtain the maximum absorption wavelength.

For each photo-initiator, the absorption spectrum was measured three times likewise to obtain maximum absorption wavelengths, and the average value was employed as the maximum absorption wavelength of the photo-initiator. The difference between the maximum absorption wavelengths of the respective photo-initiators was obtained.

In case where there are multiple maximum values, the maximum absorption wavelength should be decided as mentioned below. Of the multiple maximum values existing in a range from 200 to 400 nm in the absorption spectrum, the wavelength at the maximum value corresponding to the largest absorbance was employed as the maximum absorbance wavelength. In this case, if the concentration of the photo-initiator is too high when it is dissolved in a solvent, the above-mentioned maximum value corresponding to the largest absorbance exceeds the detection limit of the instrument used, and it may be observed as if the above-mentioned maximum value corresponding to the largest absorbance does not exist. Therefore, the concentration of the photo-initiator should be changed as appropriate for measurement, and the wavelength at the maximum value corresponding to the relatively largest absorption at each concentration should be employed as the maximum absorption wavelength.

### (14) Measurement of Total Light Transmittance

Using a turbidity meter (cloudiness meter) NDH2000 (manufactured by Nippon Denshoku Industries Co. , Ltd.), the total light transmittance in the thickness direction of a conductive laminate according to JIS K 7361-1 (1997) was measured by allowing light to fall on the conductive layer side. The average value was calculated from the measured values of five samples and employed as the total light transmittance.

### (15) Measurement of Friction Coefficient between CrosslinkedLayer Side and Protective Layer Side

In accordance with JIS C2151 (2006), a friction coefficient was evaluated by applying 200 g of a load in a state where the crosslinked layer side and the protective layer side of two conductive laminates are brought into contact with each other. A static friction coefficient and a dynamic friction coefficient of ten samples were determined, and the average values were calculated from the measured values of ten samples and employed as the static friction coefficient and the dynamic friction coefficient.

### (16) Measurement of Surface Rub Fastness

In accordance with JIS L0849 (2004), surfaces of the crosslinked layer and the protective layer of a conductive laminate were subjected to reciprocating friction for 50 times using an attached white cotton cloth (Kanakin No. 3) for test. Then, two positions of given 2 cm square of a friction surface was selected, and scratches in the direction parallel to the friction direction (within ±10° to a friction direction) were visually observed and the number of scratches of 0.5 mm or more in length was counted while each position is irradiated by a fluorescent lamp from a 10° direction to the friction surface. Evaluation was performed by five samples and the average value at ten points in total was determined as an integer by rounding up to the first decimal digit, and employed as the number of scratches in the direction parallel to the friction direction (hereinafter simply referred to as number of scratches). Evaluation criteria in the present invention are based on classification into the following three ranks. The conductive laminates rated classes A and B were accepted.
Class A: Number of scratches is 2 or less.
Class B: Number of scratches is 3 or more and 10 or less.
Class C: Number of scratches is 11 or more.

### (17) Measurement of Color Tone b* Value of Transmitted Light (Light Source C)

In accordance with JIS Z8729 (2004), a light transmittance was measured by allowing light emitted from a light source C to fall on the conductive layer side of a conductive laminate using a spectrophotometer (UV-3150 manufactured by Shimadzu Corporation). Using a light source C in a visual field of 2 degrees, a light transmittance spectrum at 380 to 780 nm was measured at intervals of 1 nm, and then a color tone b* value of transmitted light was measured from the calculation results of transmission chromaticity in an XYZ '(CIE1976) color system. The measurement was performed by five samples and the average value of color tone b* values of transmitted light of five samples was employed as the color tone b* value of transmitted light (light source C).

The materials used in the respective Examples and Comparative Examples are shown below.

### [Protective Layer]

### (1) Protective Layer Material A

- Straight chain methacrylic resin (Phoret GS-1000, solid component concentration: 30% by mass, manufactured by Soken Chemical & Engineering Co., Ltd.) which does not contain any of S element, P element, metal element, metal ion, and N element constituting a functional group, and is not capable of forming a crosslinked structure

### (2) Protective Layer Material B

- Polyfunctional acrylic resin composition (Fulcure HC-6, solid component concentration: 51% by mass, manufactured by Soken Chemical & Engineering Co., Ltd.) which does not contain any of S element, P element, metal element, metal ion, and N element constituting a functional group, and is capable of forming a crosslinked structure by a photo-initiator

### (3) Protective Layer Material C

- Polyfunctional acrylic resin composition (Fulcure UAF-1, solid component concentration: 48.4% by mass, manufactured by Soken Chemical & Engineering Co., Ltd.) which does not contain any of S element, P element, metal element, metal ion, and N element constituting a functional group, and contains fluorine element, and is capable of forming a crosslinked structure by a photo-initiator

### (4) Protective Layer Material D

- Polyfunctional acrylic/urethane acrylate mixed composition (Pholucid No. 420C, solid component concentration: 50% by mass, manufactured by Chugoku Marine Paints, Ltd.) which does not contain any of S element, P element, metal element, metal ion, and N element constituting a functional group, and contains N element in the skeleton structure, and is capable of forming a crosslinked structure by a photo-initiator

### (5) Protective Layer Material E

- Polyfunctional urethane acrylate resin composition (Artresin UN-904M, solid component concentration: 80% by mass, manufactured by Negami Chemical Industrial Co., Ltd.) which does not contain any of S element, P element, metal element, metal ion, and N element constituting a functional group, and contains N element in the skeleton structure, and is capable of forming a crosslinked structure by a photo-initiator

### (6) Protective Layer Material F

- Polyfunctional acrylic/ methacrylate-based mixed composition (Fulcure HCE-022, solid component concentration: 52.1% by mass, manufactured by Soken Chemical & Engineering Co., Ltd.) which contains N element constituting a functional group, and is capable of forming a crosslinked structure by a photo-initiator

### (7) Protective Layer Material G

- Straight chain acrylic resin (solid component concentration: 100% by mass) which contains S element, and is not capable of forming a crosslinked structure), obtained by copolymerizing acrylamide t-butyl sulfonic acid (another name: 2-acrylamide-2-methyl propane sulfonic acid) and methylmethacrylate (MMA) (anothername: methyl 2-methyl-2-propenoate)

### (8) Protective Layer Material H

- Straight chain acrylic resin (solid component concentration: 100% by mass) which contains S element and metal ion, and is not capable of forming a crosslinked structure), obtained by polymerizing acrylamide t-butylsulfonic acid sodium salt (another name: 2-acrylamide-2-methyl propane sulfonic acid sodium salt) and methyl methacrylate (MMA) (another name: methyl 2-methyl-2-propenoate)

### (9) Protective Layer Material I

- Composition (solid component concentration 40% by mass) which contains P element, and contains a polyfunctional acrylic resin capable of forming a crosslinked structure by a photo-initiator, and the following additive A, obtained by the method disclosed in Example 1 of Japanese Unexamined Patent Publication (Kokai) No. 2008-222848

### [Additives]

### (10) Additives A

- Photopolymerization initiator having a maximum absorption wavelength of 240 nm (Ciba (registered trademark) IRGACURE (registered trademark) 184 manufactured by Ciba Japan K.K.)

### (11) Additive B

- Photopolymerization initiator having a maximum absorption wavelength of 300 nm (Ciba (registered trademark) IRGACURE (registered trademark) 907 manufactured by Ciba Japan K.K.)

### (12) Additive C

- Photopolymerization initiator having a maximum absorption wavelength of 320 nm (Ciba (registered trademark) IRGACURE (registered trademark) 369 manufactured by Ciba Japan K.K.)

### (13) Additive D

- Photopolymerization initiator having a maximum absorption wavelength of 250 nm (Ciba (registered trademark) IRGACURE (registered trademark) 651 manufactured by Ciba Japan K.K.)

### [Conductive Layer]

### (1) Conductive layer A "Needle-Like Silicon Dioxide-based ATO (Antimony-Doped Tin Oxide) Composite Compound Conductive Layer"

The above-mentioned protective layer material A (acrylic resin) as the binder component and needle-like silicon dioxide-based ATO (antimony-doped tin oxide) composite compound (Dentol (registered trademark) TM100, minor axis length: 700 to 900 nm, major axis length: 15 to 25 µm, manufactured by Otsuka Chemical Co., Ltd.) as the conductive component were mixed to achieve of a conductive component content of 60% by mass based on the entire solid content (mixing ratio of solid contents: binder component/conductive component = 40% by mass/60% by mass), and ethyl acetate was added to the mixed solution to achieve a solid paint concentration of 50% by mass, for dilution and concentration adjustment, thereby obtaining a needle-like silicon dioxide-based ATO (antimony-doped tin oxide) composite compound-dispersed coating solution. A substrate was coated with the needle-like silicon dioxide-based ATO (antimony-doped tin oxide) composite compound-dispersed coating solution using a slit die coater mounted with shims made of SUS (thickness of shims: 100 µm), and dried at 120°C for 5 minutes to form a needle-like silicon dioxide-based ATO (antimony-doped tin oxide) composite compound coating film.

### (2) Conductive layer B "Silver Nanowire Conductive Layer"

Silver nanowires (minor axis length: 50 to 100 nm, major axis length: 20 to 40 µm) were obtained by the method disclosed in Japanese Translation of PCT International Application Publication No. 2009-505358 (Example 1 Synthesis of Silver Nanowires). Then, a silver nanowire-dispersed coating solution was obtained by the method disclosed in the same Japanese Translation of PCT International Application Publication No. 2009-505358 (Example 8 Dispersion of Nanowires). The silver nanowires-dispersed coating solution was adjusted in the concentration to achieve a silver nanowire content of 0.04% by mass based on the amount of the entire coating solution. A substrate was coated with the concentration-adjusted silver nanowire-dispersed coating solution using a slit die coater mounted with shims made of SUS (thickness of shims: 50 µm), and dried at 120°C for 2 minutes to form a silver nanowire coating film.

### (3) Conductive layer C "CNT Conductive Layer"

### (Preparation of Catalyst)

Ammonium iron citrate (green) (manufactured by Wako Pure Chemical Industries, Ltd.) (2,459 g) was dissolved into 500 mL of methanol (manufactured by Kanto Chemical Co., Inc.). To the solution, 100 g of light magnesia (manufactured by Iwatani Chemical Industry Co., Ltd.) was added, and the mixture was stirred at room temperature for 60 minutes. While stirring at 40°C to 60°C, the mixture was dried under reduced pressure to remove methanol, and thus obtaining a catalyst in which the metal salt was supported on light magnesia fine-particle powder.

### (Production of CNT Composition)

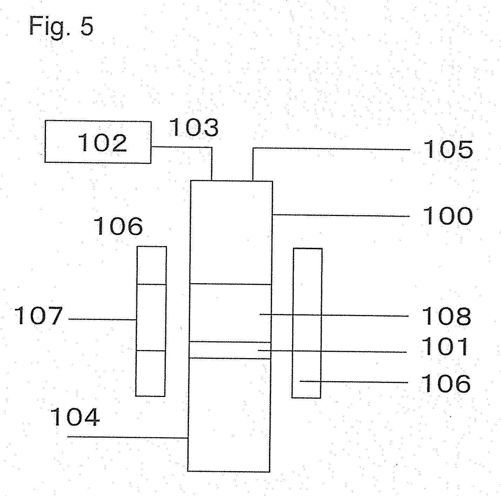

In a fluidized bed vertical reaction device shown in the schematic view of Fig. 5, CNTs were synthesized. The reactor (100) was a cylindrical quartz pipe with an inner diameter of 32 mm and a length of 1,200 mm. In the reactor (100), a sintered quartz plate (101) was provided at the central portion, and an inert gas and raw gas supply line (104) were provided below in the quartz pipe, while above in the quartz pipe, an exhaust gas line (105) and a catalyst introduction line (103) were provided. Further, in order that the reactor could be kept at a given temperature, a heater (106) was provided to surround the circumference of the reactor. The heater (106) was provided with an inspection port (107) so that the fluidized state in the device could be confirmed.

Twelve (12) grams of the above-mentioned catalyst (108) was set on the sintered quartz plate (101) via a catalyst introduction line (103) from an enclosed catalyst supply unit (102). Then, an argon gas began to be supplied via the raw gas supply line (104) at 1, 000 mL/min. After the reactor was filled with argon gas atmosphere, the temperature was heated to 850°C.

After reaching 850°C, the temperature in the reactor was maintained and the argon flow rate of the raw gas supply line (104) was raised to 2,000 mL/min to initiate the fluidization of the catalyst (108) on the sintered quartz plate. After the fluidization was confirmed from the heating furnace inspection port (107), the supply of methane into the reactor at 95 mL/min was further started. After the mixed gas was supplied for 90 minutes, the argon gas supplied from the raw material gas supply line (104) only was supplied to complete the synthesis.

Heating was stopped, and the reaction mixture was allowed to stand till the temperature reached room temperature, and after room temperature was reached, the CNT composition containing the catalyst and the CNTs was taken out of the reactor.

Twenty three point four (23.4) grams of the above-mentioned catalyst-containing CNT composition was placed on a porcelain dish and heated at 446° C for 2 hours in air in a muffle furnace (FP41 manufactured by Yamato Scientific Co., Ltd.) heated in advance to 446°C, and subsequently taken out of the muffle furnace. Then, in order to remove the catalyst, the CNT composition was added to an aqueous 6N hydrochloric acid solution and the mixture was stirred at room temperature for 1 hour. The mixture was filtered and the obtained residue was further added to the aqueous 6N hydrochloric acid solution, followed by stirring at room temperature for 1 hour. After filtration, the residue was washed several times with water, and then dried in an oven of 120 °C overnight to obtain 57.1 mg of the CNT composition free from magnesia and metal. By repeating the above-mentioned operation, 500 mg of the CNT composition free from magnesia and metal was prepared.

Then, 80 mg of the CNT composition remaining after removing the catalyst was added to 27 mL of concentrated nitric acid (first grade assay 60-61%, manufactured by Wako Pure Chemical Industries, Ltd.), and the mixture was stirred while being heated in an oil bath of 130 °C for 5 hours. After completion of heating and stirring, the CNT-containing nitric acid solution was filtered, and the residue was washed with distilled water to obtain 1,266.4 mg of a wet CNT composition containing water.

### (CNT-Dispersed Coating Solution)

A 50 mL vessel was charged with 10 mg (as dried) of the above-mentioned CNT composition and 10 mg of carboxymethyl cellulose sodium (90 kDa, 50-200 cps, manufactured by Sigma) as a dispersing agent, and distilled water was added to make 10 g in total. The mixture was treated to be dispersed with ice cooling by an ultrasonic homogenizer at an output of 20 W for 20 minutes, to prepare a solution. The obtained solution was centrifuged by a high speed centrifuge at 10,000 G for 15 minutes to obtain 9 mL of a supernatant solution. This operation was repeatedmultiple times to obtain 145 mL of a supernatant solution. Ethanol (5 mL) was added to the supernatant solution to obtain a CNT-dispersed coating solution with a CNT concentration of about 0.1% by mass capable of being applied by a coater (the mixing ratio of CNTs and the dispersing agent is 1:1). Quartz glass was coated with the CNT-dispersed coating solution and dried, and the refractive index of the CNT conductive layer was 1.82.

### (Formation of CNT Conductive Layer)

A substrate was coated with the above-mentioned CNT-dispersed coating solution by a micro-gravure coater (gravure cell count: 150R, gravure revolution ratio: 80%) and dried at 100°C for 1 minute to form a CNT coating film (minor axis length: 10 to 30 nm, major axis length: 1 to 5 µm as CNT aggregates in the CNT coating film).

### (4) Conductive Layer D "Silver Nanomicroparticles Conductive Layer"

Silver nanowire (minor axis length, major axis length (particle diameter): 9 to 15 nm) -dispersed solution was obtained by the method disclosed in Japanese Unexamined Patent Publication (Kokai) No. 2001-243841 (Example (2) Preparation of Silver Nanocolloid Coating Solution). Then, a silver nanomicroparticle conductive layer was formed by coating with the silver nanomicroparticle-dispersed solution by the method disclosed in the same Japanese Unexamined Patent Publication (Kokai) No. 2001-243841 (Examples 1 to 8).

### (5) Conductive Layer E "Silver Nanowire/Silver Nanomicroparticles Mixed Conductive Layer"

A silver nanomicroparticle dispersion obtained by the method disclosed in Japanese Unexamined Patent Publication (Kokai) No. 2001-243841 (Example (2) Preparation of Silver Nanocolloid Coating Solution) was mixed with a silver nanowire-dispersed coating solution obtained by the method disclosed in Japanese Translation of PCT International Application Publication No. 2009-505358 (Example 8 Nanowire Dispersion) so as to achieve a mass ratio of silver nanomicroparticles to silver nanowire (silver nanomicroparticles/silver nanowire) of 8/2 to obtain a silver nanowire/silver nanomicroparticles mixed dispersion. Then, a substrate was coated with the silver nanowire/silver nanomicroparticles mixed dispersion by the method disclosed in Japanese Unexamined Patent Publication (Kokai) No. 2001-243841 (Examples 1 to 8), followed by drying to form a silver nanowire/silver nanomicroparticles conductive layer.

### (6) Conductive Layer F "ITO (Indium Tin Oxide) Thin Conductive Layer"

An indium tin oxide target with a composition of In₂O₂/SnO₂ = 90/10 was used to form a 250 nm thick ITO (indium tin oxide) thin conductive film on a substrate under the introduction of argon/oxygen-mixed gas at a vacuum degree of 10⁻⁴ Torr by a sputtering method.

### [Crosslinked Layer]

### (1) Crosslinked Layer Material A

- Polystyrene resin having styryl groups as a carbon-carbon double bond group (Styrene, Polymer manufactured by Wako Pure Chemical Industries, Ltd., solid component concentration: 100% by mass, mass content of a crosslinked unit structure = 23% by mass)

### (2) Crosslinked Layer Material B

- Methacrylic resin having methacryloyl groups as a carbon-carbon double bond group (Phoret GS-1000 manufactured by Soken Chemical & Engineering Co., Ltd., solid component concentration: 30% by mass, mass content of a crosslinked unit structure = 24% by mass)

### (3) Crosslinked Layer Material C

- Acrylic composition having acryloyl groups as a carbon-carbon double bond group (EXP8002UV anchoring agent-B manufactured by Matsuichemical Inc., solid component concentration: 40% by mass, mass content of a crosslinked unit structure = 12% by mass)

### (4) Crosslinked Layer Material D

- Methacrylic composition having methacryloyl groups as a carbon-carbon double bond group (LIGHT ESTER TMP manufactured by Kyoeisha Chemical Co., Ltd, solid component concentration: 100% by mass, mass content of a crosslinked unit structure = 20% by mass)

### (5) Crosslinked Layer Material E

- Acrylic composition having acryloyl groups as a carbon-carbon double bond group (Fulcure HC-6 manufactured by Soken Chemical & Engineering Co., Ltd., solid component concentration: 51% by mass, mass content of a crosslinked unit structure = 24% by mass)

### (6) Crosslinked Layer Material F

- Urethane acrylate-based composition having acryloyl groups as a carbon-carbon double bond group (AT-600 manufactured by Kyoeisha Chemical Co., Ltd, solid component concentration: 100% by mass, mass content of a crosslinked unit structure = 9% by mass).

### (7) Crosslinked Layer Material G

- Composition having acryloyl groups as a carbon-carbon double bond group, composed of the following (a) to (d) (mass content of a crosslinked unit structure = 22% by mass):
(a) 77.80 parts by mass of an acrylic composition (Fulcure HC-6 manufactured by Soken Chemical & Engineering Co., Ltd., solid component concentration: 51% by mass),
(b) 6.29 parts by mass of an acrylic/urethane acrylate-based mixed composition (PHOLUCID No. 420C manufactured by Chugoku Marine Paints, Ltd., solid component concentration: 50% by mass),
(c) 2. 07 parts by mass an additive B (Ciba (registered trademark) IRGACURE (registered trademark) 907 manufactured by Ciba Japan K.K.), and
(d) 2. 07 parts by mass of an additive C (Ciba (registered trademark) IRGACURE (registered trademark) 369 manufactured by Ciba Japan K.K.)

### (8) Crosslinked Layer Material H

- Polyfunctional acrylic/methacrylate-based mixed composition having acryloyl groups and methacryloyl groups as a carbon-carbon double bond group (Fulcure HCE-032 manufactured by Soken Chemical & Engineering Co., Ltd., solid component concentration: 51.4% by mass, mass content of a crosslinked unit structure = 26% by mass)

### (9) Crosslinked Layer Material I

- Mixed composition having acryloyl groups as a carbon-carbon double bond group, composed of the following (a) to (e) (content of a blue pigment additive is 0.5% by mass based on the total solid contents of (a) and (b), mass content of a crosslinked unit structure = 22% by mass) :
(a) 77.80 parts by mass of an acrylic composition (Fulcure HC-6 manufactured by Soken Chemical & Engineering Co., Ltd., solid component concentration: 51% by mass)
(b) 6.29 parts by mass of an acrylic/urethane acrylate-based mixed composition (PHOLUCID No. 420C manufactured by Chugoku Marine Paints, Ltd., solid component concentration: 50% by mass),
(c) 2. 07 parts by mass of an additive B (Ciba (registered trademark) IRGACURE (registered trademark) 907 manufactured by Ciba Japan K.K.),
(d) 2. 07 parts by mass of an additive C (Ciba (registered trademark) IRGACURE (registered trademark) 369 manufactured by Ciba Japan K.K.), and
(e) 0.22 part by mass of an anthraquinone-based blue pigment additive (Kayaset Blue A-2R manufactured by Nippon Kayaku Co., Ltd.)

### (10) Crosslinked Layer Material J

- Mixed composition having acryloyl groups as a carbon-carbon double bond group, composed of the following (a) to (d) (content of a slip-imparting additive is 0.3% by mass based on the total solid content of (a), mass content of a crosslinked unit structure = 23% by mass):
(a) 77.80 parts by mass of an acrylic composition (Fulcure HC-6 manufactured by Soken Chemical & Engineering Co., Ltd., solid component concentration: 51% by mass),
(b) 1. 87 parts by mass of an additive B (Ciba (registered trademark) IRGACURE (registered trademark) 907 manufactured by Ciba Japan K.K.),
(c) 1. 87 parts bymass of an additive C (Ciba (registered trademark) IRGACURE (registered trademark) 369 manufactured by Ciba Japan K.K.), and
(d) 0.12 part by mass of a silicone acrylate-based slip-imparting additive (EBECRYL1360, polysiloxane hexaacrylate manufactured by DAICEL-CYTEC Company LTD., solid component concentration: 100% by mass)

### (11) Crosslinked Layer Material K

- Mixed composition having acryloyl groups as a carbon-carbon double bond group, composed of the following (a) to (d) (content of a slip-imparting additive is 1.0% by mass based on the total solid content of (a), mass content of a crosslinked unit structure = 23% by mass):
(a) 77.80 parts by mass of an acrylic composition (Fulcure HC-6 manufactured by Soken Chemical & Engineering Co., Ltd., solid component concentration: 51% by mass),
(b) 1. 87 parts by mass of an additive B (Ciba (registered trademark) IRGACURE (registered trademark) 907 manufactured by Ciba Japan K.K.),
(c) 1. 87 parts by mass of an additive C (Ciba (registered trademark) IRGACURE (registered trademark) 369 manufactured by Ciba Japan K.K.), and
(d) 0.40 part by mass of a silicone acrylate-based slip-imparting additive (EBECRYL1360, polysiloxane hexaacrylate manufactured by DAICEL-CYTEC Company LTD., solid component concentration: 100% by mass)

### (12) Crosslinked Layer Material L

- Mixed composition having acryloyl groups as a carbon-carbon double bond group, composed of the following (a) to (d) (content of a slip-imparting additive is 3.0% by mass based on the total solid content of (a), mass content of a crosslinked unit structure = 23% by mass):
(a) 77.80 parts by mass of an acrylic composition (Fulcure HC-6 manufactured by Soken Chemical & Engineering Co., Ltd., solid component concentration: 51% by mass),
(b) 1. 87 parts bymass of an additive B (Ciba (registered trademark) IRGACURE (registered trademark) 907 manufactured by Ciba Japan K.K.),
(c) 1.87 parts bymass of an additive C (Ciba (registered trademark) IRGACURE (registered trademark) 369 manufactured by Ciba Japan K.K.), and
(d) 1.19 parts by mass of a silicone acrylate-based (polysiloxane hexaacrylate) slip-imparting additive (EBECRYL1360 manufactured by DAICEL-CYTEC Company LTD., solid component concentration: 100% by mass)

### (13) Crosslinked Layer Material M

- Polyester-modified silicone-based (terminal hydroxyl group (hydroxyl group) polyester-modified dimethylpolysiloxane) composition having no carbon-carbon double bond group (X-22-8300 manufactured by Shin-Etsu Chemical Co., Ltd., solid component concentration: 25% by mass, mass content of a crosslinked unit structure = 0% by mass)

### (14) Crosslinked Layer Material N

- Acrylic composition having acryloyl groups as a carbon-carbon double bond group (LIGHT ACRYLATE BP-10EA manufactured by Kyoeisha Chemical Co., Ltd., solid component concentration: 100% by mass, mass content of a crosslinked unit structure = 6% by mass)

### (15) Crosslinked Layer Material O

- Acrylic composition having acryloyl groups as a carbon-carbon double bond group (LIGHT ACRYLATE PE-4A manufactured by Kyoeisha Chemical Co., Ltd., solid component concentration: 100% by mass, mass content of a crosslinked unit structure = 27% by mass)

### (16) Crosslinked Layer Material P

- Mixed composition having acryloyl groups as a carbon-carbon double bond group, composed of the following (a) to (e) (content of blue pigment additive is 0.3% by mass based on the total solid content of (a) and (b), mass content of a crosslinked unit structure = 22% by mass):
(a) 77.80 parts by mass of an acrylic composition (Fulcure HC-6 manufactured by Soken Chemical & Engineering Co., Ltd., solid component concentration: 51% by mass),
(b) 6.29 parts by mass of an acrylic/urethane acrylate-basedmixed composition (PHOLUCID No. 420C manufactured by Chugoku Marine Paints, Ltd., solid component concentration: 50% by mass),
(c) 2. 07 parts by mass of an additive B (Ciba (registered trademark) IRGACURE (registered trademark) 907 manufactured by Ciba Japan K.K.),
(d) 2.07 parts by mass of an additive C (Ciba (registered trademark) IRGACURE (registered trademark) 369 manufactured by Ciba Japan K.K.), and
(e) 0.15 part by mass of a blue pigment additive (Pigment Blue 15:6)

### [Removing Agent]

The method for producing a removing agent (a removing agent containing an acid) will be described below.

A vessel was charged with 70 g of ethylene glycol (manufactured by Wako Pure Chemical Industries, Ltd.), 30 g of N,N'-dimethylpropyleneurea (manufactured by Tokyo Chemical Industry Co., Ltd.) and 5 g of sodium nitrate, followed by mixing. To the mixture, 5 g of polyquaternium-10 (manufactured by ISP Japan) and 0.5 g of THIXATROL MAX (a polyester amide manufactured by Elementis Japan K.K.) as a thixotropic agent were added, followed by stirring in an oil bath while heating to 60°C for 30 minutes.

Then, the vessel was taken out of the oil bath and allowed to cool to room temperature, and then 0.5 g of a leveling agent (F-555 manufactured by DIC K.K.) and 10 g of p-toluenesulfonic acid monohydrate (boiling point under atmospheric pressure: 103 to 106°C, manufactured by Tokyo Chemical Industry Co., Ltd.) were added, followed by stirring for 15 minutes. The obtained solution was filtered by a membrane filter (Omnipore Membrane PTFE, nominal diameter of 0.45 µm, manufactured by Millipore K.K.) to obtain a removing agent.

Examples 1 and 2 do not belong to the present invention but represent Reference Examples.

### (Reference Example 1)

A 125 µm thick polyethylene terephthalate film, LUMIRROR (registered trademark) U48 (manufactured by Toray Industries, Inc.) was used as a substrate. Then, 100 g of the crosslinked layer material A and 1,026 g of benzene were mixed and stirred to prepare a crosslinked layer coating solution. The substrate was coated with the protective layer coating solution using a slit die coater mounted with shims made of SUS (thickness of shims 50 µm), and dried at 120°C for 2 minutes to form a 950 nm thick crosslinked layer.

Then, the conductive layer A was formed on the surface opposite to the crosslinked layer of the substrate in the following manner.

Subsequently, 296 g of the protective layer material A and 704 g of ethyl acetate were mixed and stirred to prepare a protective layer coating solution. The above-mentioned conductive layer A was coated with the protective layer coating solution using a slit die coater mounted with shims made of SUS (thickness of shims 50 µm), and dried at 120°C for 2 minutes to forma 950 nm thick protective layer, and thus obtaining a conductive laminate.

### (Reference Example 2)

A 125 µm thick polyethylene terephthalate film, LUMIRROR (registered trademark) U48 (manufactured by Toray Industries, Inc.) was used as a substrate. Then, 500 g of the crosslinked layer material B and 1, 382 g of ethyl acetate were mixed, followed by stirring to prepare a crosslinked layer coating solution. The substrate was coated with the protective layer coating solution using a slit die coater mounted with shims made of SUS (thickness of shims 50 µm), and dried at 120°C for 2 minutes to form a 850 nm thick crosslinked layer.

Then, the conductive layer A was formed on the surface opposite to the crosslinked layer of the substrate in the following manner.

Subsequently, 500 g of the protective layer material A and 1, 500 g of ethyl acetate were mixed, followed by stirring to prepare a protective layer coating solution. The above-mentioned conductive layer A was coated with the protective layer coating solution using a slit die coater mounted with shims made of SUS (thickness of shims 50 µm), and dried at 120°C for 2 minutes to forma 800 nm thick protective layer, and thus obtaining a conductive laminate.

### (Example 3)

A 125 µm thick polyethylene terephthalate film, LUMIRROR (registered trademark) U48 (manufactured by Toray Industries, Inc.) was used as a substrate. Then, 300 g of the crosslinked layer material C, 764 g of toluene and 764 g of methyl ethyl ketone were mixed and stirred to prepare a crosslinked layer coating solution. The substrate was coated with the protective layer coating solution using a slit die coater mounted with shims made of SUS (thickness of shims 50 µm), dried at 100°C for 2 minutes and then irradiated with ultraviolet light at 1.2 J/cm² for curing to form a 700 nm thick crosslinked layer.

Then, conductive layer B was formed on the surface opposite to the crosslinked layer of the substrate in the following manner.

Subsequently, 150 g of the protective layer material B, 3.60 g of the additive A, 7.15 g of the additive B and 1, 907 g of ethyl acetate were mixed, followed by stirring to prepare a protective layer coating solution. The above-mentioned conductive layer B was coated with the protective layer coating solution using a slit die coater mounted with shims made of SUS (thickness of shims 50 µm), dried at 120°C for 2 minutes and then irradiated with ultraviolet light at 1.2 J/cm² for curing to form a 450 nm thick protective layer, and thus obtaining a conductive laminate of the present invention.

### (Example 4)

In the same manner as in Example 3, except that the composition of the protective layer coating solution was 150 g of the protective layer material B, 3. 60 g of the additive A, 7.15 g of the additive B and 2,288 g of ethyl acetate, a 380 nm thick protective layer was formed to obtain a conductive laminate of the present invention.

### (Example 5)

In the same manner as in Example 3, except that the composition of the protective layer coating solution was 150 g of the protective layer material B, 3. 60 g of the additive A, 7.15 g of the additive B and 2,748 g of ethyl acetate, a 310 nm thick protective layer was formed to obtain a conductive laminate of the present invention.

### (Example 6)

In the same manner as in Example 3, except that the composition of the protective layer coating solution was 150 g of the protective layer material B, 3. 60 g of the additive A, 7.15 g of the additive B and 3,561 g of ethyl acetate, a 250 nm thick protective layer was formed to obtain a conductive laminate of the present invention.

### (Example 7)

In the same manner as in Example 6, except that the composition of the crosslinked layer coating solution was 76.5 g of the crosslinked layer material D, 3.60 g of the additive A, 7.15 g of the additive B, 990 g of toluene and 990 g of ethyl acetate, a 450 nm thick crosslinked layer was formed to obtain a conductive laminate of the present invention.

### (Example 8)

In the same manner as in Example 6, except that the composition of the crosslinked layer coating solution was 78.4 g of the crosslinked layer material E, 1.88 g of the additive B, 1.88 g of the additive C and 1,423 g of ethyl acetate, a 310 nm thick crosslinked layer was formed to obtain a conductive laminate of the present invention.

### (Example 9)

In the same manner as in Example 6, except that the composition of the protective layer coating solution was 40.0 g of the crosslinked layer material F, 1.88 g of the additive B, 1.88 g of the additive C and 1,462 g of ethyl acetate, a 310 nm thick crosslinked layer was formed to obtain a conductive laminate of the present invention.

### (Example 10)

In the same manner as in Example 8, except that the composition of the protective layer coating solution was 150 g of the protective layer material C, 3.41 g of the additive A, 6.79 g of the additive B and 3,373 g of ethyl acetate, a 250 nm thick protective layer was formed to obtain a conductive laminate of the present invention.

### (Example 11)

In the same manner as in Example 8, except that the composition of the protective layer coating solution was 77.80 g of the protective layer material B, 6.29 g of the protective layer material D, 2.07 g of the additive A, 2.07 g of the additive B and 1,916 g of ethyl acetate, a 250 nm thick protective layer was formed to obtain a conductive laminate of the present invention.

### (Example 12)

In the same manner as in Example 8, except that the composition of the protective layer coating solution was 100 g of the protective layer material E, 3.76 g of the additive A and 3,470 g of ethyl acetate, a 250 nm thick protective layer was formed to obtain a conductive laminate of the present invention.

### (Example 13)

In the same manner as in Example 8, except that the composition of the protective layer coating solution was 120 g of the protective layer material F, 2.94 g of the additive A, 5.85 g of the additive B and 2,913 g of ethyl acetate, a 250 nm thick protective layer was formed to obtain a conductive laminate of the present invention.

### (Example 14)

In the same manner as in Example 8, except that the composition of the protective layer coating solution was 117 g of the protective layer material B, 6. 63 g of the protective layer material G, 3.12 g of the additive A, 6.20 g of the additive B and 3,094 g of ethyl acetate, a 250 nm thick protective layer was formed to obtain a conductive laminate of the present invention.

### (Example 15)

In the same manner as in Example 8, except that the composition of the protective layer coating solution was 117 g of the protective layer material B, 6.63 g of the protective layer material H, 3.12 g of the additive A, 6.20 g of the additive B and 3,094 g of ethyl acetate, a 250 nm thick protective layer was formed to obtain a conductive laminate of the present invention.

### (Example 16)

In the same manner as in Example 8, except that the composition of the protective layer coating solution was 117 g of the protective layer material B, 16.58 g of the protective layer material I, 6.2 g of the additive B and 2,954 g of ethyl acetate, a 250 nm thick protective layer was formed to obtain a conductive laminate of the present invention.

### (Example 17)

In the same manner as in Example 8, a crosslinked layer and a conductive layer were laminated to each other. Then, the silver nanomicroparticle dispersion obtained by the method disclosed in Japanese Unexamined Patent Publication (Kokai) No. 2001-243841 (Example (2) Preparation of Silver Nanocolloid Coating Solution) was evaporated to dryness to obtain silver nanomicroparticles.

Then, 123.5 g of the protective layer material B, 3.32 g of the silver nanomicroparticles, 3.12 g of the additive A, 6.20 g of the additive B, 3, 090 g of ethyl acetate were mixed and stirred to prepare a protective layer coating solution. The above-mentioned conductive layer B was coated with the protective layer coating solution using a slit die coater mounted with shims made of SUS (thickness of shims 50 µm), dried at 120°C for 2 minutes and then irradiated with ultraviolet light at 1.2 J/cm² for curing to form a 250 nm thick protective layer, and thus obtaining a conductive laminate of the present invention.

### (Example 18)

A 125 µm thick polyethylene terephthalate film, LUMIRROR (registered trademark) U48 (manufactured by Toray Industries, Inc.) was used as a substrate. Then, 78.4 g of the crosslinked layer material E, 1.88 g of the additive B, 1.88 g of the additive C and 3, 566 g of ethyl acetate were mixed and stirred to prepare a crosslinked layer coating solution. The substrate was coated with the protective layer coating solution using a micro-gravure coater (gravure cell count: 80R, gravure revolution ratio: 100%), dried at 120°C for 2 minutes and then irradiated with ultraviolet light at 1.2 J/cm² for curing to form a 70 nm thick crosslinked layer.

Then, the conductive layer C was formed on the surface opposite to the crosslinked layer of the substrate in the above-mentioned manner.

Subsequently, 50 g of the protective layer material B, 1.20 g of the additive A, 2.38 g of the additive B and 2, 370 g of ethyl acetate were mixed, followed by stirring to prepare a protective layer coating solution. The above-mentioned conductive layer C was coated with the protective layer coating solution using a micro-gravure coater (gravure cell count: 80R, gravure revolution ratio: 100%), dried at 120°C for 2 minutes and then irradiated with ultraviolet light at 1.2 J/cm² for curing to form a 75 nm thick protective layer, and thus preparing a conductive laminate of the present invention.

### (Example 19)

In the same manner as in Example 18, except that the composition of the protective layer coating solution was 77.80 g of the protective layer material B, 6.29 g of the protective layer material D, 2.07 g of the additive A, 2.07 g of the additive B and 3,825 g of ethyl acetate, a 75 nm thick protective layer was formed to obtain a conductive laminate of the present invention.

### (Example 20)

In the same manner as in Example 19, except that the composition of the crosslinked layer coating solution was 100 g of the crosslinked layer material G and 4, 752 g of ethyl acetate, a 70 nm thick crosslinked layer was formed to obtain a conductive laminate of the present invention.

### (Example 21)

In the same manner as in Example 8, except that the conductive layer was the conductive layer E, a conductive laminate of the present invention was obtained.

### (Example 22)

In the same manner as in Example 8, except that the composition of the protective layer coating solution was 77.80 g of the protective layer material B, 6.29 g of the protective layer material D, 1.38 g of the additive A, 1.38 g of the additive B, 1.38 g of the additive C and 1, 916 g of ethyl acetate, a 250 nmthickprotective layer was formed to obtain a conductive laminate of the present invention.

### (Example 23)

In the same manner as in Example 22, except that the additive D was used in place of the additive C, a 250 nm thick protective layer was formed to obtain a conductive laminate of the present invention.

### (Example 24)

In the same manner as in Example 22, except that the composition of the crosslinked layer coating solution was 300 g of the crosslinked layer material C, 764 g of toluene and 764 g of methyl ethyl ketone, a 700 nm thick crosslinked layer was formed to obtain a conductive laminate of the present invention.

### (Example 25)

In the same manner as in Example 22, except that the composition of the crosslinked layer coating solution was 100 g of the crosslinked layer material G and 4,267 g of ethyl acetate, a 130 nm thick crosslinked layer was formed to obtain a conductive laminate of the present invention.

### (Example 26)

In the same manner as in Example 22, except that the composition of the crosslinked layer coating solution was 100 g of the crosslinked layer material G and 3, 596 g of ethyl acetate, and a substrate was coated with the crosslinked layer coating solution by a micro-gravure coater (gravure cell count: 80R, gravure revolution ratio: 100%), dried at 120°C for 2 minutes and then irradiated with ultraviolet light at 1.2 J/cm² for curing to form a 90 nm thickness crosslinked layer, a conductive laminate of the present invention was obtained.

### (Example 27)

In the same manner as in Example 26, except that the composition of the protective layer coating solution was 77.80 g of the protective layer material B, 6.29 g of the protective layer material D, 1. 38 g of the additive A, 1. 38 g of the additive B, 1.38 g of the additive C and 4,086 g of ethyl acetate, a 120 nm thick protective layer was formed to obtain a conductive laminate of the present invention.

### (Example 28)

In the same manner as in Example 22, except that the composition of the crosslinked layer coating solution was 77.80 g of the crosslinked layer material H, 1.88 g of the additive B, 1.88 g of the additive C and 1,423 g of ethyl acetate to form a 310 nm thick crosslinked layer, a conductive laminate of the present invention was obtained.

### (Example 29)

In the same manner as in Example 22, except that the composition of the crosslinked layer coating solution was 155.6 g of the crosslinked layer material H, 3.76 g of the additive B, 3.76 g of the additive C and 1, 630 g of ethyl acetate to provide a 310 nm thick crosslinked layer, a conductive laminate of the present invention was obtained.

### (Example 30)

In the same manner as in Example 22, except that the composition of the crosslinked layer coating solution was 233.4 g of the crosslinked layer material H, 5.64 g of the additive B, 5.64 g of the additive C and 1,227 g of ethyl acetate to provide a 310 nm thick crosslinked layer, a conductive laminate of the present invention was obtained.

### (Example 31)

In the same manner as in Example 22, except that the composition of the crosslinked layer coating solution was 50.0 g of the crosslinked layer material I and 2, 138 g of ethyl acetate to provide a 130 nm thick crosslinked layer, a conductive laminate of the present invention was obtained.

### (Example 32)

In the same manner as in Example 22, except that the composition of the crosslinked layer coating solution was 100 g of the crosslinked layer material I and 1,735 g of ethyl acetate to provide a 310 nm thick crosslinked layer, a conductive laminate of the present invention was obtained.

### (Example 33)

A 50 µm thick polyethylene terephthalate film, LUMIRROR (registered trademark) U48 (manufactured by Toray Industries, Inc.) was used as a substrate. Then, 300 g of the crosslinked layer material C, 764 g of toluene and 764 g of methyl ethyl ketone were mixed, followed by stirring to prepare a crosslinked layer coating solution. The substrate was coated with the protective layer coating solution using a slit die coater mounted with shims made of SUS (thickness of shims 50 µm), dried at 100°C for 2 minutes and then irradiated with ultraviolet light at 1.2 J/cm² for curing to form a 700 nm thick crosslinked layer.

Then, the conductive layer B was formed on the surface opposite to the crosslinked layer of the substrate in the above-mentioned manner.

Subsequently, 77.80 g of the protective layer material B, 6.29 g of the protective layer material D, 1.38 g of the additive A, 1.38 g of the additive B, 1.38 g of the additive C and 1,916 g of ethyl acetate were mixed, followed by stirring to prepare a protective layer coating solution. The above-mentioned conductive layer B was coated with the protective layer coating solution using a slit die coater mounted with shims made of SUS (thickness of shims 50 µm), dried at 120°C for 2 minutes and then irradiated with ultraviolet light at 1.2 J/cm² for curing to form a 250 nm thick protective layer, and thus obtaining a conductive laminate of the present invention.

### (Example 34)

In the same manner as in Example 33, except that the composition of the crosslinked layer coating solution was 100 g of the crosslinked layer material G and 4,267 g of ethyl acetate to provide a 130 nm thick crosslinked layer, a conductive laminate of the present invention was obtained.

### (Example 35)

In the same manner as in Example 33, except that the composition of the crosslinked layer coating solution was 100 g of the crosslinked layer material J and 1, 734 g of ethyl acetate to provide a 310 nm thick crosslinked layer, a conductive laminate of the present invention was obtained.

### (Example 36)

In the same manner as in Example 33, except that the composition of the crosslinked layer coating solution was 100 g of the crosslinked layer material K and 1, 740 g of ethyl acetate to provide a 310 nm thick crosslinked layer, a conductive laminate of the present invention was obtained.

### (Example 37)

In the same manner as in Example 33, except that the composition of the crosslinked layer coating solution was 100 g of the crosslinked layer material L and 1,755 g of ethyl acetate to provide a 310 nm thick crosslinked layer, a conductive laminate of the present invention was obtained.

### (Example 38)

In the same manner as in Example 22, except that the composition of the crosslinked layer coating solution was 300 g of the crosslinked layer material P and 2,190 g of ethyl acetate to provide a 700 nm thick crosslinked layer, a conductive laminate of the present invention was obtained.

### (Comparative Example 1)

A 125 µm thick polyethylene terephthalate film, LUMIRROR (registered trademark) U48 (manufactured by Toray Industries, Inc.) was subjected to various evaluations without providing a crosslinked layer, a conductive layer and a protective layer.

### (Comparative Example 2)

In the same manner as in Example 22, the conductive layer and the protective layer were formed and only the crosslinked layer was not provided to obtain a conductive laminate.

### (Comparative Example 3)

In the same manner as in Example 8, the crosslinked layer and the conductive layer were provided and only the protective layer was not provided to obtain a conductive laminate.

### (Comparative Example 4)

In the same manner as in Example 18, the crosslinked layer and the conductive layer were provided and only the protective layer was not provided to obtain a conductive laminate.

### (Comparative Example 5)

A 125 µm thick polyethylene terephthalate film, LUMIRROR (registered trademark) U48 (manufactured by Toray Industries, Inc.) was used as a substrate. Then, 78.4 g of the crosslinked layer material E, 1. 88 g of the additive B, 1. 88 g of the additive C and 3,566 g of ethyl acetate were mixed and stirred to prepare a crosslinked layer coating solution. The substrate was coated with the protective layer coating solution using a micro-gravure coater (gravure cell count: 80R, gravure revolution ratio: 100%), dried at 120°C for 2 minutes and then irradiated with ultraviolet light at 1.2 J/cm² for curing to form a 70 nm thick crosslinked layer.

Then, the conductive layer D was formed on the surface opposite to the crosslinked layer of the substrate in the above-mentioned manner.

Subsequently, 150 g of the protective layer material B, 3.60 g of the additive A, 7.15 g of the additive B and 2,748 g of ethyl acetate were mixed, followed by stirring to prepare a protective layer coating solution. The above-mentioned conductive layer D was coated with the protective layer coating solution using a slit die coater mounted with shims made of SUS (thickness of shims: 50 µm), dried at 120°C for 2 minutes and then irradiated with ultraviolet light at 1.2 J/cm² for curing to form a 310 nm thick protective layer, and thus obtaining a conductive laminate.

### (Comparative Example 6)

In the same manner as in Comparative Example 5, except that the conductive layer was the conductive layer F, a conductive laminate was obtained.

### (Comparative Example 7)

A 125 µm thick polyethylene terephthalate film, LUMIRROR (registered trademark) U48 (manufactured by Toray Industries, Inc.) was used as a substrate. Then, 78.4 g of the crosslinked layer material E, 1.88 g of the additive B, 1.88 g of the additive C and 6, 752 g of ethyl acetate were mixed and stirred to prepare a crosslinked layer coating solution. The substrate was coated with the protective layer coating solution using a micro-gravure coater (gravure cell count: 80R, gravure revolution ratio: 100%), dried at 120 °C for 2 minutes and then irradiated with ultraviolet light at 1.2 J/cm² for curing to form a 40 nm thick crosslinked layer.

Then, the conductive layer B was formed on the surface opposite to the crosslinked layer of the substrate in the above-mentioned manner.

Subsequently, 311.2 g of the protective layer material B, 25.16 g of the protective layer material D, 5.52 g of the additive A, 5.52 g of the additive B, 5.52 g of the additive C and 2,152 g of ethyl acetate were mixed, followed by stirring to prepare a protective layer coating solution. The above-mentioned conductive layer B was coated with the protective layer coating solution using a slit die coater mounted with shims made of SUS (thickness of shims: 50 µm), dried at 120°C for 2 minutes and then irradiated with ultraviolet light at 1.2 J/cm² for curing to form a 800 nm thick protective layer, and thus obtaining a conductive laminate.

### (Comparative Example 8)

In the same manner as in Example 22, except that the composition of the crosslinked layer coating solution was 784 g of the crosslinked layer material E, 18.8 g of the additive B, 18.8 g of the additive C and 3,420 g of ethyl acetate to provide a 1,100 nm thick crosslinked layer, a conductive laminate was obtained.

### (Comparative Example 9)

In the same manner as in Example 8, except that the composition of the protective layer coating solution was 77.80 g of the protective layer material B, 6.29 g of the protective layer material D, 1.38 g of the additive A, 1.38 g of the additive B, 1.38 g of the additive C and 8,260 g of ethyl acetate to provide a 60 nm thick protective layer, a conductive laminate was obtained.

### (Comparative Example 10)

In the same manner as in Example 8, except that the composition of the protective layer coating solution was 778.0 g of the protective layer material B, 62.9 g of the protective layer material D, 13.8 g of the additive A, 13.8 g of the additive B, 13.8 g of the additive C and 3,672 g of ethyl acetate to provide a 1,100 nm thick protective layer, a conductive laminate was obtained.

### (Comparative Example 11)

In the same manner as in Example 22, except that the composition of the crosslinked layer coating solution was 1,000 g of the crosslinked layer material M and 1, 800 g of ethyl acetate, and the substrate was coated with the crosslinked layer coating solution using a slit die coater mounted with shims made of SUS (thickness of shims: 50 µm) and dried at 120°C for 2 minutes to form a 950 nm thick crosslinked layer, a conductive laminate was obtained.

### (Comparative Example 12)

In the same manner as in Example 22, except that the composition of the crosslinked layer coating solution was 153 g of the crosslinked layer material N, 7.20 g of the additive A, 14.3 g of the additive B, 892 g of toluene and 892 g of ethyl acetate to form a 950 nm thick crosslinked layer, a conductive laminate was obtained.

### (Comparative Example 13)

In the same manner as in Example 33, except that the composition of the crosslinked layer coating solution was 153 g of the crosslinked layer material O, 7.20 g of the additive A, 14.3 g of the additive B, 2, 915 g of toluene and 2, 915 g of ethyl acetate to form a 310 nm thick crosslinked layer, a conductive laminate was obtained.

### (Comparative Example 14)

In the same manner as in Example 22, except that the composition of the crosslinked layer coating solution was 15.3 g of the crosslinked layer material O, 0.72 g of the additive A, 1.43 g of the additive B, 1,355 g of toluene and 1,355 g of ethyl acetate, and a substrate was coated with the crosslinked layer coating solution by a micro-gravure coater (gravure cell count: 80R, gravure revolution ratio: 100%), dried at 120 °C for 2 minutes and then irradiated with ultraviolet light at 1.2 J/cm² for curing to form a 40 nm thickness crosslinked layer, a conductive laminate of the present invention was obtained.

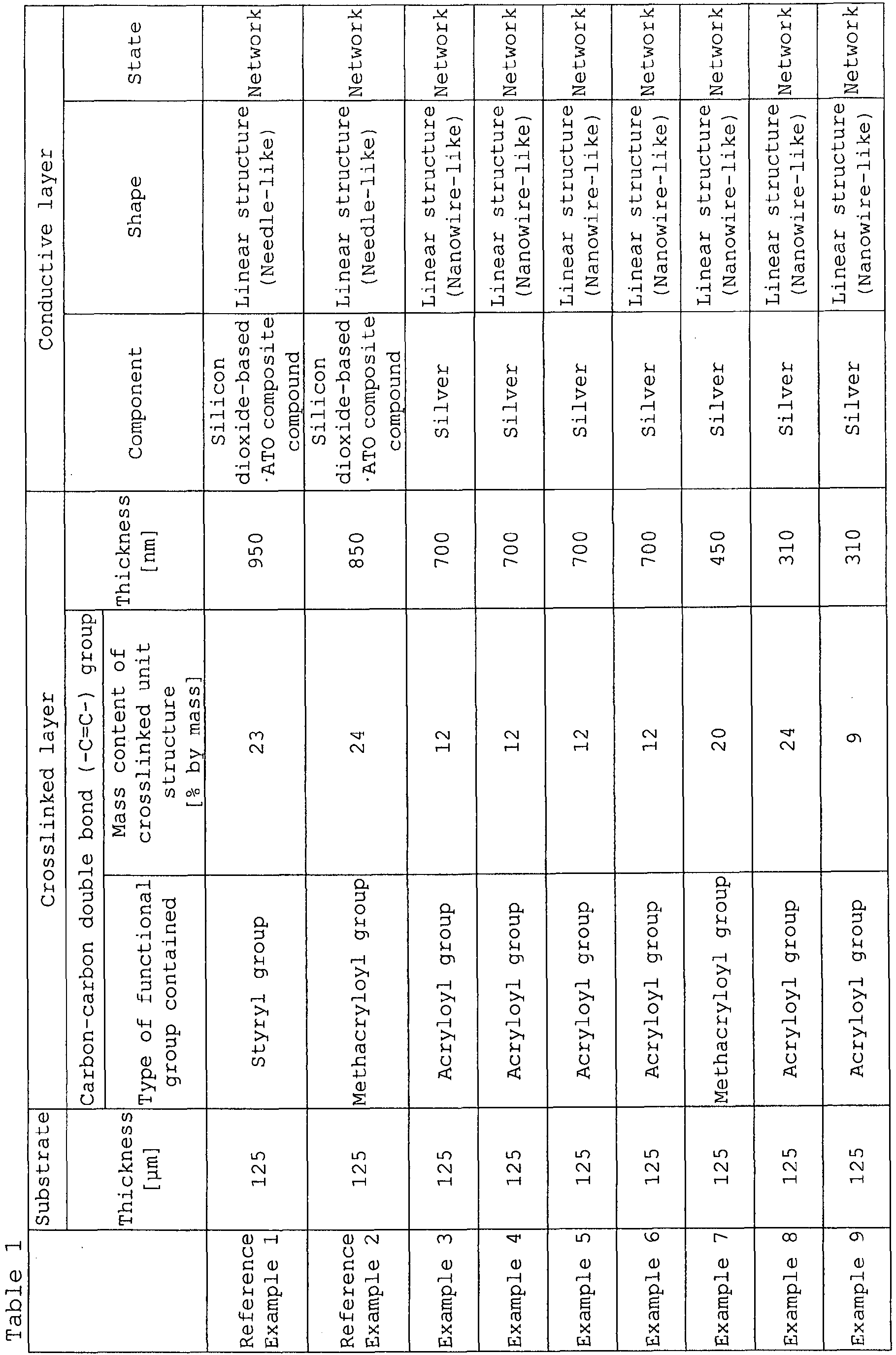

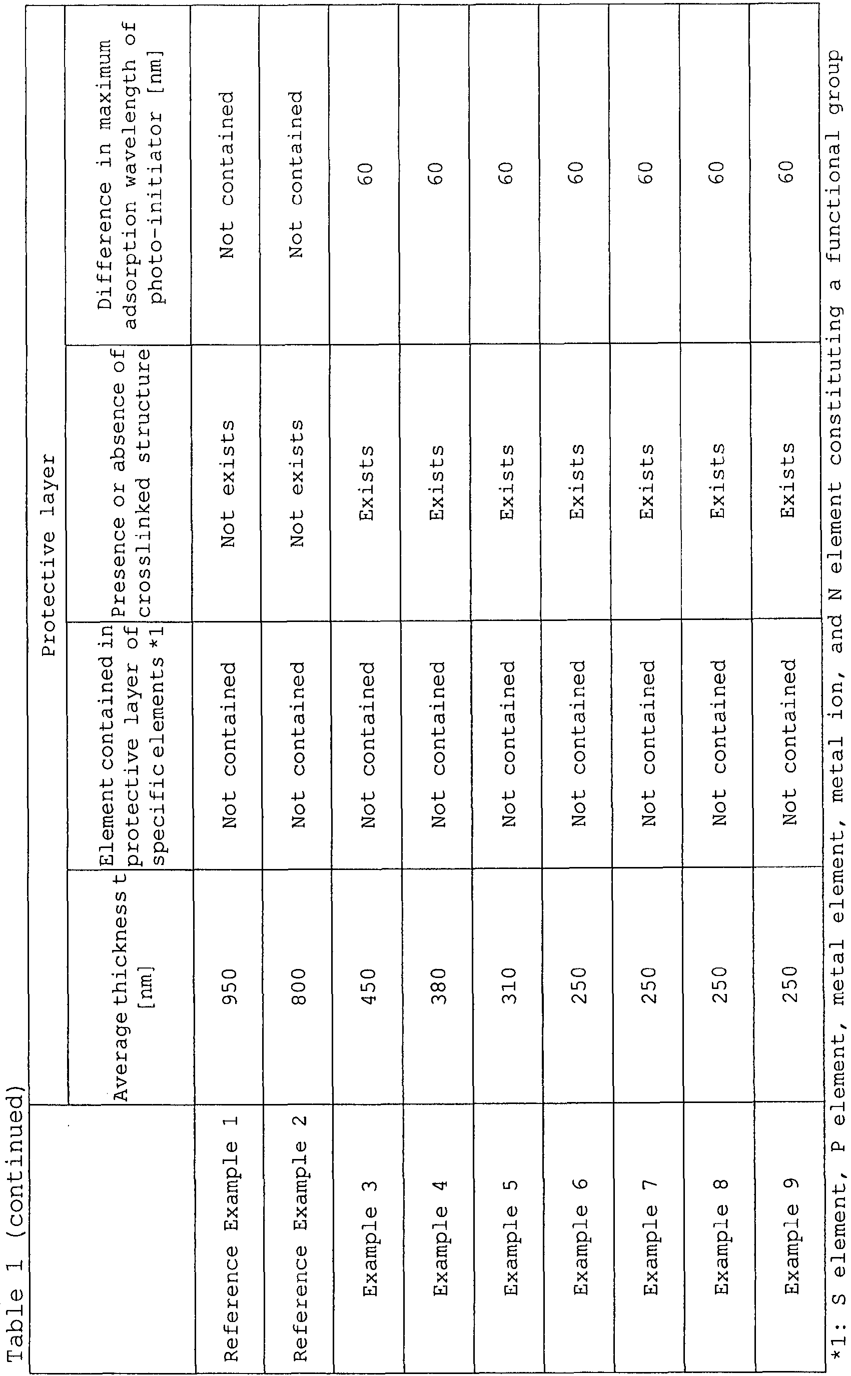

**Table 2**

| | Conductive laminate | | | Durability against heat | | Properties of patterned portions | |
|---|---|---|---|---|---|---|---|
| | Surface resistance value [Ω/□] | | Total light transmittance [%] | Before patterning | After patterning | Presence or absence of remaining conductive component | Acceptance or rejection of electrical insulation properties |
| | Protective layer side R₀ | Crosslinked layer side | | Judgment (Hz/Hz₀) | Judgment | | |
| Reference Example 1 | 3.2×10⁶ | 1.0×10¹⁴ or more | 76.5 | Accepted (1.18) | Accepted | Accepted | Accepted |
| Reference Example 2 | 2.1×10⁵ | 1.0×10¹⁴ or more | 76.7 | Accepted (1.18) | Accepted | Accepted | Accepted |
| Example 3 | 509 | 1.0×10¹⁴ or more | 90.2 | Accepted (1.09) | Accepted | Accepted | Accepted |
| Example 4 | 277 | 1.0×10¹⁴ or more | 90.8 | Accepted (1.10) | Accepted | Accepted | Accepted |
| Example 5 | 156 | 1.0×10¹⁴ or more | 91.3 | Accepted (1.08) | Accepted | Accepted | Accepted |
| Example 6 | 153 | 1.0×10¹⁴ or more | 91.2 | Accepted (1.09) | Accepted | Accepted | Accepted |
| Example 7 | 155 | 1.0×10¹⁴ or more | 91.4 | Accepted (1.13) | Accepted | Accepted | Accepted |
| Example 8 | 155 | 1.0×10¹⁴ or more | 91.3 | Accepted (1.01) | Accepted | Accepted | Accepted |
| Example 9 | 152 | 1.0×10¹⁴ or more | 91.3 | Accepted (1.08) | Accepted | Accepted | Accepted |

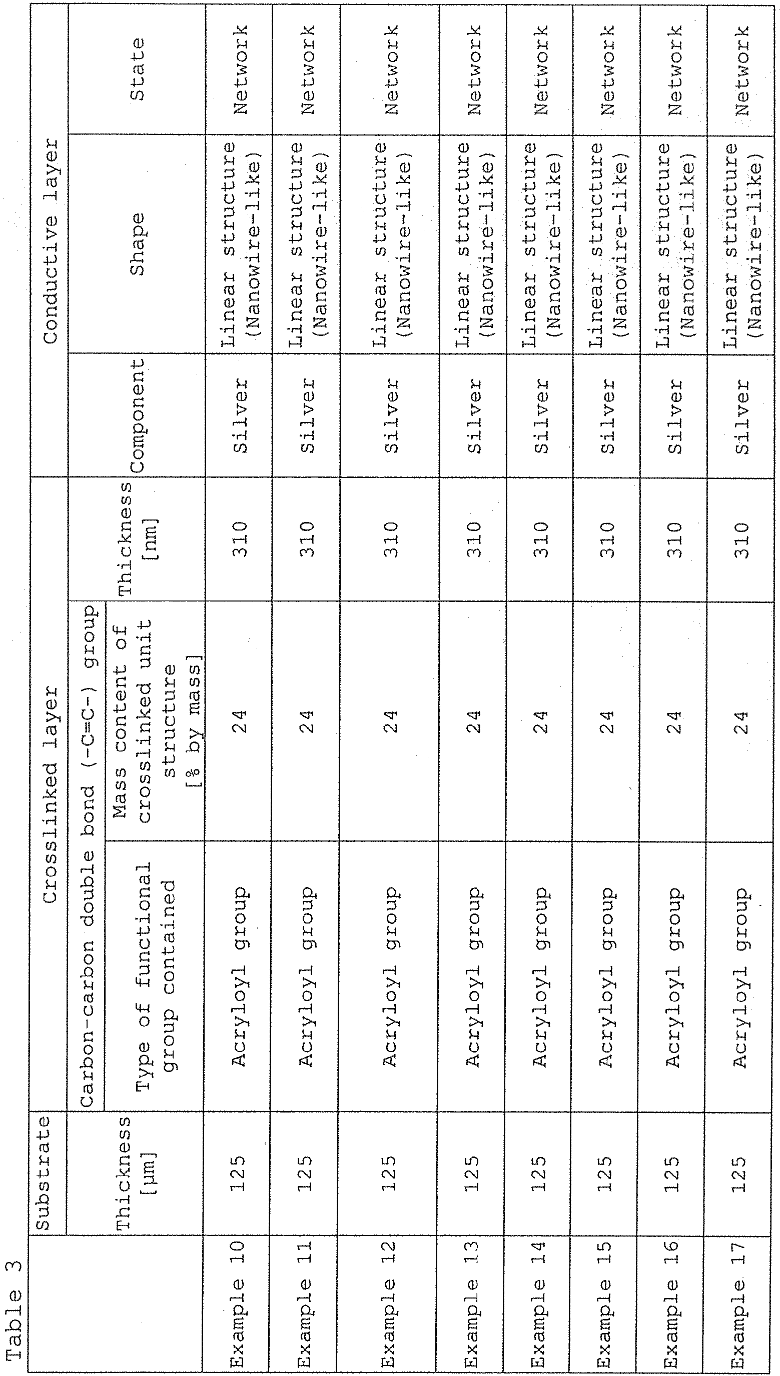

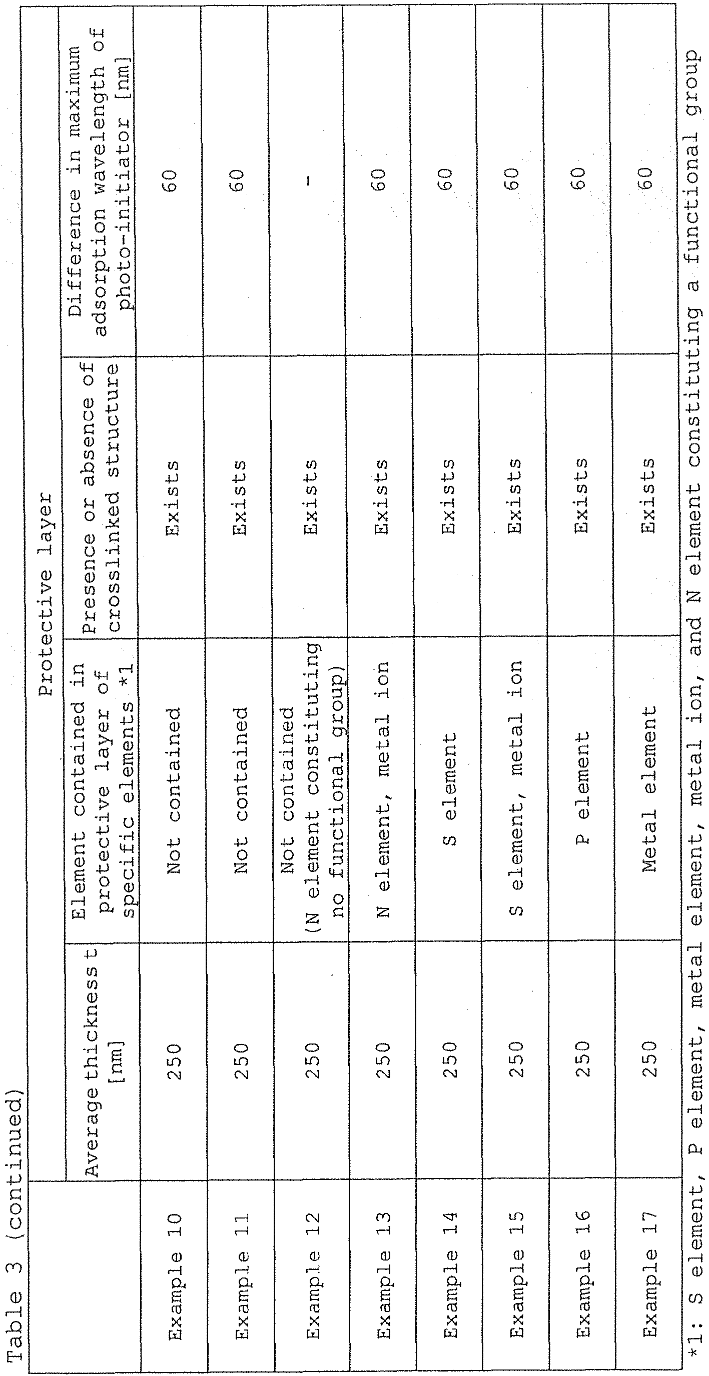

**Table 4**

| | Conductive laminate | | | Durability against heat | | Properties of patterned portions | |
|---|---|---|---|---|---|---|---|
| | Surface resistance value [Ω/□] | | Total light transmittance [%] | Before patterning | After patterning | Presence or absence of remaining conductive component | Acceptance or rejection of electrical insulation properties |
| | Protective layer side R₀ | Crosslinked layer side | | Judgment (Hz/Hz₀) | Judgment | | |
| Example 10 | 148 | 1.0×10¹⁴ or more | 91.6 | Accepted (1.01) | Accepted | Accepted | Accepted |
| Example 11 | 158 | 1.0×10¹⁴ or more | 91.2 | Accepted (1.01) | Accepted | Accepted | Accepted |
| Example 12 | 163 | 1.0×10¹⁴ or more | 90.9 | Accepted (1.01) | Accepted | Accepted | Accepted |
| Example 13 | 174 | 1.0×10¹⁴ or more | 90.8 | Accepted (1.01) | Accepted | Accepted | Accepted |
| Example 14 | 183 | 1.0×10¹⁴ or more | 90.4 | Accepted (1.03) | Accepted | Accepted | Accepted |
| Example 15 | 180 | 1.0×10¹⁴ or more | 90.4 | Accepted (1.04) | Accepted | Accepted | Accepted |
| Example 16 | 167 | 1.0×10¹⁴ or more | 90.8 | Accepted (1.04) | Accepted | Accepted | Accepted |
| Example 17 | 140 | 1.0×10¹⁴ or more | 87.1 | Accepted (1.01) | Accepted | Accepted | Accepted |

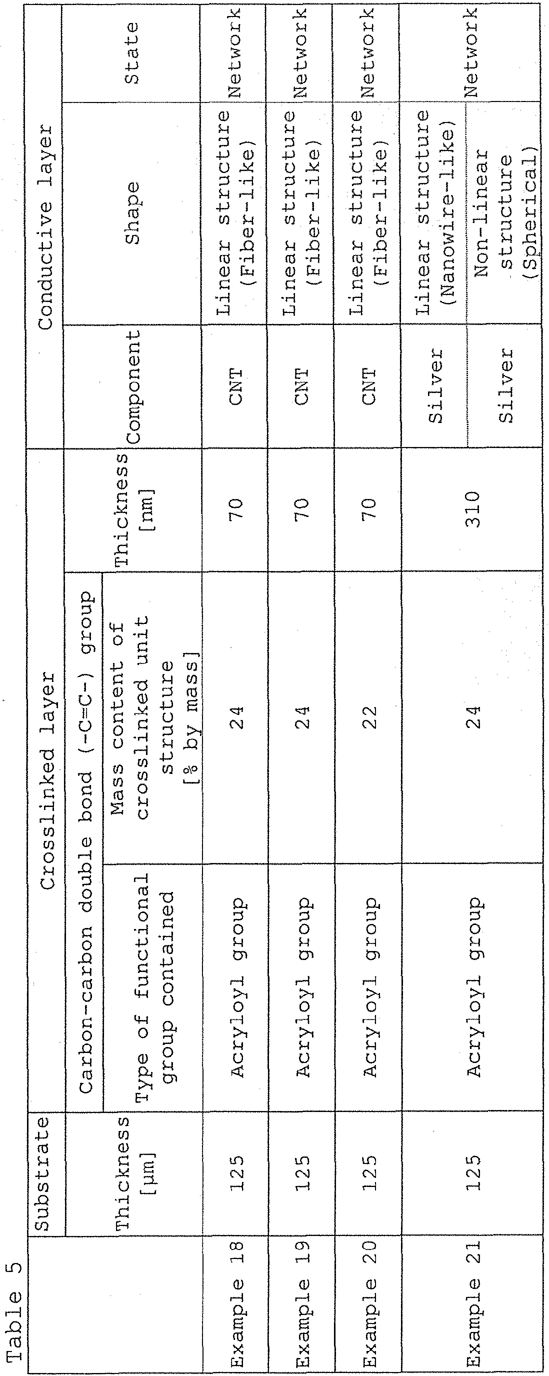

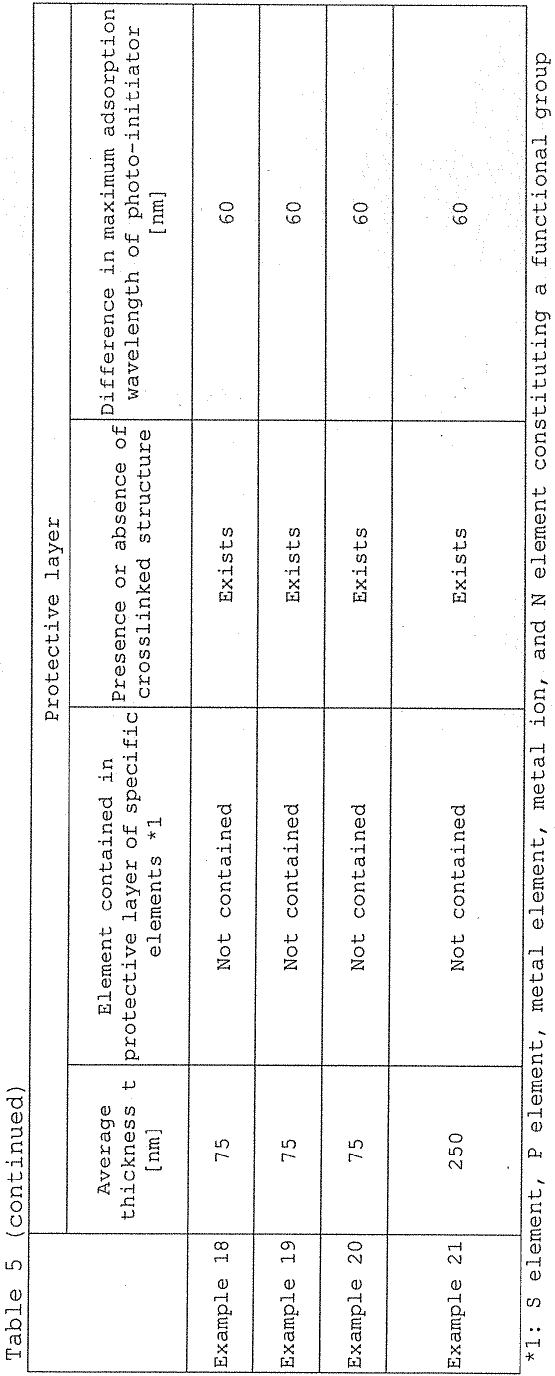

**Table 6**

| | Conductive laminate | | | Durability against heat | | Properties of patterned portions | |
|---|---|---|---|---|---|---|---|
| | Surface resistance value [Ω/□] | | Total light transmittance [%] | Before patterning | After patterning | Presence or absence of remaining conductive component | Acceptance or rejection of electrical insulation properties |
| | Protective layer side R₀ | Crosslinked layer side | | Judgment (Hz/Hz₀) | Judgment | | |
| Example 18 | 855 | 1.0×10¹⁴ or more | 85.2 | Accepted (1.11) | Accepted | Accepted | Accepted |
| Example 19 | 850 | 1.0×10¹⁴ or more | 85.2 | Accepted (1.12) | Accepted | Accepted | Accepted |
| Example 20 | 851 | 1.0×10¹⁴ or more | 85.4 | Accepted (1.15) | Accepted | Accepted | Accepted |
| Example 21 | 331 | 1.0×10¹⁴ or more | 70.3 | Accepted (1.02) | Accepted | Accepted | Accepted |

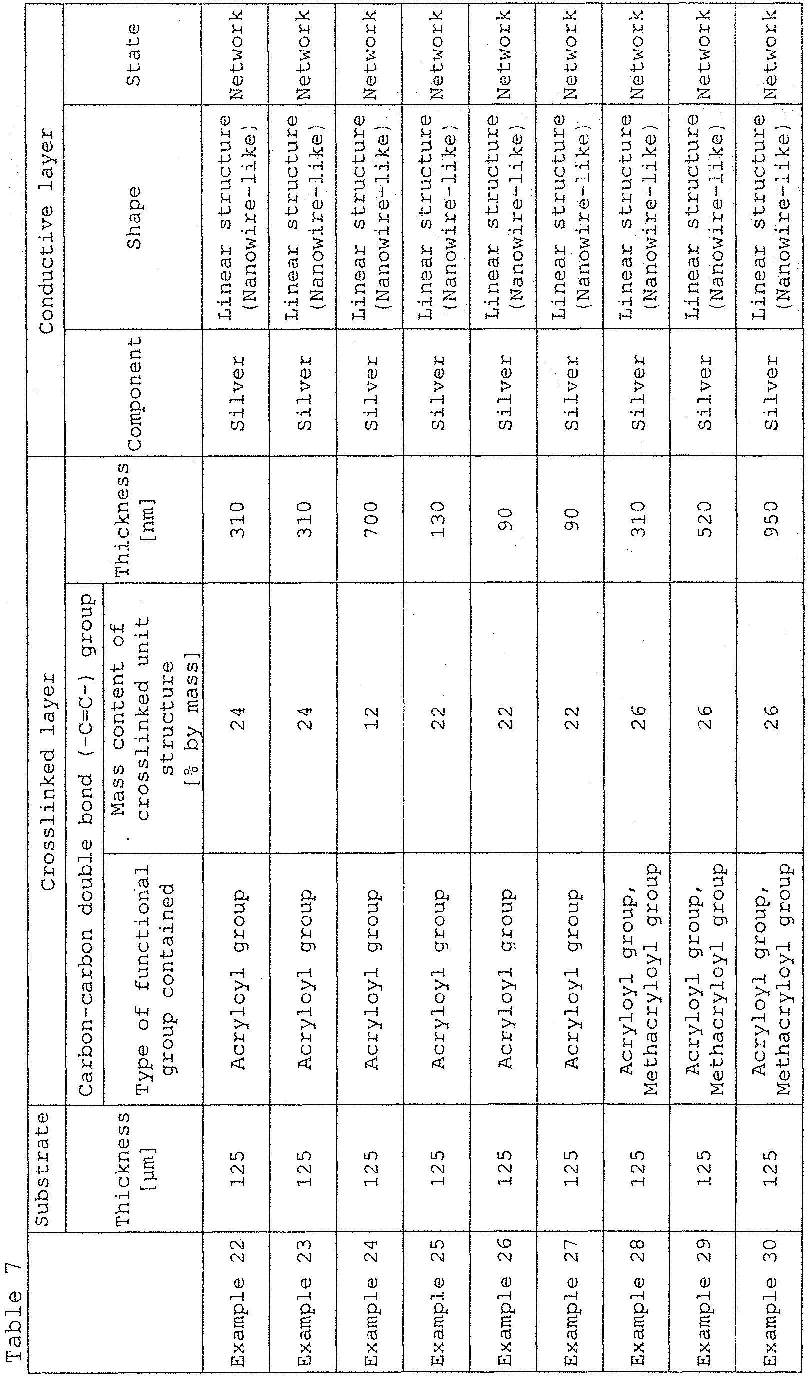

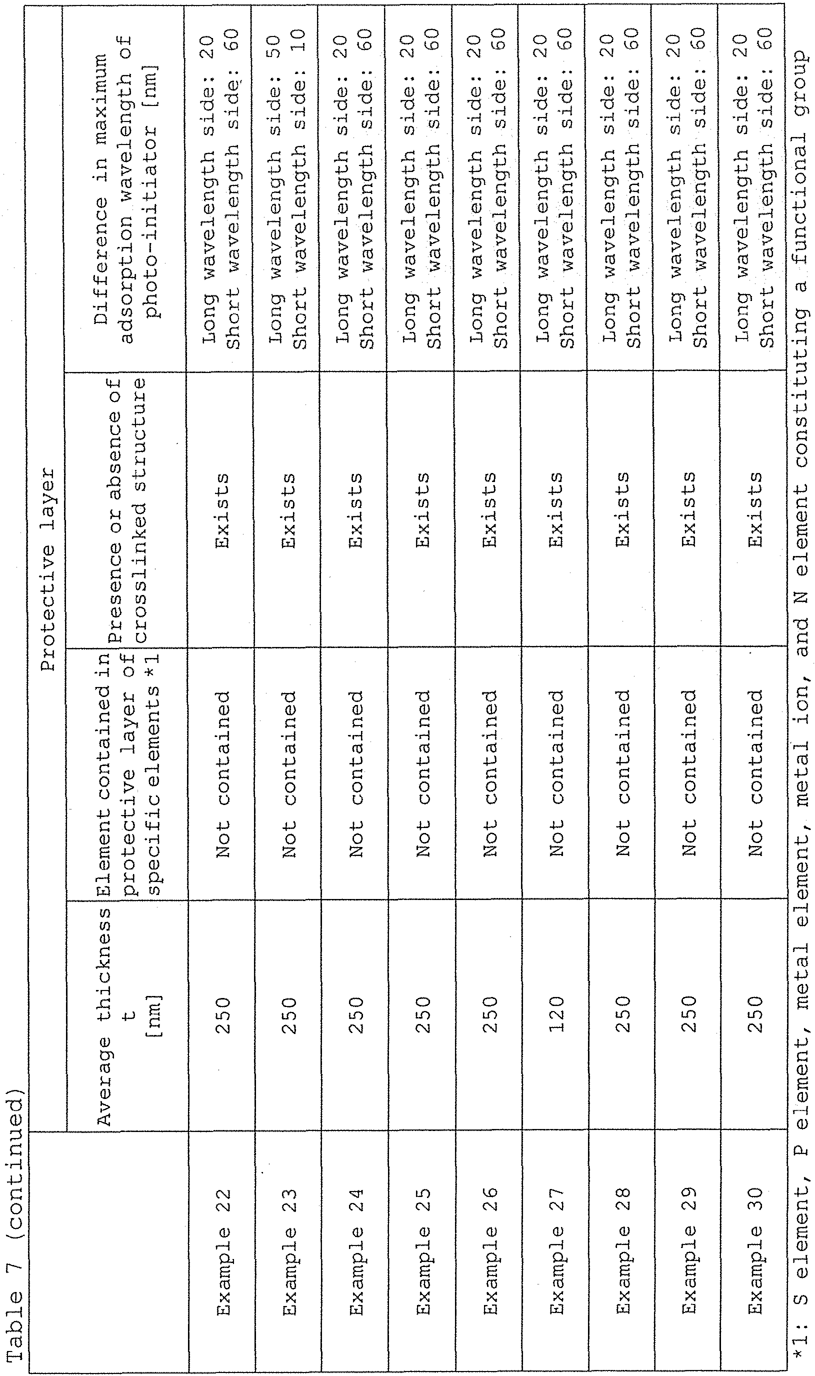

**Table 8**

| | Conductive laminate | | | Durability against heat | | Properties of patterned portions | |
|---|---|---|---|---|---|---|---|
| | Surface resistance value [Ω/□] | | Total light transmittance [%] | Before patterning | After patterning | Presence or absence of remaining conductive component | Acceptance or rejection of electrical insulation properties |
| | Protective layer side R₀ | Crosslinked layer side | | Judgment (Hz/Hz₀) | Judgment | | |
| Example 22 | 169 | 1.0×10¹⁴ or more | 91.3 | Accepted (1.01) | Accepted | Accepted | Accepted |
| Example 23 | 166 | 1.0×10¹⁴ or more | 91.2 | Accepted (1.01) | Accepted | Accepted | Accepted |
| Example 24 | 171 | 1.0×10¹⁴ or more | 91.1 | Accepted (1.07) | Accepted | Accepted | Accepted |
| Example 25 | 167 | 1.0×10¹⁴ or more | 91.1 | Accepted (1.06) | Accepted | Accepted | Accepted |
| Example 26 | 167 | 1.0×10¹⁴ or more | 91 | Accepted (1.06) | Accepted | Accepted | Accepted |
| Example 27 | 157 | 1.0×10¹⁴ or more | 91.3 | Accepted (1.07) | Accepted | Accepted | Accepted |
| Example 28 | 162 | 5.5×10¹² | 90.9 | Accepted (1.04) | Accepted | Accepted | Accepted |
| Example 29 | 170 | 6.9×10¹¹ | 90.2 | Accepted (1.03) | Accepted | Accepted | Accepted |
| Example 30 | 179 | 7.1×10¹⁰ | 90.3 | Accepted (1.02) | Accepted | Accepted | Accepted |

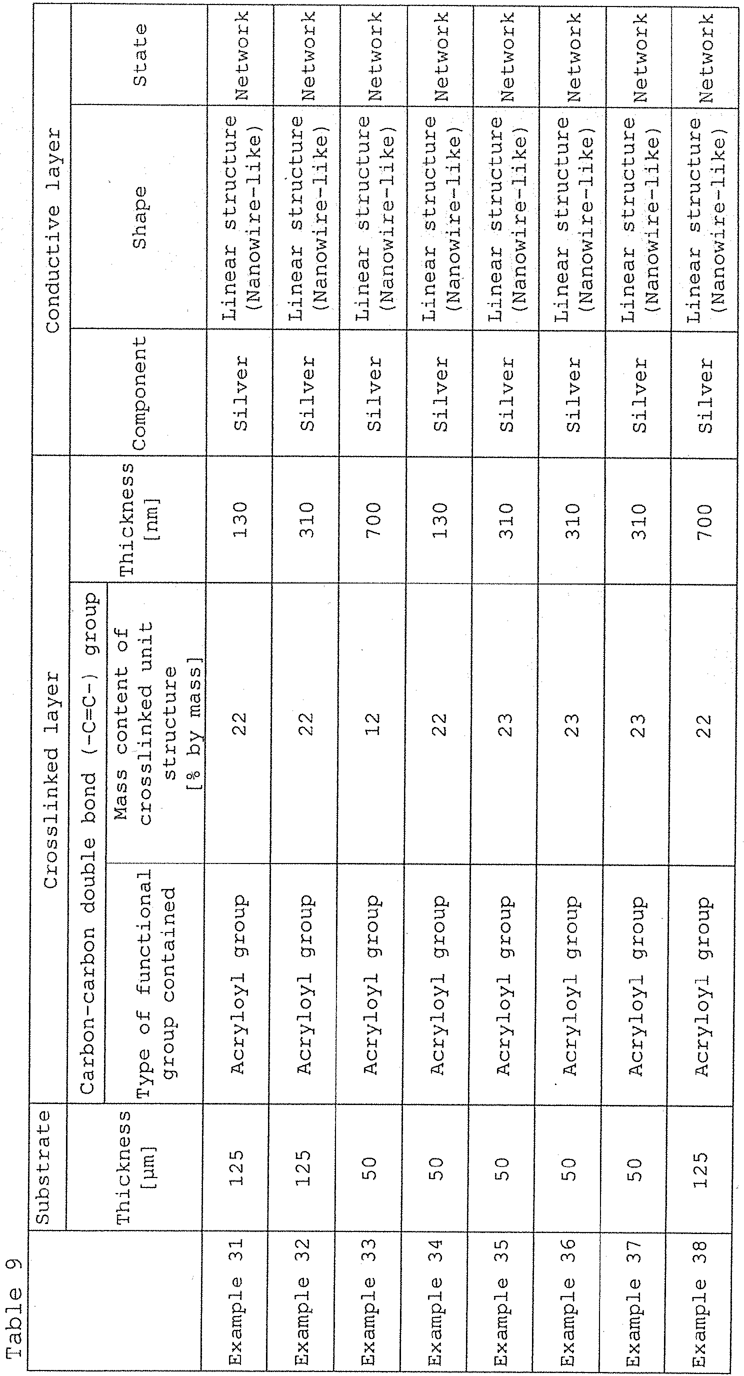

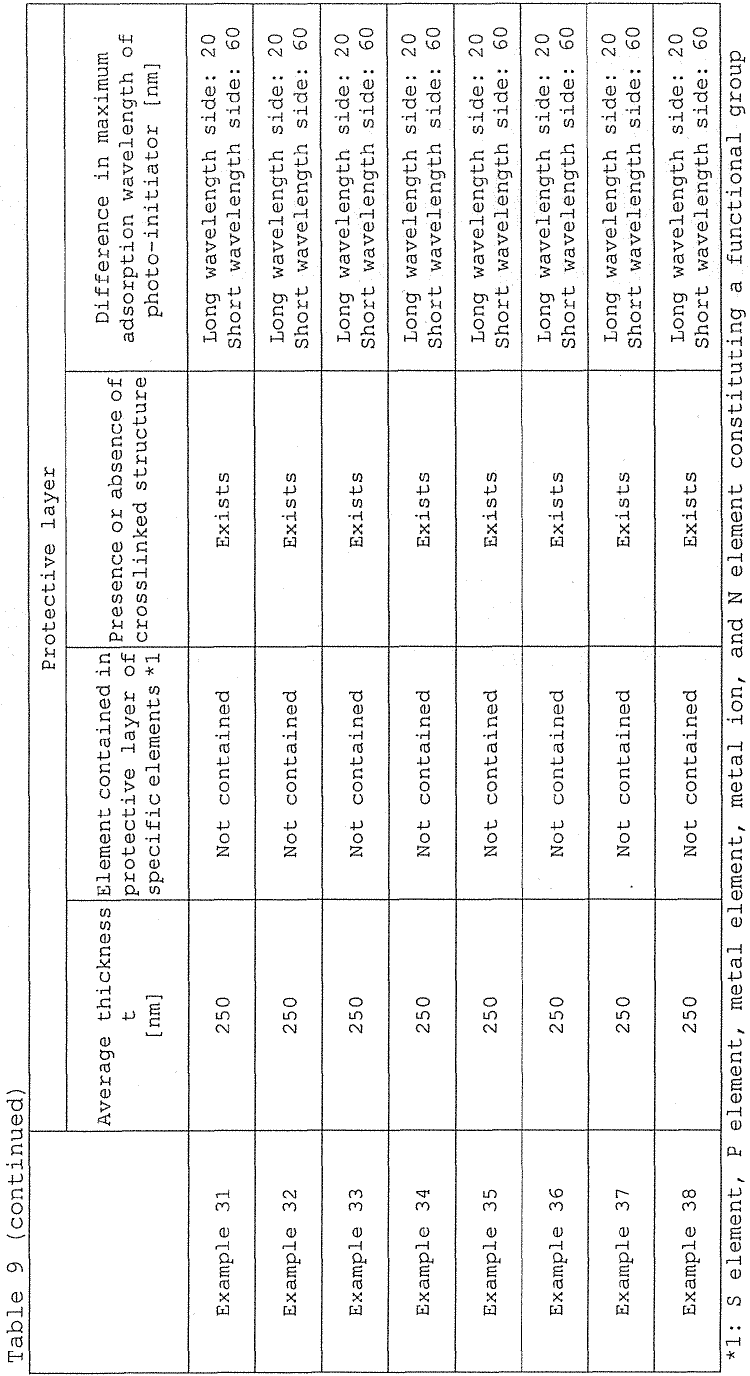

**Table 10**

| | Conductive laminate | | | Durability against heat | | Properties of patterned portions | |
|---|---|---|---|---|---|---|---|
| | Surface resistance value [Ω/□] | | Total light transmittance [%] | Before pattering | After patterning | Presence or absence of remaining conductive component | Acceptance or rejection of electrical insulation properties |
| | Protective layer side R₀ | Crosslinked layer side | | Judgment (Hz/Hz₀) | Judgment | | |
| Example 31 | 159 | 1.0×10¹⁴ or more | 90.0 | Accepted (1.09) | Accepted | Accepted | Accepted |
| Example 32 | 163 | 1.0×10¹⁴ or more | 89.9 | Accepted (1.03) | Accepted | Accepted | Accepted |
| Example 33 | 175 | 1.0×10¹⁴ or more | 91.8 | Accepted (1.08) | Accepted | Accepted | Accepted |
| Example 34 | 156 | 1.0×10¹⁴ or more | 91.7 | Accepted (1.05) | Accepted | Accepted | Accepted |
| Example 35 | 159 | 1.0×10¹⁴ or more | 91.8 | Accepted (1.01) | Accepted | Accepted | Accepted |
| Example 36 | 160 | 1.0×10¹⁴ or more | 91.8 | Accepted (1.02) | Accepted | Accepted | Accepted |
| Example 37 | 159 | 1.0×10¹⁴ or more | 91.8 | Accepted (1.06) | Accepted | Accepted | Accepted |
| Example 38 | 168 | 1.0×10¹⁴ or more | 89.8 | Accepted (1.03) | Accepted | Accepted | Accepted |

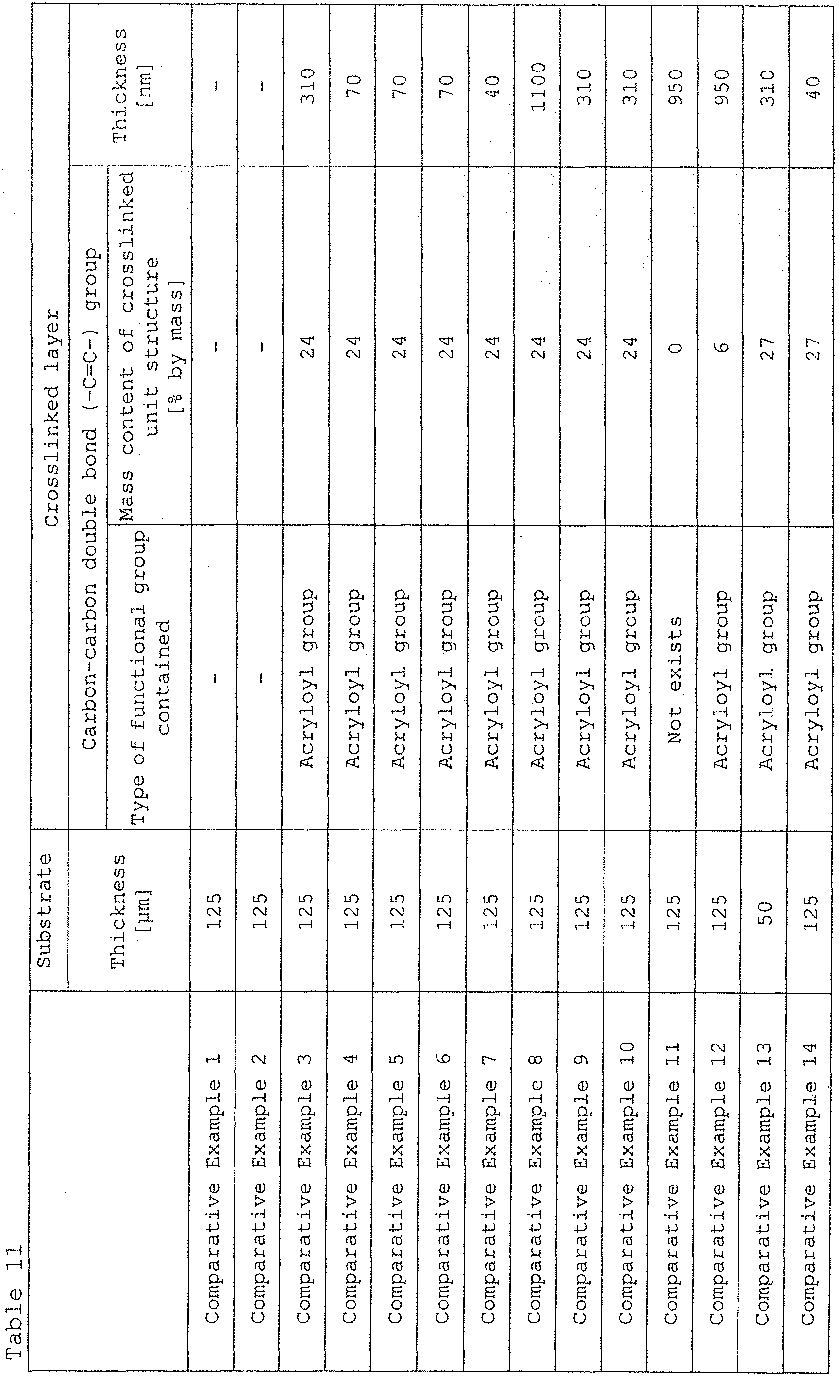

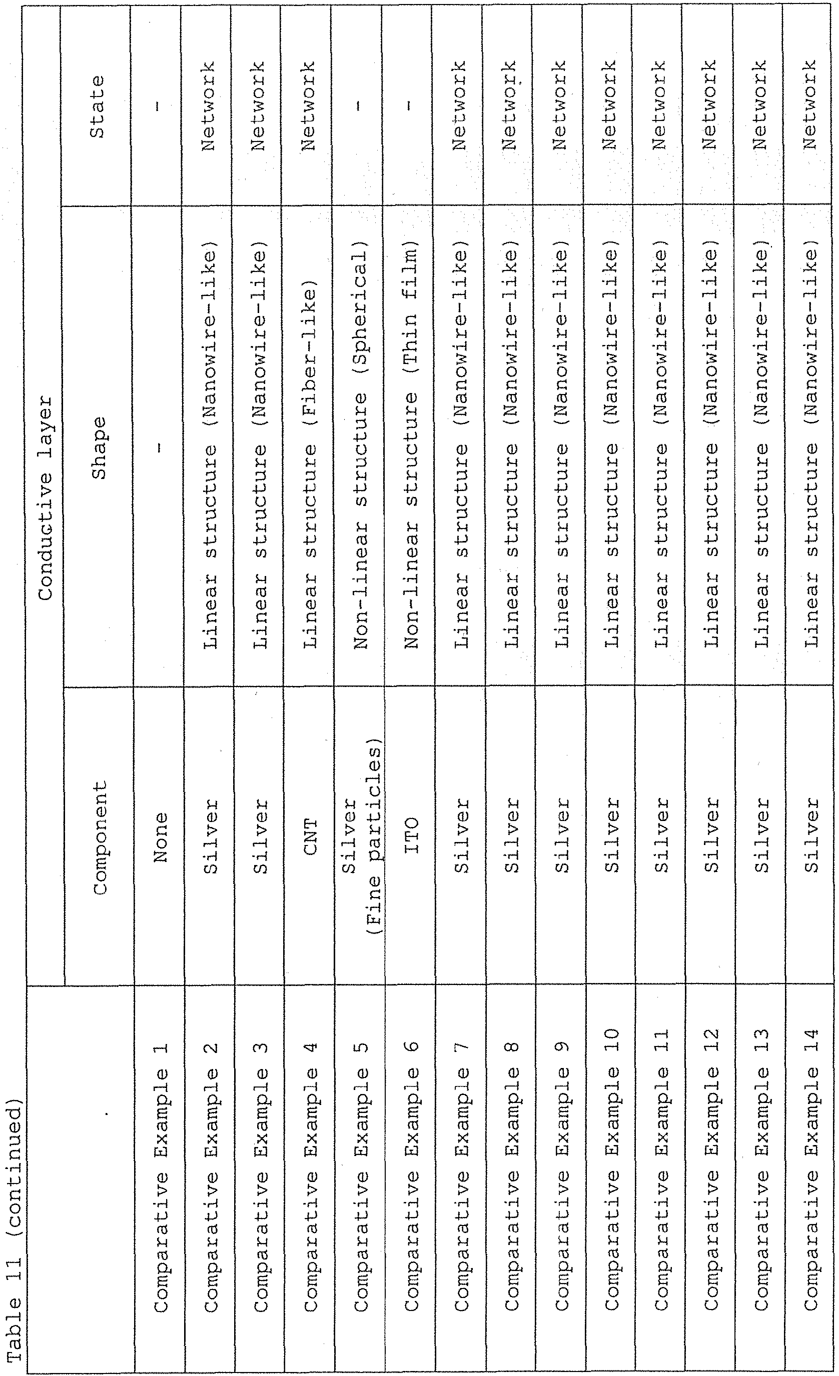

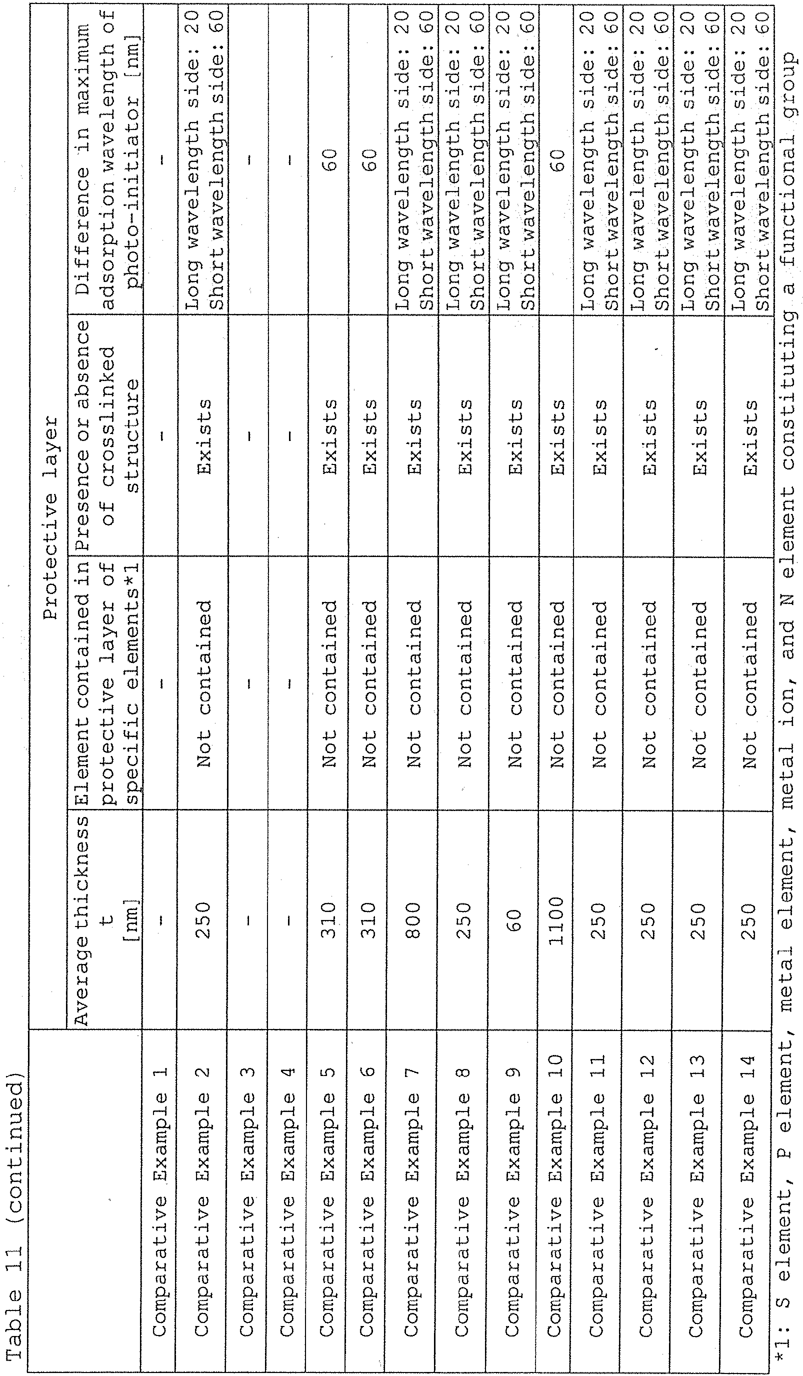

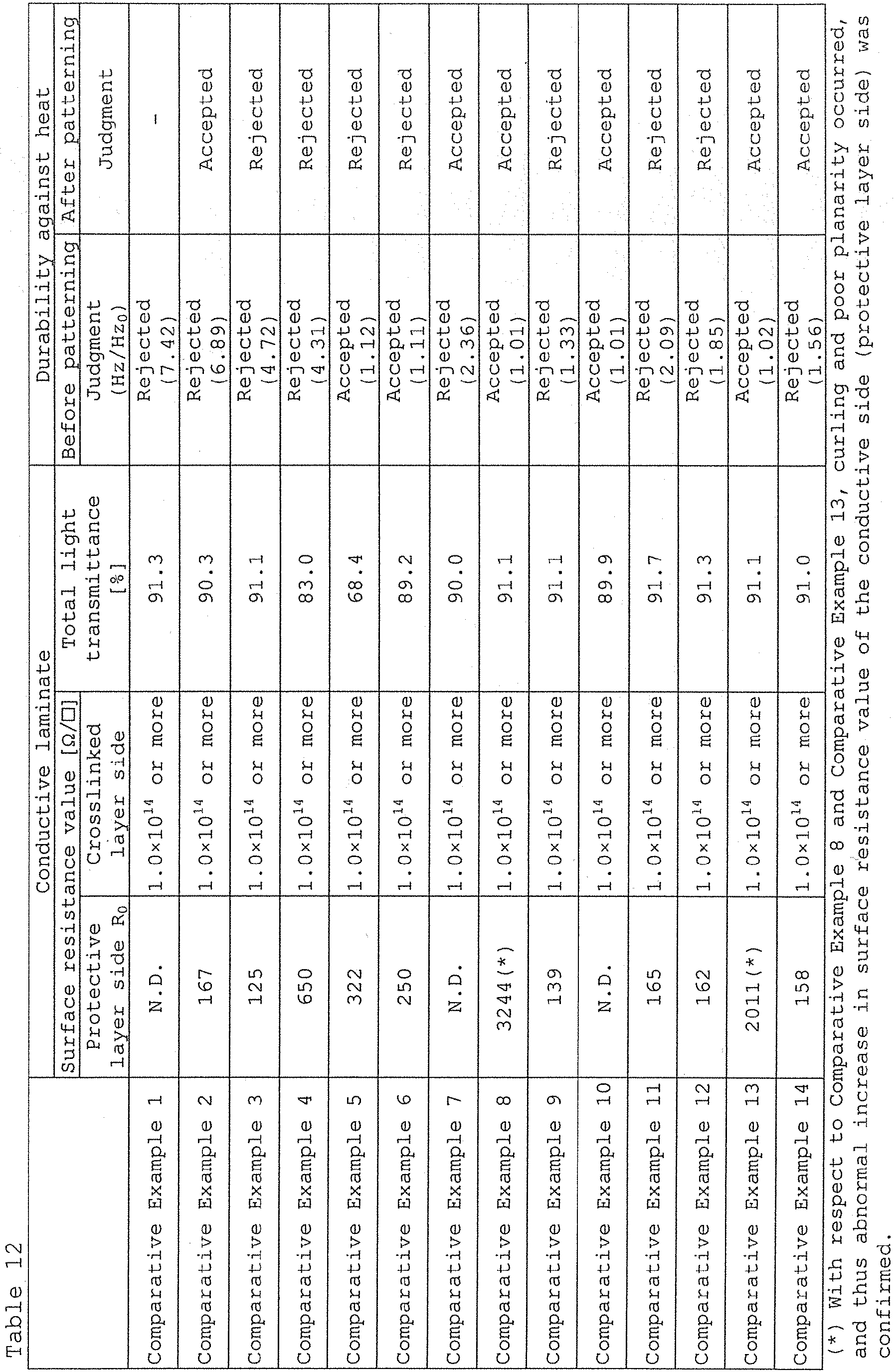

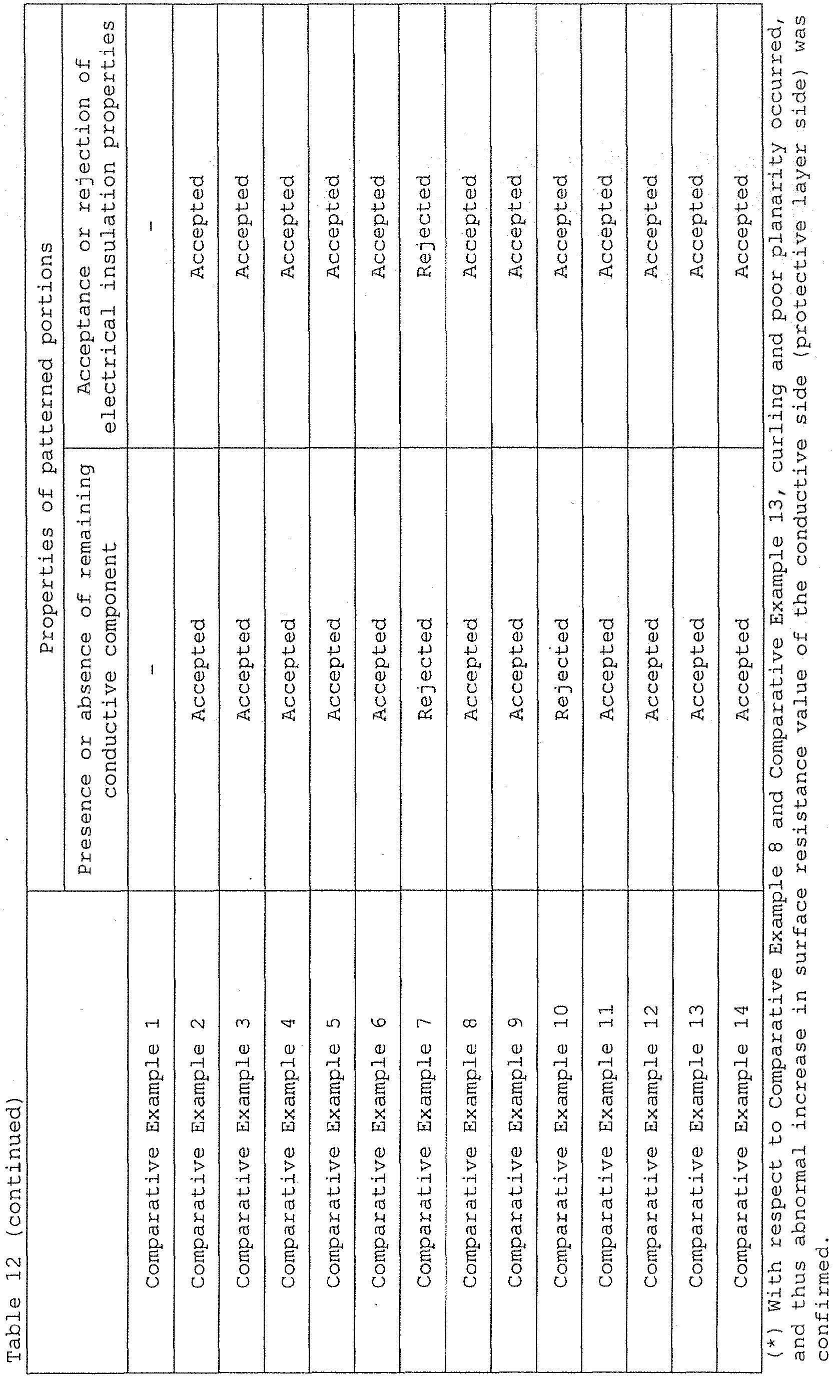

**Table 13**

| | Conductive laminate |
|---|---|
| | Transmitted light color tone b* value (light source C) |
| Example 21 | 1.7 |
| Example 25 | 1.2 |
| Example 31 | 0.8 |
| Example 32 | 0.4 |
| Example 38 | 0.5 |

**Table 14**

| | Conductive laminate | | | |
|---|---|---|---|---|
| | Friction coefficient | | Surface rub fastness (number of scratches) | |
| | Static friction coefficient | Dynamic friction coefficient | Crosslinked layer side | Protective layer side |
| Reference Example 1 | N.D. | N.D. | C-class (13) | B-class (7) |
| Reference Example 2 | N.D. | N.D. | C-class (15) | C-class (12) |
| Example 22 | N.D. | N.D. | B-class (5) | B-class (4) |
| Example 24 | N.D. | N.D. | B-class (8) | B-class (4) |
| Example 35 | 0.74 | 0.63 | B-class (3) | B-class (4) |
| Example 36 | 0.57 | 0.47 | A-class (2) | B-class (4) |
| Example 37 | 0.52 | 0.43 | A-class (0) | B-class (4) |
| Comparative Example 2 | 1.01 | 0.89 | C-class (25) *1 | B-class (3) |
| Comparative Example 3 | 0.91 | 0.81 | B-class (5) | C-class (22) *2 |

| | | | | |
|---|---|---|---|---|
| *1 Substrate side (opposite side of crosslinked layer)is evaluated since no protective layer is provided. *2 Substrate side (opposite side of protective layer)is evaluated since no crosslinked layer is provided. | | | | |

In all Examples 1 to 38, the conductive laminates exhibited satisfactory durability against heat before and after patterning. The portions where the conductive component is removed by patterning exhibited satisfactory electrical insulation properties. In particular, the conductive laminates including a crosslinked layer having acryloyl groups as a carbon-carbon double bond group were less likely to undergo an increase in haze due to heat, and thus enabling satisfactory durability as compared with those having no acryloyl group (Examples 1, 2, 7). The conductive laminates including the crosslinked layer having acryloyl groups were less likely to undergo an increase in haze due to heat, and thus enabling satisfactory durability even if mass content of a crosslinked unit structure of the crosslinked layer is reduced (Examples 3 to 6), the thickness of the crosslinked layer is reduced (Examples 8, 25 to 27), the crosslinked layer includes structures other than acryloyl groups (Example 9), and other components are included (Examples 25 to 27). In case where the crosslinked layer contains an antistatic component (Examples 28 to 30), and an additive for correction of color tone (Examples 31, 32, 38) or an additive for improvement of slipperiness (Examples 35 to 37), satisfactory durability could be obtained.

In case where the conductive laminates have satisfactory slipperiness because of small friction coefficient of a surface of the crosslinked layer (Examples 35 to 37), control of the amount of the additive for improvement of slipperiness enabled a decrease in the number of scratches formed by reciprocating friction.

Even if the composition of the protective layer component or elements contained therein are changed (Examples 10, 11) or the type of the conductive component varies (Examples 1 to 3, 18 to 20), the portions where the conductive component is removed by patterning exhibited satisfactory electrical insulation properties, and also exhibited satisfactory durability against heat.

Even if the component of the protective layer has not a crosslinked structure, the portions where the conductive component is removed by patterning exhibited satisfactory electrical insulation properties, and also exhibited satisfactory durability against heat in case where the above-mentioned specific element is not contained and also the protective layer has a large average thickness (t) (Examples 1, 2). Even if the component of the protective layer contains the above-mentioned specific element, the portions where the conductive component is removed by patterning exhibited satisfactory electrical insulation properties, and also exhibited satisfactory durability against heat, similarly, in case where the component of the protective layer has a crosslinked structure and also the protective layer has a thickness (t) in a specific range (Examples 12 to 17).

In case where the protective layer has relatively small average thickness (t), total light transmittance may relatively decreased (Examples 1 to 4, 21). However, it was well suited for practical use as a conductive laminate. In case where the protective layer has relatively large average thickness (t), durability against heat may relatively deteriorated (Examples 18 to 20). However, it was well suited for practical use as a conductive laminate.

In the case of crosslinking the protective layer, mixing of a photo-initiator capable of adjusting a difference in the value of a maximum absorption wavelength in a specific range (Examples 22, 24) improved resistance to the removing agent and durability against heat as compared with the case where the photo-initiator is not mixed (Examples 6, 8) or a photo-initiator incapable of adjusting a difference in the value of a maximum absorption wavelength in a specific range is mixed (Example 23).

In case where the conductive layer is a conductive layer which further contains a non-linear structure component as a conductive component (Example 21), the non-linear structure component densely exists as compared with the case where the conductive layer contains no non-linear structure component (Example 8). Therefore, the total light transmittance relatively decreased, and also the protective layer was likely to be eroded when the conductive component is removed, leading to relatively low resistance to the removing agent.

In case where the substrate has relatively small thickness (Examples 33, 34), the total light transmittance increased as compared with the case where the substrate has a large thickness (Examples 24, 25).

In case where no conductive layer is provided, the measurement cannot be performed because of too large surface resistance value, and thus fails to use as a conductive laminate (Comparative Example 1).

In case where no crosslinked layer is provided (Comparative Example 2), durability against heat was poor when the thickness is less than a specific range even if the crosslinked layer is provided (Comparative Example 7). Even if the crosslinked layer has sufficient thickness, durability against heat was poor in case where the crosslinked layer does not include a structure derived from a carbon-carbon double bond group (Comparative Example 11), or mass content of the structure derived from a carbon-carbon double bond group is less than a specific range in the crosslinked layer (Comparative Example 12). To the contrary, in case where mass content of the structure derived from a carbon-carbon double bond group is more than a specific range (Comparative Example 13), or the crosslinked layer has a thickness more than a specific range (Comparative Example 8), it has been found that abnormality such as significant increase in surface resistance value occurs due to curling or poor planarity of the conductive laminate. In case where mass content of the structure derived from a carbon-carbon double bond group is more than a specific range, when the thickness of the crosslinked layer is decreased until it becomes possible to avoid curling or poor planarity of the conductive laminate (Comparative Example 14), the thickness of the crosslinked layer becomes less than a specific range, leading to poor durability against heat.

In any of case where the protective layer is not provided (Comparative Examples 3, 4), case where the conductive layer is a conductive layer which does not include linear structures as a conductive component (Comparative Examples 5, 6), and case where the average thickness (t) of the protective layer is less than a specific range (Comparative Example 9), the obtained conductive laminates were insufficient in durability against heat of portions where the conductive component is removed by patterning.

In case where the average thickness (t) of the protective layer is significantly more than a specific range (Comparative Example 10), the measurement cannot be performed because of too large surface resistance value, and thus fail to use as a conductive laminate. Too large thickness of the protective layer disables the removal of not only the protective layer but also the conductive component, and thus making it impossible to form patterning by chemical etching.

### [Industrial Applicability]

The conductive laminate of the present invention has satisfactory durability against heat in the processing step when formed into an electrode member to be used in a touch panel. The conductive laminate of the present invention can also be used in the electrode members used for display-related articles such as liquid crystal displays, organic electroluminescences and electronic papers and also for solar cell modules.

### [Reference Signs List]

1: Substrate
2: Conductive layer
3: Protective layer
4: Crosslinked layer
5: Conductive surface observed from direction perpendicular to lamination surface
6: Single fibrous conductor (an example of linear structure)
7: Aggregate of fibrous conductor (an example of linear structure)
8 : Nanowire of metal or metal oxide (an example of linear structure)
9: Needle-like conductor such as whisker (an example of linear structure)
10: Thin conductive film
11: Contact point between fibrous conductors overlying each other
12: Contact points between nanowires of metal or metal oxide overlying each other
13: Contact points between needle-like conductors such as whiskers overlying each other
14: Conductive laminate in which conductive layer and protective layer are patterned
15: Substrate of conductive laminate in which conductive layer and protective layer are patterned
16: Patterned conductive layer
17: Patterned protective layer
18: Crosslinked layer
19: Bonding layer of adhesive or tackifier
20: Substrate on screen side of touch panel
21: Hard coating layer laminated on substrate on screen side of touch panel
22: Protective layer surface
23: Thickness (t1) of protective layer at the portion where no linear structure exists
24: Thickness (t2) of protective layer at the portion where linear structures exist (in the case of single linear structure)
25: Thickness (t2) of protective layer at the portion where linear structures exist (in the case of aggregate consisting of linear structures)
26: Single linear structure constituting aggregate
27: Aggregate consisting of linear structures
28: Substrate
100: Reactor
101: Sintered quartz plate
102: Enclosed catalyst supply unit
103: Catalyst introduction line
104: Raw gas supply line
105: Exhaust gas line
106: Heater
107: Inspection port
108: Catalyst

## Claims

1. A conductive laminate comprising a substrate, a crosslinked layer laminated on one surface of the substrate, and a conductive layer and a protective layer laminated on the other surface of the substrate, the conductive laminate satisfying the following conditions (i) to (iv):
(i) the crosslinked layer is composed of a crosslinked polymer including a structure in which compounds, each having two or more carbon-carbon double bond groups contributing to a polymerization reaction, are subjected to the polymerization reaction, and also the mass content of a unit structure portion of the carbon-carbon double bond group, which is >C=C< and formula weight is 24, in the structure derived from the carbon-carbon double bond group is from 9 to 26% by mass relative to the total mass of the crosslinked layer;
(ii) the crosslinked layer has a thickness of 50 nm to 1 µm;
(iii) the conductive layer contains a conductive component having a network structure composed of linear structures; and
(iv) the protective layer has an average thickness (t) of 70 nm to 1 µm.

2. The conductive laminate according to claim 1, wherein the crosslinked layer is composed of a crosslinked polymer including, as the structure in which the carbon-carbon double bond groups are subjected to the polymerization reaction, a structure in which acryloyl groups are subjected to the polymerization reaction.

3. The conductive laminate according to claim 1 or 2, wherein a static friction coefficient between the crosslinked layer side and the protective layer side in accordance with JIS C2151 (2006) is 0.75 or less, and a dynamic friction coefficient in accordance with JIS C2151 (2006) is 0.65 or less.

4. The conductive laminate according to any one of claims 1 to 3, wherein the number of scratches generated in a direction parallel to a friction direction is 10 or less in 2 cm square when a surface of either the crosslinked layer or the protective layer is subjected to reciprocating friction for 50 times by a method in accordance with JIS L0849 (2004), using an attached white cotton cloth (Kanakin No. 3) for test.

5. The conductive laminate according to any one of claims 1 to 4, wherein a color tone b* of transmitted light in a L*a*b* color system in accordance with JIS Z8729 (2004) is 1.5 or less when light emitted from a light source C is made incident from the crosslinked layer side.

6. The conductive laminate according to any one of claims 1 to 5, wherein the crosslinked layer side has a surface resistance value of 1 × 10¹³ Ω/□ or less.

7. The conductive laminate according to any one of claims 1 to 6, wherein the substrate has a thickness of 100 µm or less.

8. A touch panel obtained by using the conductive laminate according to any one of claims 1 to 7.

## Patentansprüche

1. Leitfähiges Laminat, umfassend ein Substrat, eine vernetzte Schicht, die auf eine Oberfläche des Substrats laminiert ist, und eine leitfähige Schicht und eine Schutzschicht, die auf die andere Oberfläche des Substrats laminiert sind, wobei das leitfähige Laminat die nachfolgenden Bedingungen (i) bis (iv) erfüllt:
(i) die vernetzte Schicht besteht aus einem vernetzten Polymer, die eine Struktur enthält, in der Verbindungen, die jeweils zwei oder mehr Kohlenstoff-Kohlenstoff-Doppelbindungsgruppen aufweisen, die zu einer Polymerisationsreaktion beitragen, der Polymerisationsreaktion unterzogen werden, und außerdem liegt der Massegehalt eines Struktureinheitsbereichs der Kohlenstoff-Kohlenstoff-Doppelbindungsgruppe, die >C=C< ist und ein Formelgewicht von 24 aufweist, in der Struktur, die von der Kohlenstoff-Kohlenstoff-Doppelbindungsgruppe abgeleitet ist, im Bereich von 9 bis 26 Masse% bezogen auf die Gesamtmasse der vernetzten Schicht;
(ii) die vernetzte Schicht weist eine Dicke von 50 nm bis 1 µm auf;
(iii) die leitfähige Schicht enthält eine leitfähige Komponente mit einer Netzwerkstruktur, die aus linearen Strukturen besteht; und
(iv) die Schutzschicht weist eine durchschnittliche Dicke (t) von 70 nm bis 1 µm auf.

2. Leitfähiges Laminat gemäß Anspruch 1, wobei die vernetzte Schicht aus einem vernetzten Polymer besteht, das als Struktur, in der die Kohlenstoff-Kohlenstoff-Doppelbindungsgruppen der Polymerisationsreaktion unterzogen werden, eine Struktur umfasst, bei der Acryloylgruppen der Polymerisationsreaktion unterzogen werden.

3. Leitfähiges Laminat gemäß Anspruch 1 oder 2, wobei ein statischer Reibungskoeffizient zwischen der vernetzten Schichtseite und der Schutzschichtseite in Übereinstimmung mit JIS C2151 (2006) 0,75 oder weniger beträgt, und ein dynamischer Reibungskoeffizient in Übereinstimmung mit JIS C2151 (2006) 0,65 oder weniger beträgt.

4. Leitfähiges Laminat gemäß einem der Ansprüche 1 bis 3, wobei die Anzahl von Kratzern, die in einer Richtung parallel zu einer Reibungsrichtung erzeugt werden, 10 oder weniger in einem Quadrat von 2 cm beträgt, wenn eine Oberfläche entweder der vernetzten Schicht oder der Schutzschicht einer 50 maligen wechselseitigen Reibung durch ein Verfahren in Übereinstimmung mit JIS L 0849 (2004) unter Verwendung eines befestigten weißen Baumwolltuchs (Kankin Nr. 3) für einen Test unterzogen wird.

5. Leitfähiges Laminat gemäß einem der Ansprüche 1 bis 4, wobei ein Farbton b* von durchgeleitetem Licht in einem L*a*b*-Farbsystem in Übereinstimmung mit JIS Z8729 (2004) 1,5 oder weniger beträgt, wenn von einer Lichtquelle C emittiertes Licht von der vernetzten Schichtseite einfällt.

6. Leitfähiges Laminat gemäß einem der Ansprüche 1 bis 5, wobei die vernetzte Schichtseite einen Oberflächenwiderstandswert von 1 × 10¹³ Ω/□ oder weniger aufweist.

7. Leitfähiges Laminat nach einem der Ansprüche 1 bis 6, wobei das Substrat eine Dicke von 100 µm oder weniger aufweist.

8. Berührungsbildschirm, der durch Verwendung des leitfähigen Laminats gemäß einem der Ansprüche 1 bis 7 erhalten wird.

## Revendications

1. Stratifié conducteur comprenant un substrat, une couche réticulée stratifiée sur une surface du substrat, et une couche conductrice et une couche protectrice stratifiées sur l'autre surface du substrat, le stratifié conducteur satisfaisant les conditions (i) à (iv) suivantes :
(i) la couche réticulée est composée d'un polymère réticulé comportant une structure dans laquelle des composés, ayant chacun deux ou plusieurs groupe(s) à double liaison carbone-carbone contribuant à une réaction de polymérisation, sont soumis à la réaction de polymérisation, et la teneur en masse d'une partie de structure unitaire du groupe à double liaison carbone-carbone, qui est >C=C< et de poids moléculaire égal à 24, dans la structure dérivée du groupe à double liaison carbone-carbone est comprise entre 9 et 26% en masse par rapport à la masse totale de la couche réticulée ;
(ii) la couche réticulée a une épaisseur de 50 nm à 1 µm ;
(iii) la couche conductrice contient un composant conducteur ayant une structure en réseau composée de structures linéaires ; et
(iv) la couche protectrice a une épaisseur moyenne (t) de 70 nm à 1 µm.

2. Stratifié conducteur selon la revendication 1, dans lequel la couche réticulée est composée d'un polymère réticulé comportant, comme étant la structure dans laquelle les groupes à double liaison carbone-carbone sont soumis à la réaction de polymérisation, une structure dans laquelle des groupes acryloyle sont soumis à la réaction de polymérisation.

3. Stratifié conducteur selon la revendication 1 ou 2, dans lequel un coefficient de frottement statique entre le côté couche réticulée et le côté couche protectrice est inférieur ou égal à 0,75 selon la norme JIS C2151 (2006), et un coefficient de frottement dynamique est inférieur ou égal à 0,65 selon la norme JIS C2151 (2006).

4. Stratifié conducteur selon l'une quelconque des revendications 1 à 3, dans lequel le nombre de rayures générées dans une direction parallèle à une direction de frottement est inférieur ou égal à 10 dans 2 cm carré lorsqu'une surface soit de la couche réticulée soit de la couche protectrice est soumise 50 fois à un frottement alternatif par un procédé selon la norme JIS L0849 (2004), en utilisant un tissu de coton blanc attaché (Kanakin N° 3) pour l'essai.

5. Stratifié conducteur selon l'une quelconque des revendications 1 à 4, dans lequel une tonalité de couleur b* d'une lumière transmise dans un système de couleur L*a*b* selon la norme JIS Z8729 (2004) est inférieure ou égale à 1,5 lorsqu'une lumière émise à partir d'une source de lumière C est rendue incidente à partir du côté couche réticulée.

6. Stratifié conducteur selon l'une quelconque des revendications 1 à 5, dans lequel le côté couche réticulée a une valeur de résistance en surface inférieure ou égale à 1 x 10¹³ Ω/□.

7. Stratifié conducteur selon l'une quelconque des revendications 1 à 6, dans lequel le substrat a une épaisseur de 100 µm ou moins.

8. Écran tactile obtenu en utilisant le stratifié conducteur selon l'une quelconque des revendications 1 à 7.
